# EUROPEAN PATENT SPECIFICATION

(11) **EP 3 032 606 B1**
(45) Date of publication and mention of the grant of the patent: **08.11.2017**
(21) Application number: 15196314.7
(22) Date of filing: 25.11.2015
(51) Int. Cl.: H01L 51/54, C09K 11/06

(54) **ORGANIC OPTOELECTRIC DEVICE AND DISPLAY DEVICE**
ORGANISCHE OPTOELEKTRISCHE VORRICHTUNG UND ANZEIGEVORRICHTUNG
DISPOSITIF OPTO-ÉLECTRONIQUE ORGANIQUE ET DISPOSITIF D'AFFICHAGE

(30) Priority: 09.12.2014 KR 20140176175
(43) Date of publication of application: 15.06.2016
(73) Proprietor: Samsung SDI Co., Ltd., Gyeonggi-do 17084 (KR)
(72) Inventor: KANG, Eui-Su, 16678 Suwon-si, Gyeonggi-do (KR); MIN, Soo-Hyun, 16678 Suwon-si, Gyeonggi-do (KR); KIM, Young-Kwon, 16678 Suwon-si, Gyeonggi-do (KR); KIM, Youn-Hwan, 16678 Suwon-si, Gyeonggi-do (KR); YANG, Yong-Tak, 16678 Suwon-si, Gyeonggi-do (KR); YU, Eun-Sun, 16678 Suwon-si, Gyeonggi-do (KR); JUNG, Ho-Kuk, 16678 Suwon-si, Gyeonggi-do (KR); JO, Young-Kyoung, 16678 Suwon-si, Gyeonggi-do (KR)
(74) Representative: Michalski Hüttermann & Partner Patentanwälte mbB

(56) References cited:
- WO-A1-2014/054898
- US-A1- 2011 278 555
- US-A1- 2014 339 518
- US-A1- 2014 357 866
- A-MONRAT THAENGTHONG ET AL: "Synthesis and characterization of highcarbazole-based amorphous hole-transporting materials for organic light-emitting devices", TETRAHEDRON LETTERS, PERGAMON, GB, vol. 52, no. 37, 1 July 2011 (2011-07-01), pages 4749-4752, XP028260545, ISSN: 0040-4039, DOI: 10.1016/J.TETLET.2011.07.002 [retrieved on 2011-07-08]

## Description

### BACKGROUND OF THE INVENTION

### (a) Field of the Invention

An organic optoelectric device and a display device are disclosed.

### (b) Description of the Related Art

An organic optoelectric device is a device that converts electrical energy into photoenergy, and vice versa.

An organic optoelectric device may be classified as follows in accordance with its driving principles. One is an optoelectric device where excitons are generated by photoenergy, separated into electrons and holes, and are transferred to different electrodes to generate electrical energy, and the other is a light emitting device where a voltage or a current is supplied to an electrode to generate photoenergy from electrical energy.

Examples of an organic optoelectric device may be an organic photoelectric device, an organic light emitting diode, an organic solar cell and an organic photo conductor drum.

US 2011/278555 A1 refers to a biscarbazole derivative, a material for an organic electroluminescence device, and an organic electroluminescence device using those.

US 2014/357866 A1 refers to an organic electroluminescent compound and an organic electroluminescent device containing the same.

WO 2014/054898 A1 refers to an organic electroluminescent compound and an organic electroluminescent device containing the same.

US 2014/339518 A1 refers to an OLED including an emitter layer disposed between a cathode and an anode where the emitter layer includes a host material and a phosphorescent emitter material. A first hole transport layer is disposed between the emitter layer and the anode and a second hole transport layer is disposed between the first hole transport layer and the anode. The first hole transport layer includes a first hole transport material that is a carbazole type compound and the second hole transport layer includes a second hole transport material that is different from the first hole transport material.

Further, highcarbazole-based amorphous hole-transporting materials for organic light-emitting devices are disclosed in A-MONRAT THAENGTHONG ET AL, "Synthesis and characterization of highcarbazole-based amorphous hole-transporting materials for organic light-emitting devices", TETRAHEDRON LETTERS, PERGAMON, GB, vol. 52, no. 37, doi: 10.1016/ J.TETLET. 2011.07.002, ISSN 0040-4039, (20110701), pages 4749 - 4752.

Of these, an organic light emitting diode (OLED) has recently drawn attention due to an increase in demand for flat panel displays. Such an organic light emitting diode converts electrical energy into light by applying current to an organic light emitting material. It has a structure in which an organic layer is interposed between an anode and a cathode.

A green organic light emitting diode having a long life-span is considered to be one of the critical factors for realizing a long life-span full color display. Accordingly, development of a long life-span green organic light emitting diode is being actively researched. In order to solve this problem, a green organic light emitting diode having high efficiency and a long life-span is provided in this invention.

### SUMMARY OF THE INVENTION

One embodiment provides an organic optoelectric device being capable of realizing having high efficiency. Another embodiment provides a display device including the organic optoelectric device.

According to one embodiment, an organic optoelectric device includes an anode and a cathode facing each other, an emission layer between the anode and the cathode, a hole transport layer between the anode and the emission layer, and a hole transport auxiliary layer between the hole transport layer and the emission layer, wherein the emission layer includes at least one of a first compound including moieties represented by Chemical Formulae 1 to 3 sequentially linked and at least one of a second compound represented by Chemical Formula 4, and the hole transport auxiliary layer includes at least one of a third compound represented by Chemical Formula 5.

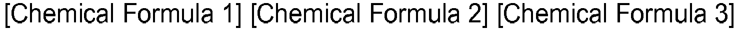

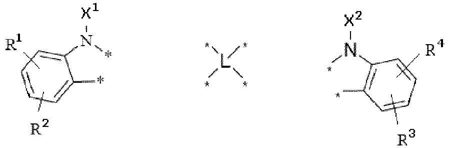

In Chemical Formulae 1 to 3,
X¹ is *-Y¹-ET,
X² is *-Y²-Ar¹,
Y¹ and Y² are each independently a single bond, a substituted or unsubstituted C6 to C30 arylene group, a substituted or unsubstituted C2 to C30 heteroarylene group, or a combination thereof,
Ar¹ is a substituted or unsubstituted C6 to C30 aryl group, a substituted or unsubstituted C2 to C30 heteroaryl group, or a combination thereof,
L is a substituted or unsubstituted C2 or C3 alkenylene group or a substituted or unsubstituted C6 to C20 arylene group,
R¹ to R⁴ are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof,
ET is represented by Chemical Formula 1a, and
* is a linking point, 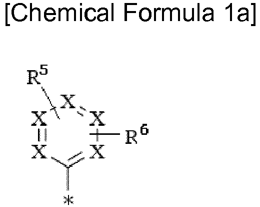 wherein, in Chemical Formula 1a,
X is N, C or CR^{a},
at least one of X is N,
R⁵, R⁶ and R^{a} are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof, and
* is a linking point, 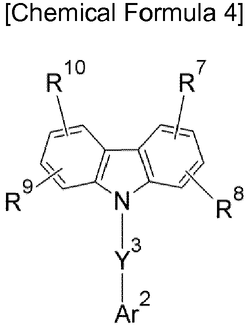
wherein, in Chemical Formula 4,
Y³ is a single bond, a substituted or unsubstituted C6 to C30 arylene group, a substituted or unsubstituted C2 to C30 heteroarylene group, or a combination thereof,
Ar² is a substituted or unsubstituted C6 to C30 aryl group, substituted or unsubstitutedC2 to C30 heteroaryl group, or a combination thereof,
R⁷ to R¹⁰ are each independently hydrogen, deuterium, a substituted or unsubstituted C1 to C20 alkyl group, a substituted or unsubstituted C6 to C50 aryl group, a substituted or unsubstituted C2 to C50 heteroaryl group, or a combination thereof, and
at least one of R⁷ to R¹⁰ and Ar² includes a substituted or unsubstituted triphenylene group or a substituted or unsubstituted carbazolyl group, 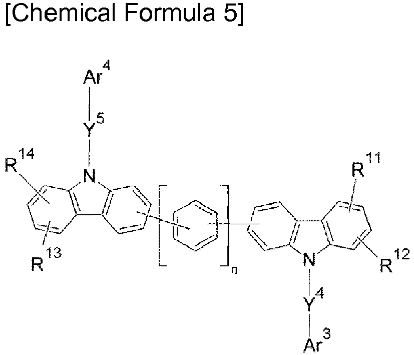
wherein, in Chemical Formula 5,
R¹¹ to R¹⁴ are each independently hydrogen, deuterium, a substituted or unsubstituted C1 to C30 alkyl group, a substituted or unsubstituted C6 to C30 aryl group, a substituted or unsubstituted C2 to C30 heteroaryl group, or a combination thereof,
Y⁴ and Y⁵ are each independently a single bond, a substituted or unsubstituted C6 to C30 arylene group, a substituted or unsubstituted C2 to C30 heteroarylene group, or a combination thereof,
Ar³ and Ar⁴ are each independently hydrogen, deuterium, a substituted or unsubstituted C1 to C30 alkyl group, a substituted or unsubstituted C3 to C30 cycloalkyl group, a substituted or unsubstituted C6 to C30 aryl group, a substituted or unsubstituted carbazolyl group, a substituted or unsubstituted dibenzofuranyl group, a substituted or unsubstituted dibenzothiophenyl group, a substituted or unsubstituted C6 to C30 arylamine group, a substituted or unsubstituted C1 to C30 alkoxy group, a substituted or unsubstituted C3 to C40 silyl group, a substituted or unsubstituted C1 to C30 alkylthiol group, a substituted or unsubstituted C6 to C30 arylthiol group, a halogen, a halogen-containing group, a cyano group, a hydroxy group, an amino group, a nitro group, or a combination thereof,
n is an integer ranging from 0 to 4,
wherein "substituted" of Chemical Formulae 1 to 5 refers to that at least one hydrogen is replaced by deuterium, a halogen, a hydroxy group, an amino group, a substituted or unsubstituted C1 to C30 amine group, a nitro group, a substituted or unsubstituted C1 to C40 silyl group, a C1 to C30 alkyl group, a C3 to C30 cycloalkyl group, a C2 to C30 heterocycloalkyl group, a C6 to C30 aryl group, a C2 to C30 heteroaryl group, a C1 to C20 alkoxy group, a fluoro group, a C1 to C10 trifluoroalkyl group, or a cyano group.

According to another embodiment, a display device including the organic optoelectric device is provided.

An organic optoelectric device having high efficiency may be realized.

### BRIEF DESCRIPTION OF THE DRAWINGS

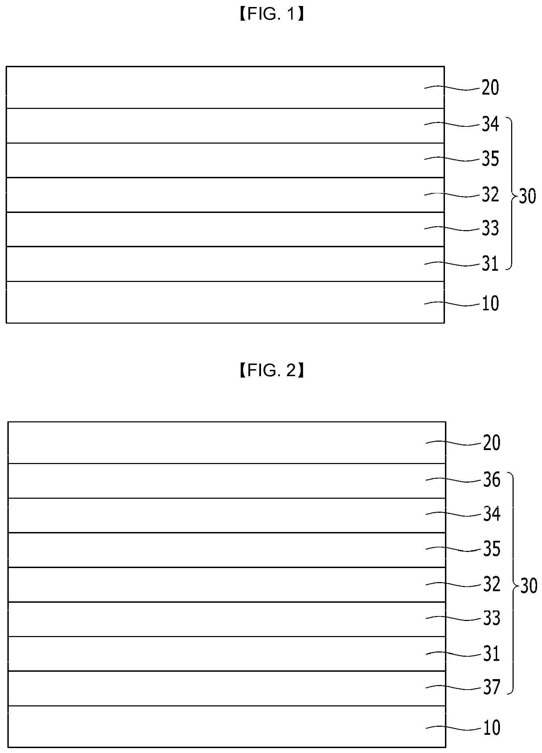

FIGS. 1 and 2 are cross-sectional views showing organic optoelectric devices according to one embodiment.

### DETAILED DESCRIPTION

Hereinafter, embodiments of the present invention are described in detail. However, these embodiments are exemplary, the present invention is not limited thereto and the present invention is defined by the scope of claims.

In the present specification, when a definition is not otherwise provided, the term "substituted" refers to one substituted with a substituent selected from deuterium, a halogen, a hydroxy group, an amino group, a substituted or unsubstituted C1 to C30 amine group, a nitro group, a substituted or unsubstituted C1 to C40 silyl group, a C1 to C30 alkyl group, a C1 to C10 alkylsilyl group, a C3 to C30 cycloalkyl group, a C2 to C30 heterocycloalkyl group, a C6 to C30 aryl group, a C2 to C30 heteroaryl group, a C1 to C20 alkoxy group, a fluoro group, a C1 to C10 trifluoroalkyl group such as a trifluoromethyl group, or a cyano group, instead of at least one hydrogen of a substituent or a compound.

In addition, two adjacent substituents of the substituted halogen, hydroxy group, amino group, substituted or unsubstituted C1 to C20 amine group, nitro group, substituted or unsubstituted C3 to C40 silyl group, C1 to C30 alkyl group, C1 to C10 alkylsilyl group, C2 to C30 cycloalkyl group, C2 to C30 heterocycloalkyl group, C6 to C30 aryl group, C2 to C30 heteroaryl group, C1 to C20 alkoxy group, fluoro group, C1 to C10 trifluoroalkyl group such as trifluoromethyl group and the like, or cyano group may be fused with each other to form a ring. For example, the substituted C6 to C30 aryl group may be fused with another adjacent substituted C6 to C30 aryl group to form a substituted or unsubstituted fluorene ring.

In the present specification, when specific definition is not otherwise provided, the term "hetero" refers to one including 1 to 3 hetero atoms selected from N, O, S, P, and Si, and remaining carbons in one compound or substituent.

In the present specification, when a definition is not otherwise provided, "alkyl group" refers to an aliphatic hydrocarbon group. The alkyl group may be "a saturated alkyl group" without any double bond or triple bond.

The alkyl group may be a C1 to C30 alkyl group. More specifically, the alkyl group may be a C1 to C20 alkyl group or a C1 to C10 alkyl group. For example, a C1 to C4 alkyl group may have 1 to 4 carbon atoms in an alkyl chain which may be selected from methyl, ethyl, propyl, iso-propyl, n-butyl, iso-butyl, sec-butyl, and t-butyl.

Specific examples of the alkyl group may be a methyl group, an ethyl group, a propyl group, an isopropyl group, a butyl group, an isobutyl group, a t-butyl group, a pentyl group, a hexyl group, a cyclopropyl group, a cyclobutyl group, a cyclopentyl group, a cyclohexyl group, and the like.

In the present specification, the term "aryl group" refers to a substituent including all element of the cycle having p-orbitals which form conjugation, and may be monocyclic, polycyclic or fused ring polycyclic (i.e., rings sharing adjacent pairs of carbon atoms) functional group.

In the present specification, the term "heterocyclic group" refers to one including at least one hetero atom selected from N, O, S, P and Si in a cyclic compound such as an aryl group, a cycloalkyl group, a fused ring thereof, or a combination thereof, and remaining carbons. When the heterocyclic group is a fused ring, the entire or each ring of the heterocyclic group may include at least one hetero atom. Accordingly, the heterocyclic group may be a general concept including a heteroaryl group.

More specifically, the substituted or unsubstituted C6 to C30 aryl group and/or the substituted or unsubstituted C2 to C30 heterocyclic group may be a substituted or unsubstituted phenyl group, a substituted or unsubstituted naphthyl group, a substituted or unsubstituted anthracenyl group, a substituted or unsubstituted phenanthrylene group, a substituted or unsubstituted naphthacenyl group, a substituted or unsubstituted pyrenyl group, a substituted or unsubstituted biphenyl group, a substituted or unsubstituted p-terphenyl group, a substituted or unsubstituted m-terphenyl group, a substituted or unsubstituted chrysenyl group, a substituted or unsubstituted triphenylenyl group, a substituted or unsubstituted perylenyl group, a substituted or unsubstituted indenyl group, a substituted or unsubstituted furanyl group, a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridinyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted fluorenyl group, a substituted or unsubstituted carbazolyl group, a substituted or unsubstituted dibenzofuranyl group, a substituted or unsubstituted dibenzothiophenyl group, combinations thereof, or fused rings of the combinations thereof, but are not limited thereto.

In the specification, hole characteristics refer to characteristics capable of donating an electron when an electric field is applied and that a hole formed in the anode is easily injected into the emission layer and transported in the emission layer due to conductive characteristics according to highest occupied molecular orbital (HOMO) level.

In addition, electron characteristics refer to characteristics capable of accepting an electron when an electric field is applied and that an electron formed in the cathode is easily injected into the emission layer and transported in the emission layer due to conductive characteristics according to lowest unoccupied molecular orbital (LUMO) level.

Hereinafter, an organic optoelectric device according to one embodiment is described.

The organic optoelectric device may be any device to convert electrical energy into photoenergy and vice versa without particular limitation, and may be, for example an organic photoelectric device, an organic light emitting diode, an organic solar cell, and an organic photo-conductor drum.

Herein, an organic light emitting diode as one example of an organic optoelectric device is described, but the present invention can be applied to other organic optoelectric devices in the same way.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

FIG. 1 is a schematic cross-sectional view showing organic optoelectric devices according to one embodiment.

Referring to FIG. 1, an organic optoelectric device according to one embodiment includes an anode 10 and a cathode 20 facing each other and an organic layer 30 between the anode 10 and the cathode 20.

The anode 10 may be made of a conductor having a large work function to help hole injection, and may be for example metal, metal oxide and/or a conductive polymer. The anode 10 may be, for example a metal such as nickel, platinum, vanadium, chromium, copper, zinc, and gold or an alloy thereof; metal oxide such as zinc oxide, indium oxide, indium tin oxide (ITO), indium zinc oxide (IZO), and the like; a combination of metal and oxide such as ZnO and Al or SnO₂ and Sb; a conductive polymer such as poly(3-methylthiophene), poly(3,4-(ethylene-1,2-dioxy)thiophene) (PEDT), polypyrrole, and polyaniline, but is not limited thereto.

The cathode 20 may be made of a conductor having a small work function to help electron injection, and may be for example metal, metal oxide and/or a conductive polymer. The cathode 20 may be for example a metal or an alloy thereof such as magnesium, calcium, sodium, potassium, titanium, indium, yttrium, lithium, gadolinium, aluminum silver, tin, lead, cesium, barium, and the like; a multi-layer structure material such as LiF/Al, LiO₂/Al, LiF/Ca, LiF/Al and BaF₂/Ca, but is not limited thereto.

The organic layer 30 includes a hole transport layer 31, an emission layer 32 and a hole transport auxiliary layer 33 between the hole transport layer 31 and the emission layer 32.

Referring to FIG. 2, the organic layer 30 may further include a hole injection layer 37 between the hole transport layer 31 and the anode 10, and an electron injection layer 36 between the electron transport layer 34 and the cathode 20.

The hole injection layer 37 between the hole transport layer 31 and the anode 10 the improves interface characteristics an organic material used as the hole transport layer 31 and ITO used as the anode 10 and is coated on the ITO to smooth uneven upper surface of ITO. For example, the hole injection layer 37 may be selected from materials having a median value between work functions of the ITO and HOMO of the hole transport layer 31 to adjust a difference between the work functions of the ITO and the HOMO of the hole transport layer 31 and particularly, materials having appropriate conductivity. The materials forming the hole injection layer 37 of the present invention may be N4,N4'-diphenyl-N4,N4'-bis(9-phenyl-9H-carbazol-3-yl)biphenyl-4,4'-diamine, but is not limited thereto. A conventional material of the hole injection layer 37 may be also used together, for example, copper phthlalocyanine (CuPc), aromatic amines such as N,N'-dinaphthyl-N,N'-phenyl-(1,1'-biphenyl)-4,4'-diamine (NPD), 4,4',4"-tris[methylphenyl(phenyl)amino] triphenyl amine (m-MTDATA), 4,4',4"-tris[1-naphthyl(phenyl)amino] triphenyl amine (1-TNATA), 4,4',4"-tris[2-naphthyl(phenyl)amino]triphenyl amine (2-TNATA), 1,3,5-tris[N-(4-diphenylaminophenyl)phenylamino] benzene (p-DPA-TDAB), a compound such 4,4'-bis[N-[4-{N,N-bis(3-methylphenyl)amino}phenyl]-N-phenylamino]biphenyl (DNTPD), hexaazatriphenylene-hexacarbonitirile (HAT-CN), and the like, a conductive polymer such as a polythiophene derivative of poly (3,4-ethylenedioxythiophene)-poly(styrenesulfonate) (PEDOT). The hole injection layer 37 may be coated with a thickness, for example of 10 to 300 A on ITO as an anode.

The electron injection layer 36 is disposed on the electron transport layer and thus, facilitates injection of electrons from a cathode and ultimately improves power efficiency and may, for example, include LiF, Liq, NaCl, CsF, Li₂O, BaO and the like, which are conventionally used in a related art.

The hole transport layer 31 facilitates hole transport from the anode 10 to the emission layer 32 and may be, for example, formed of an amine compound but is not limited thereto.

The amine compound may include, for example at least one aryl group and/or heteroaryl group. The amine compound may be, for example represented by Chemical Formula a or Chemical Formula b, but is not limited thereto.

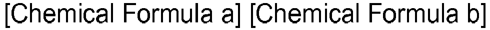

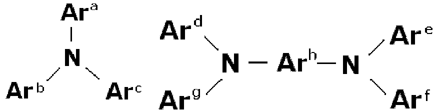

In Chemical Formulae a or b,
Ar^{a} to Ar^{g} are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof,
at least one of Ar^{a} to Ar^{c} and at least one of Ar^{d} to Ar^{g} are a substituted or unsubstituted C6 to C30 aryl group, a substituted or unsubstituted C2 to C30 heteroaryl group, or a combination thereof, and
Ar^{h} is a single bond, a substituted or unsubstituted C1 to C20 alkylene group, a substituted or unsubstituted C6 to C30 arylene group, a substituted or unsubstituted C2 to C30 heteroarylene group or a combination thereof.

The electron transport layer 34 easily transports electrons from the cathode 20 to the emission layer 32 and may be formed of an organic compound containing an electron-accepting functional group (an electron-withdrawing group), a metal compound well accepting electrons, or a mixture thereof. For example, the electron transport layer material may include aluminum trihydroxyquinoline (Alq₃), a 1,3,4-oxadiazole derivative of 2-(4-biphenylyl)-5-phenyl-1,3,4-oxadiazole (PBD), a quinoxaline derivative of 1,3,4-tris[(3-penyl-6-trifluoromethyl)quinoxaline-2-yl] benzene (TPQ), a triazole derivative and a triazine derivative of 8-(4-(4-(naphthalen-2-yl)-6-(naphthalen-3-yl)-1,3,5-triazin-2-yl)phenyl)quinoline), and the like, but is not limited thereto.

In addition, the electron transport layer may include an organometallic compound represented by Chemical Formula c singularly or as a mixture with the electron transport layer material.

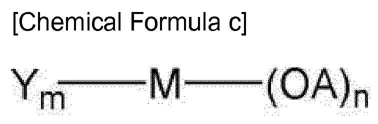

In Chemical Formula c,
Y includes a moiety where one selected from C, N, O and S directly bonds with M to form a single bond and a moiety where one selected from C, N, O and S forms a coordination bond with M, and is a chelated ligand with the single bond and the coordination bond,
the M is an alkali metal, an alkali earth metal, aluminum (Al), or boron (B) atom, and the OA is a monovalent ligand being capable of forming a single bond or a coordination bonding with the M,
the O is oxygen,
A is selected from a substituted or unsubstituted C1 to C30 alkyl group, a substituted or unsubstituted C5 to C50 aryl group, a substituted or unsubstituted C2 to C30 alkenyl group, a substituted or unsubstituted C2 to C20 alkynyl group, a substituted or unsubstituted C3 to C30 cycloalkyl group, a substituted or unsubstituted C5 to C30 cycloalkenyl group, and a substituted or unsubstituted C2 to C50 heteroaryl group having heterogeneous atom of O, N or S,
when the M is a metal selected from an alkali metal, m=1 and n=0,
when the M is a metal selected from an alkali earth metal, m=1 and n=1, or m=2, and n=0,
when the M is boron or aluminum, m is one of 1 to 3, and n is one of 0 to 2, satisfying m +n=3; and
the 'substituted' of the 'substituted or unsubstituted' refers to that at least one hydrogen is replaced by one or more substituent selected from deuterium, a cyano group, a halogen, a hydroxy group, a nitro group, an alkyl group, an alkoxy group, an alkylamino group, an arylamino group, heteroarylamino group, an alkylsilyl group, an arylsilyl group, an aryloxy group, an aryl group, a heteroaryl group, germanium, phosphorus, and boron.

In the present invention, each Y is the same or different, and are independently one selected from Chemical Formula c1 to Chemical Formula c39, but is not limited thereto.

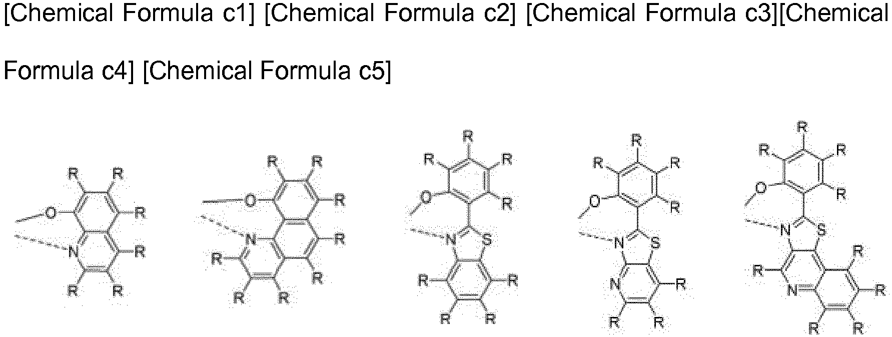

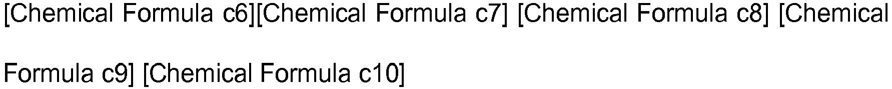

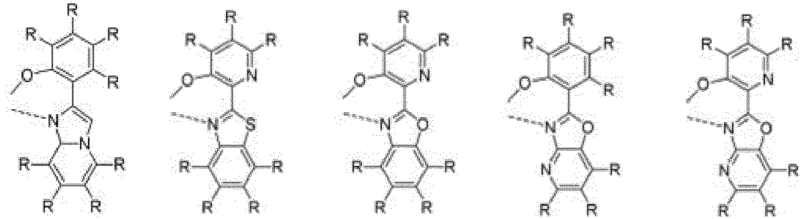

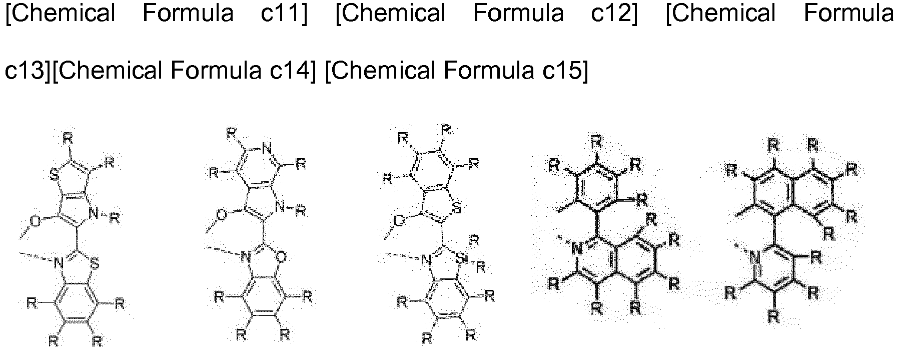

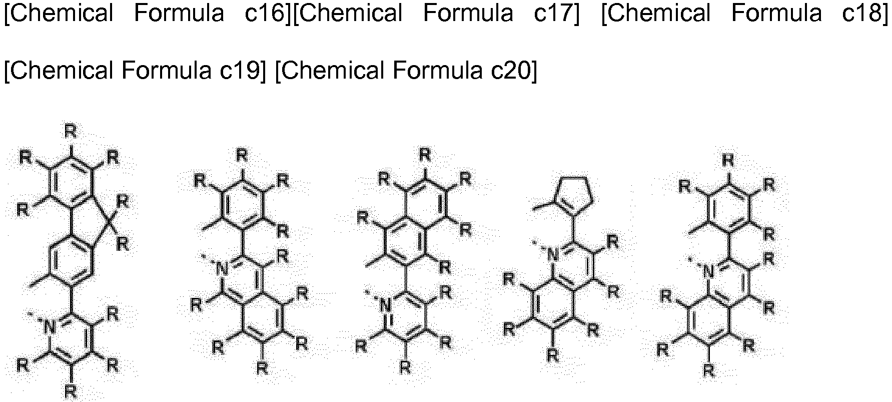

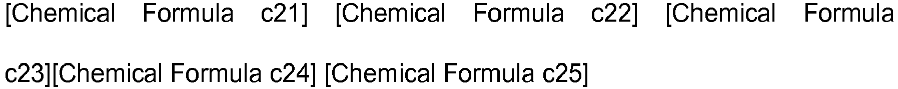

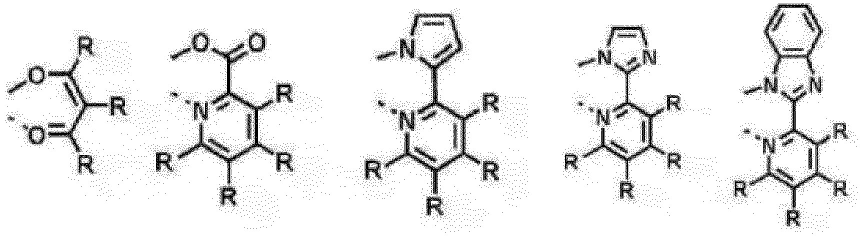

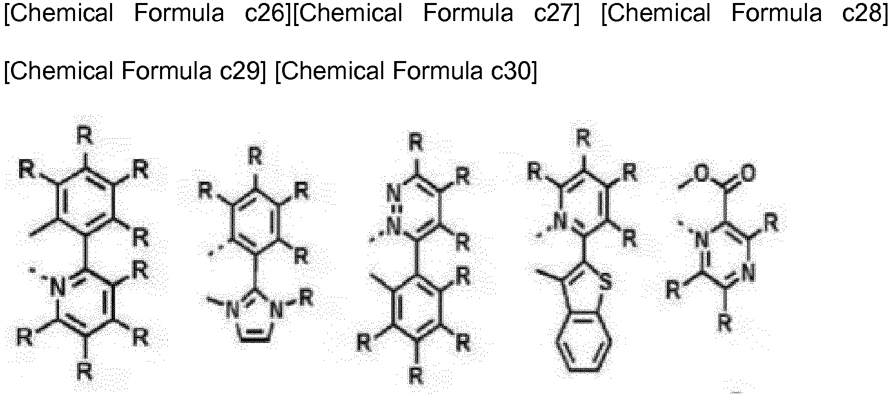

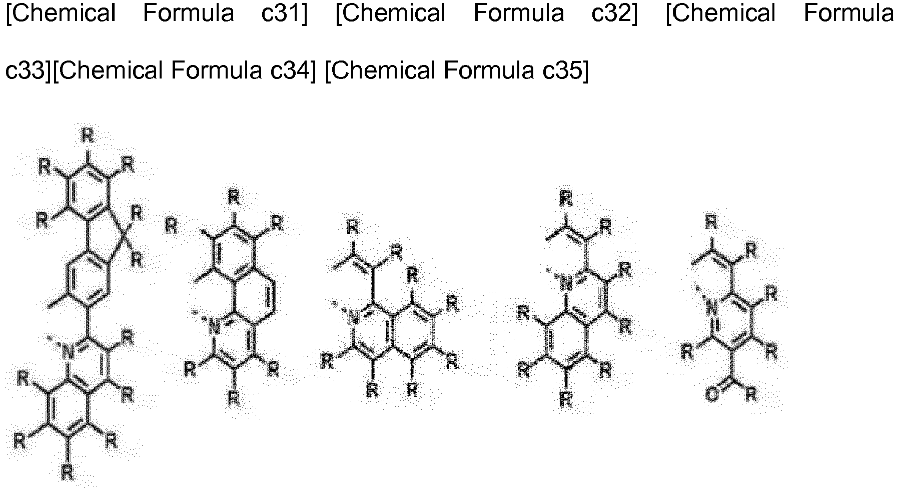

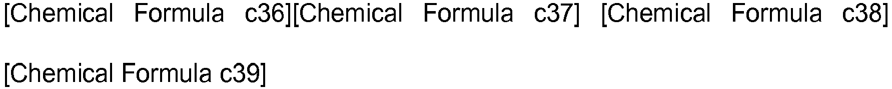

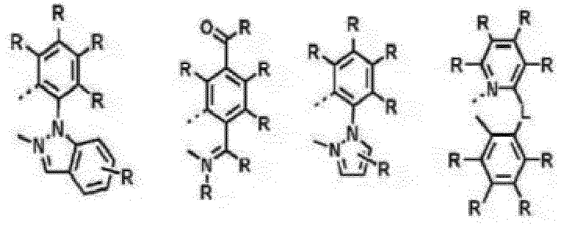

In Chemical Formulae c1 to c39,
R is the same or different and is each independently selected from hydrogen, deuterium, halogen, a cyano group, a substituted or unsubstituted C1 to C30 alkyl group, a substituted or unsubstituted C6 to C30 aryl group, a substituted or unsubstituted C3 to C30 heteroaryl group, a substituted or unsubstituted C1 to C30 alkoxy group, a substituted or unsubstituted C3 to C30 cycloalkyl group, a substituted or unsubstituted C2 to C30 alkenyl group, a substituted or unsubstituted C1 to C30 alkylamino group, a substituted or unsubstituted C1 to C30 alkylsilyl group, a substituted or unsubstituted C6 to C30 arylamino group and a substituted or unsubstituted C6 to C30 arylsilyl group, or is linked to an adjacent substituent with alkylene or alkenylene to form a spirocycle or a fused ring.

The emission layer 32 is an organic layer emitting light and includes a host and a dopant when a doping system is adopted. Herein, the host mainly promotes a recombination of electrons and holes and holds excitons in an emission layer, while the dopant efficiently emits light from the excitons obtained from the recombination.

The emission layer may include known hosts and dopants.

The emission layer 32 includes at least two kinds of a host and a dopant, and the host includes a first compound having bipolar characteristics having relatively stronger electron characteristics and a second compound having bipolar characteristics having relatively stronger hole characteristics.

The first compound is a compound having bipolar characteristics having relatively stronger electron characteristics, and may be represented by a sequential combination of moieties represented by Chemical Formulae 1 to 3.

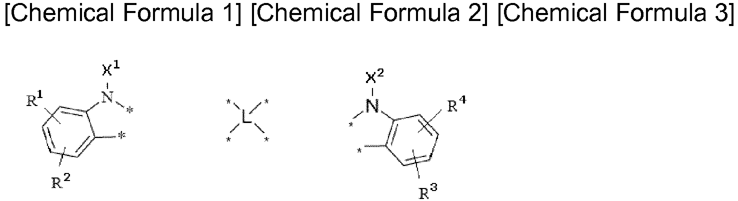

In Chemical Formulae 1 to 3,
X¹ is *-Y¹-ET,
X² is *-Y²-Ar¹,
Y¹ and Y² are each independently a single bond, a substituted or unsubstituted C6 to C30 arylene group, a substituted or unsubstituted C2 to C30 heteroarylene group, or a combination thereof,
Ar¹ is a substituted or unsubstituted C6 to C30 aryl group, a substituted or unsubstituted C2 to C30 heteroaryl group, or a combination thereof,
L is a substituted or unsubstituted C2 or C3 alkenylene group or a substituted or unsubstituted C6 to C20 arylene group, and
R¹ to R⁴ are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof.

In Chemical Formulae 1 to 3, "*" is a linking point between Chemical Formula 1 and Chemical Formula 2 and between Chemical Formula 2 and Chemical Formula 3.

ET is represented by Chemical Formula 1a,

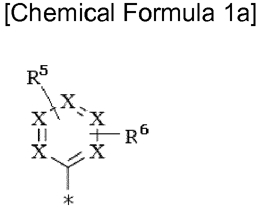

In Chemical Formula 1a,
X is N, C or CR^{a},
at least one of X is N,
R⁵, R⁶ and R^{a} are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof, and
* is a linking point.

The ET is a substituent being capable of transporting electrons, for example a heteroaryl group including at least one nitrogen except a carbazolyl group, such as a substituted or unsubstituted pyridinyl group, a substituted or unsubstituted pyrimidinyl group, a substituted or unsubstituted triazinyl group, a substituted or unsubstituted pyrazinyl group, a substituted or unsubstituted pyridazinyl group, a substituted or unsubstituted purinyl group, a substituted or unsubstituted quinolinyl group, a substituted or unsubstituted isoquinolinyl group, a substituted or unsubstituted phthalazinyl group, a substituted or unsubstituted naphpyridinyl group, a substituted or unsubstituted quinoxalinyl group, a substituted or unsubstituted quinazolinyl group, a substituted or unsubstituted acridinyl group, a substituted or unsubstituted phenanthrolinyl group, a substituted or unsubstituted phenazinyl group, a substituted or unsubstituted imidazolyl group, a substituted or unsubstituted triazolyl group, a substituted or unsubstituted tetrazolyl group, a substituted or unsubstituted oxadiazolyl group, a substituted or unsubstituted oxatriazolyl group, a substituted or unsubstituted thiatriazolyl group, a substituted or unsubstituted benzimidazolyl group, a substituted or unsubstituted benzotriazolyl group, or a combination thereof.

The ET may be one of substituents in Group 1.

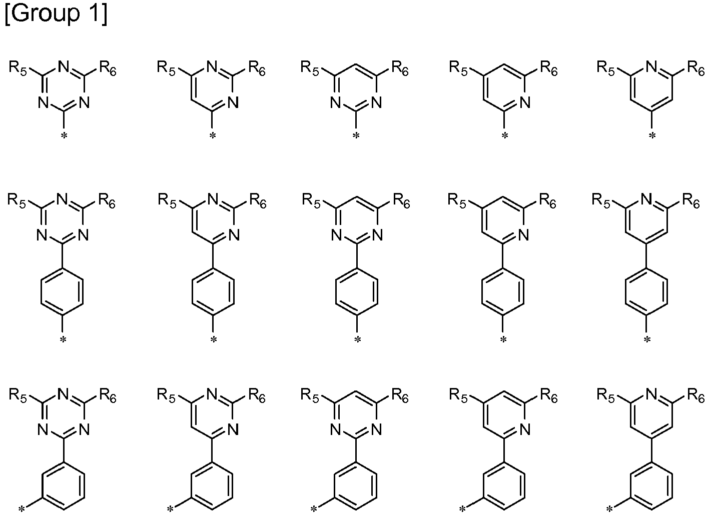

In the Group 1, R⁵ and R⁶ are the same as described above. The X¹ may be, for example one of substituents listed in Group 2.

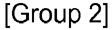

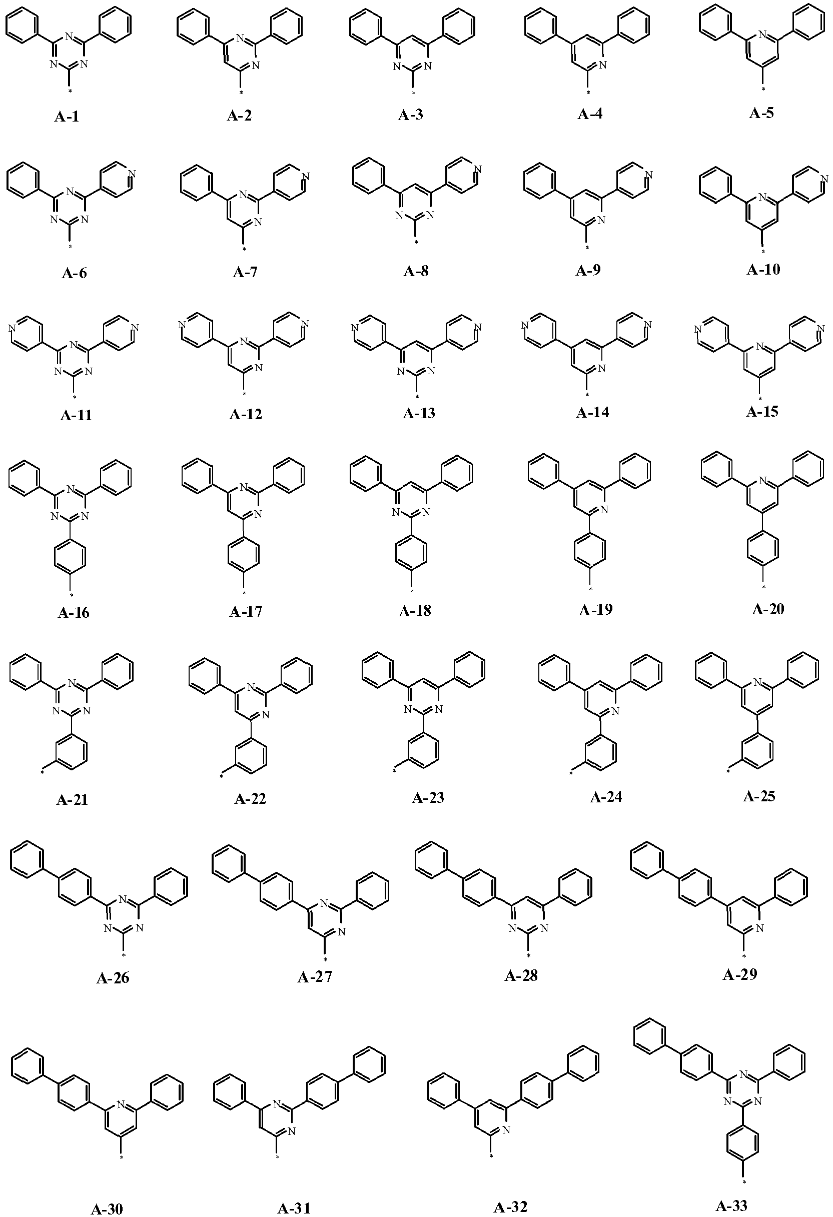

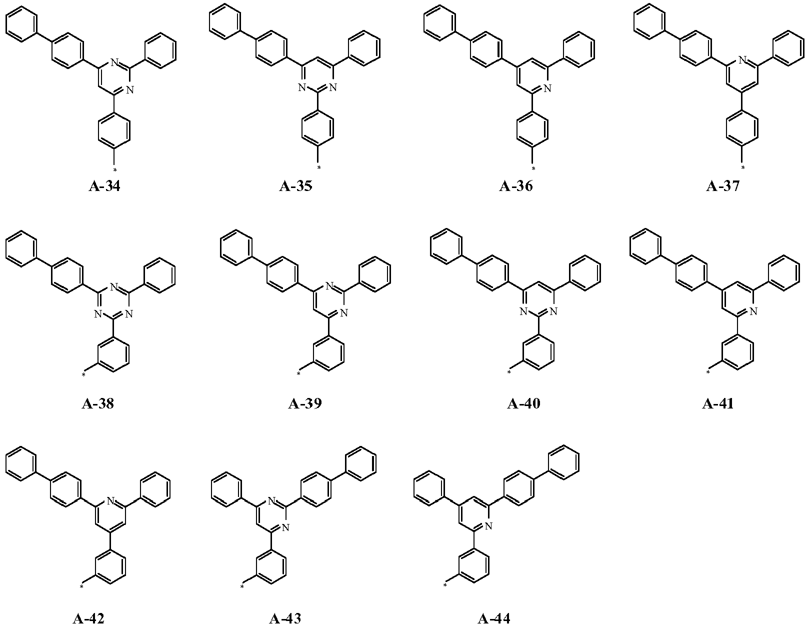

The moiety represented by Chemical Formula 2 may be, for example represented by one of Chemical Formulae 2-1 to 2-3, but is not limited thereto.

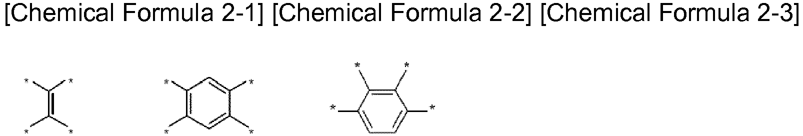

In the moiety represented by Chemical Formula 3, Ar¹ may be, for example a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted carbazolyl group, a substituted or unsubstituted benzofuranyl group, a substituted or unsubstituted benzothiophenyl group, a substituted or unsubstituted fluorenyl group, a substituted or unsubstituted dibenzofuranyl group, a substituted or unsubstituted dibenzothiophenyl group, or a combination thereof.

The X² may be, for example one of substituents listed in Group 3, but is not limited thereto.

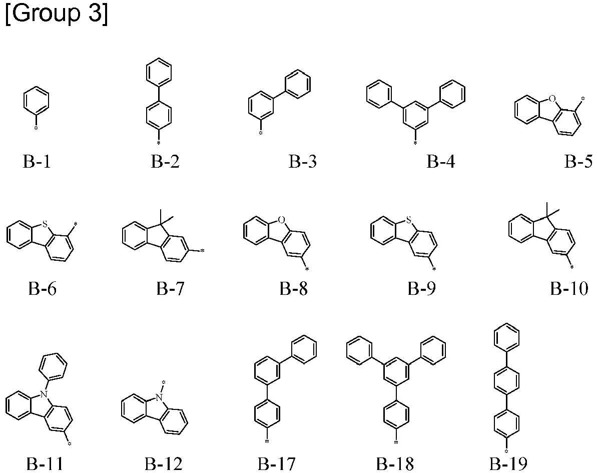

The first compound may be, for example one of substituents listed in Group 4, but is not limited thereto.

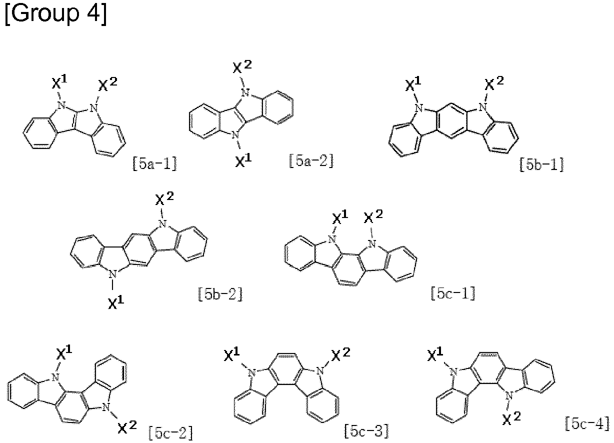

In Group 4, X¹ and X² are the same as described above.

In one embodiment, the first compound of the invention may be one of substituents listed in Group 4, X¹ is *-Y¹-ET, X² is *-Y²-Ar¹,

Y¹ and Y² are each independently a single bond, a substituted or unsubstituted C6 to C30 arylene group, or a combination thereof,

Ar¹ is a substituted or unsubstituted phenyl group, a substituted or unsubstituted biphenyl group, a substituted or unsubstituted terphenyl group, a substituted or unsubstituted quaterphenyl group, a substituted or unsubstituted naphthalenyl group, a substituted or unsubstituted dibenzofuranyl group, a substituted or unsubstituted dibenzothiophenyl group, a substituted or unsubstituted fluorenyl group, or a substituted or unsubstituted carbazolyl group,

ET is represented by Chemical Formula 1a,

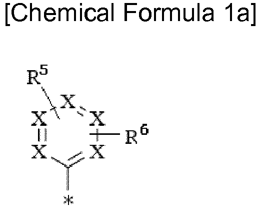

In Chemical Formula 1a,
X is N, C or CR^{a},
at least one of X is N,
R⁵, R⁶ and R^{a} are each independently hydrogen, deuterium, a substituted or unsubstituted C1 to C20 alkyl group, a substituted or unsubstituted C6 to C30 aryl group or a combination thereof, and
* is a linking point.

The first compound may be, for example one of compounds listed in Group 5, but is not limited thereto.

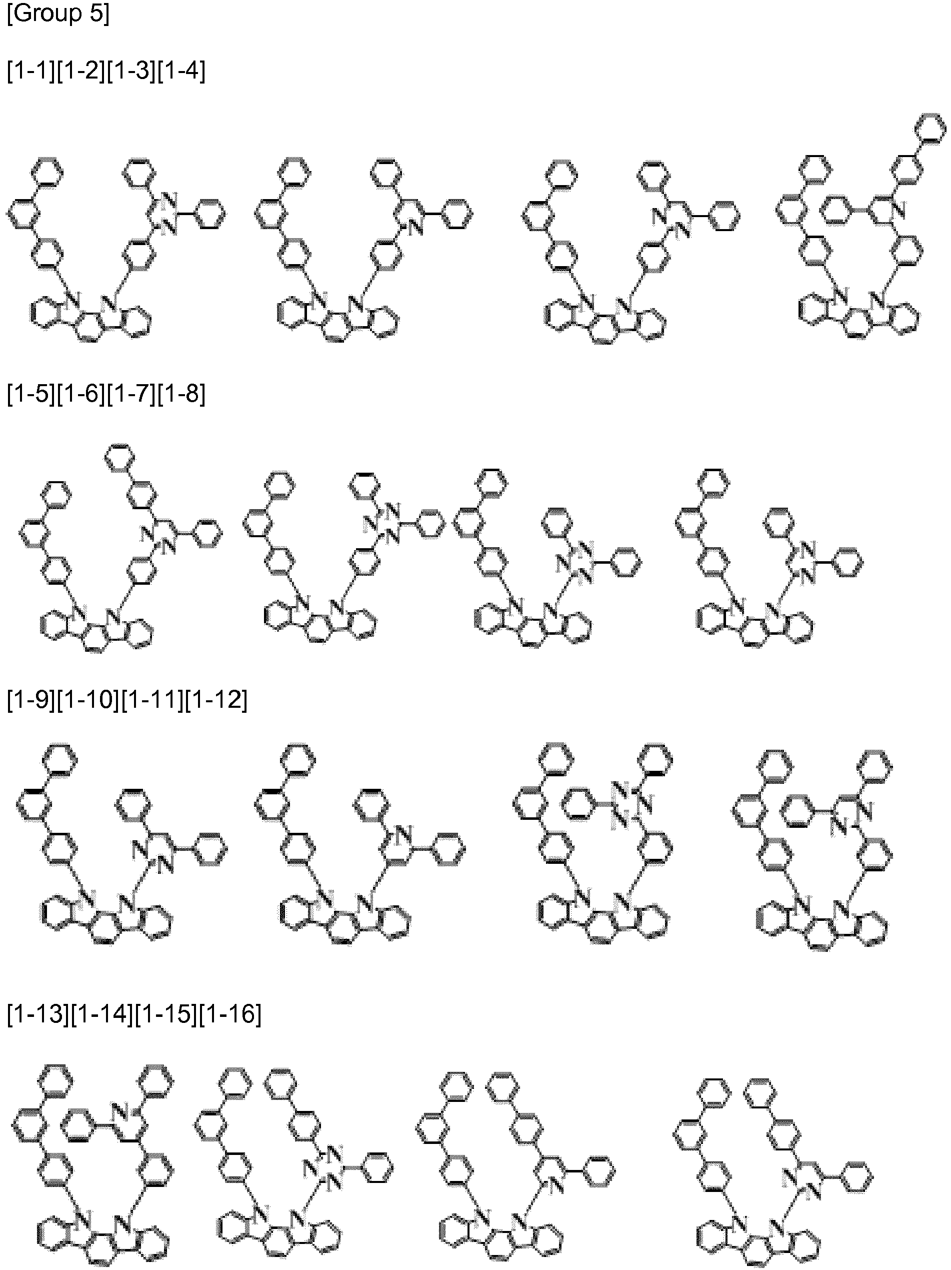

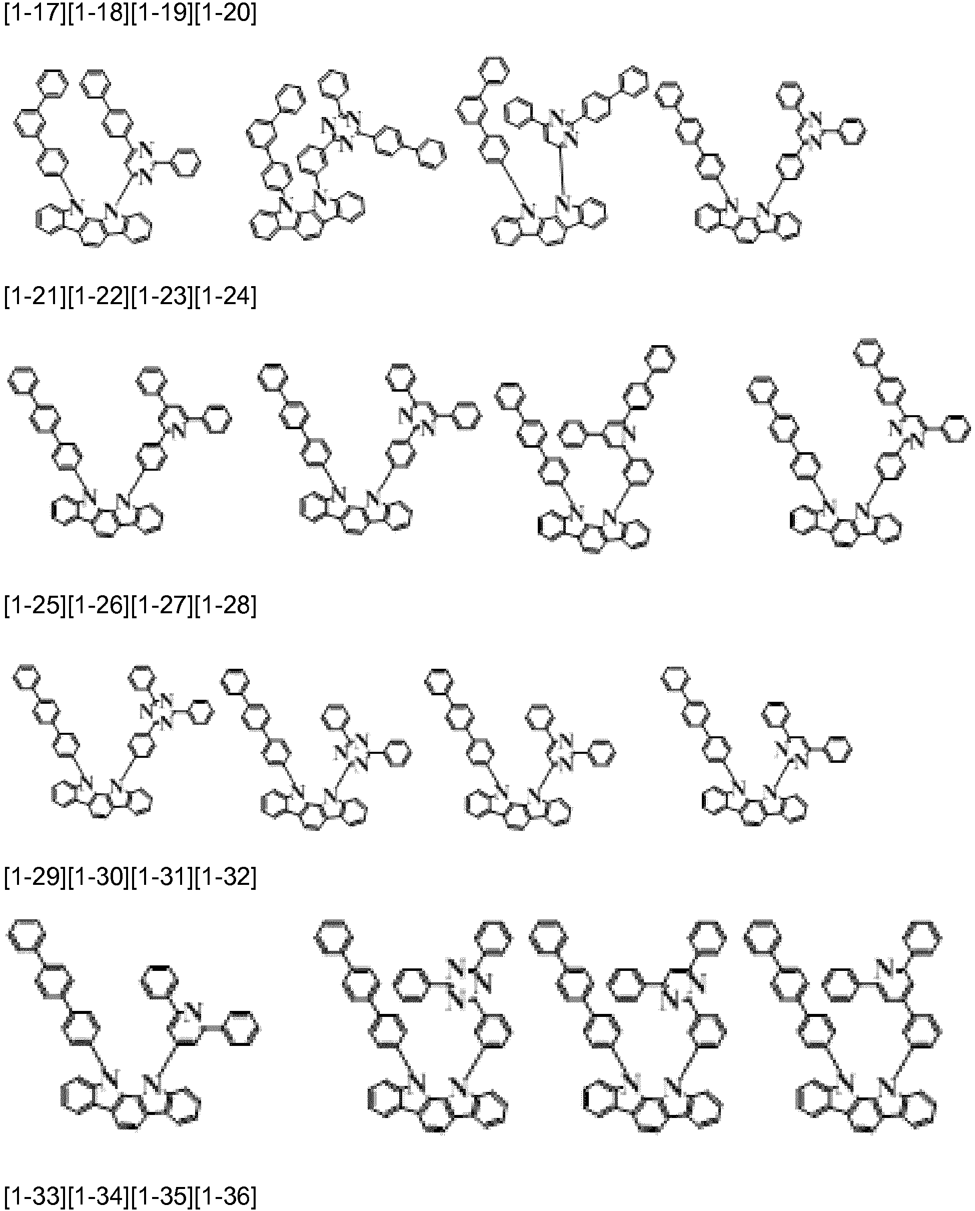

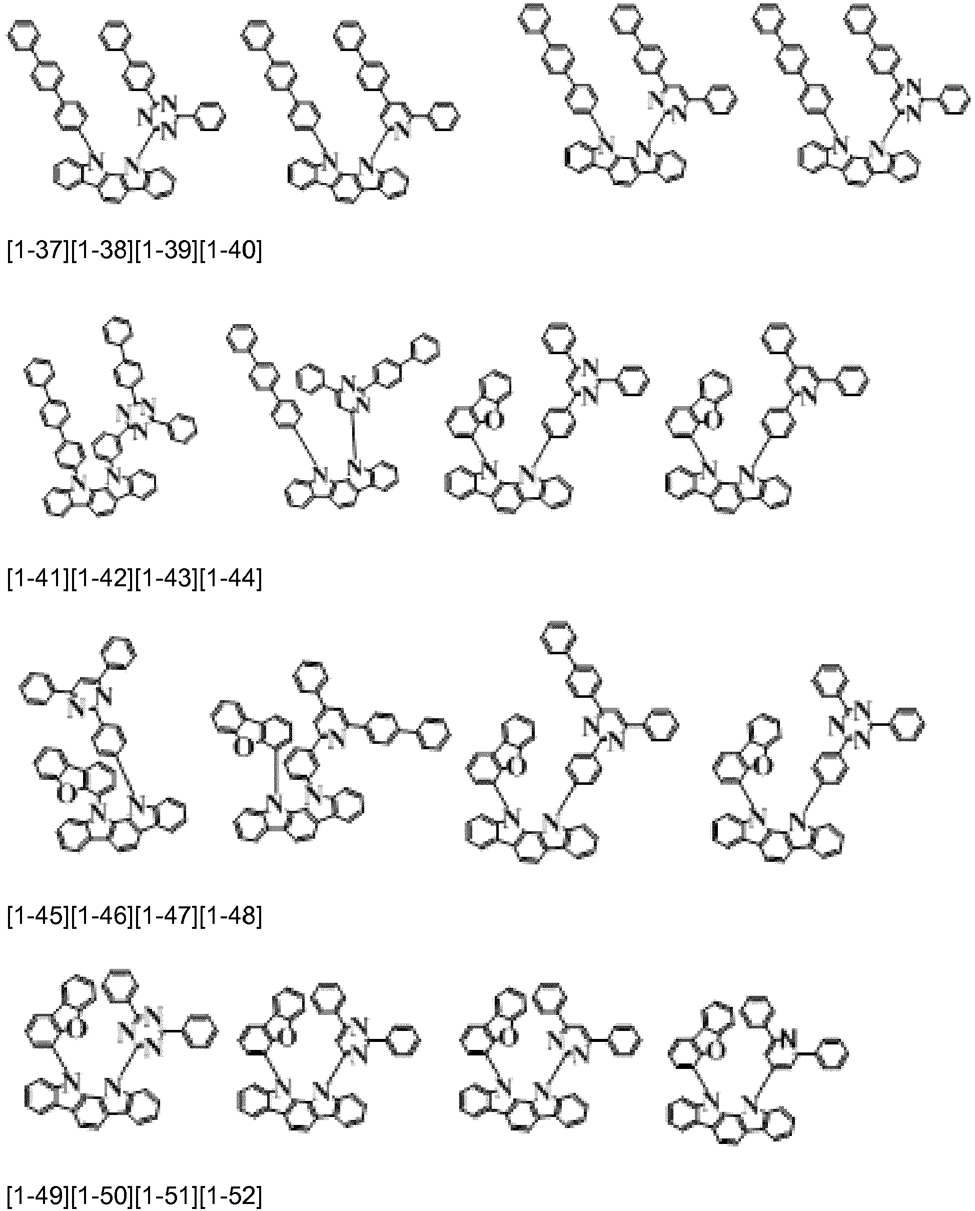

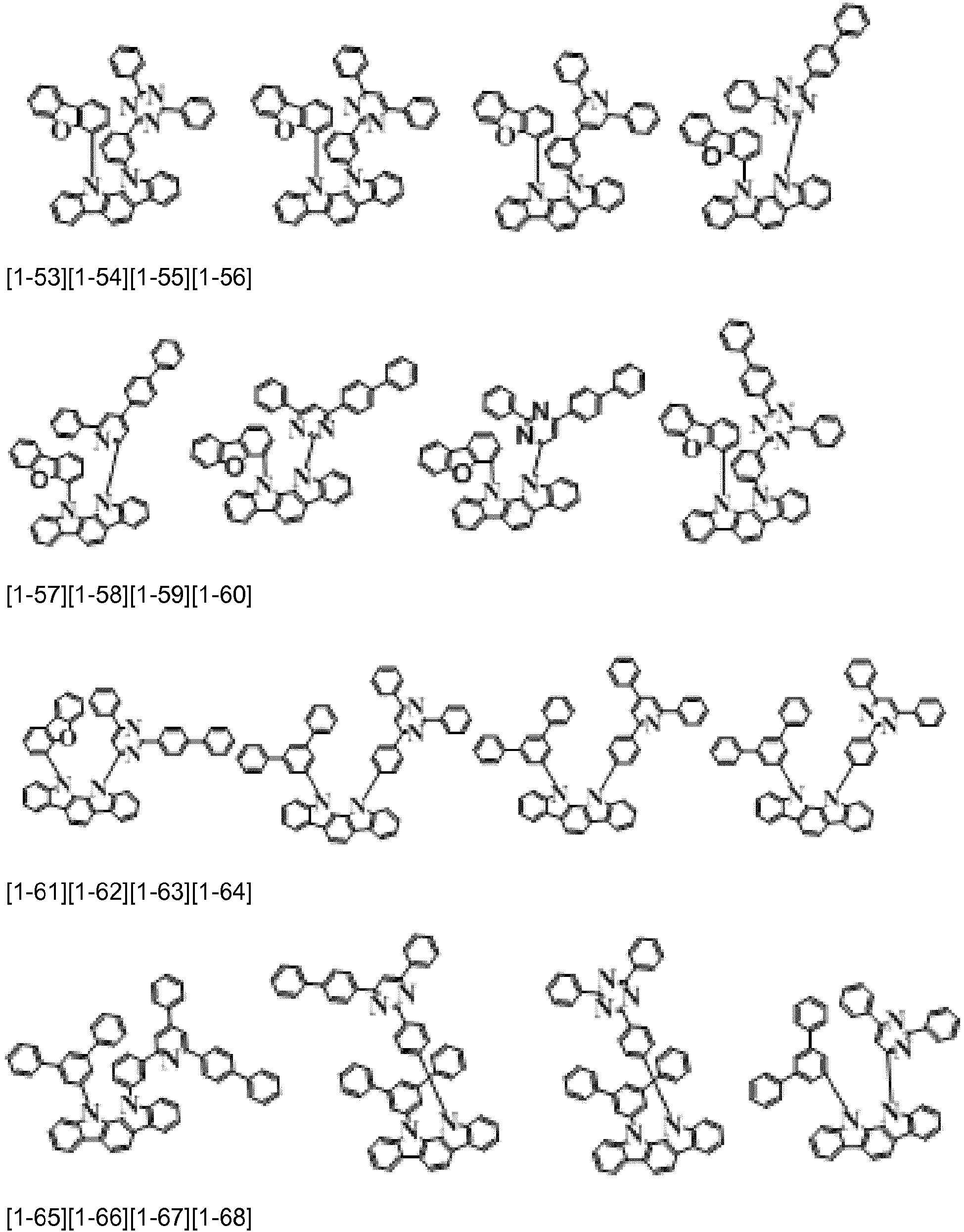

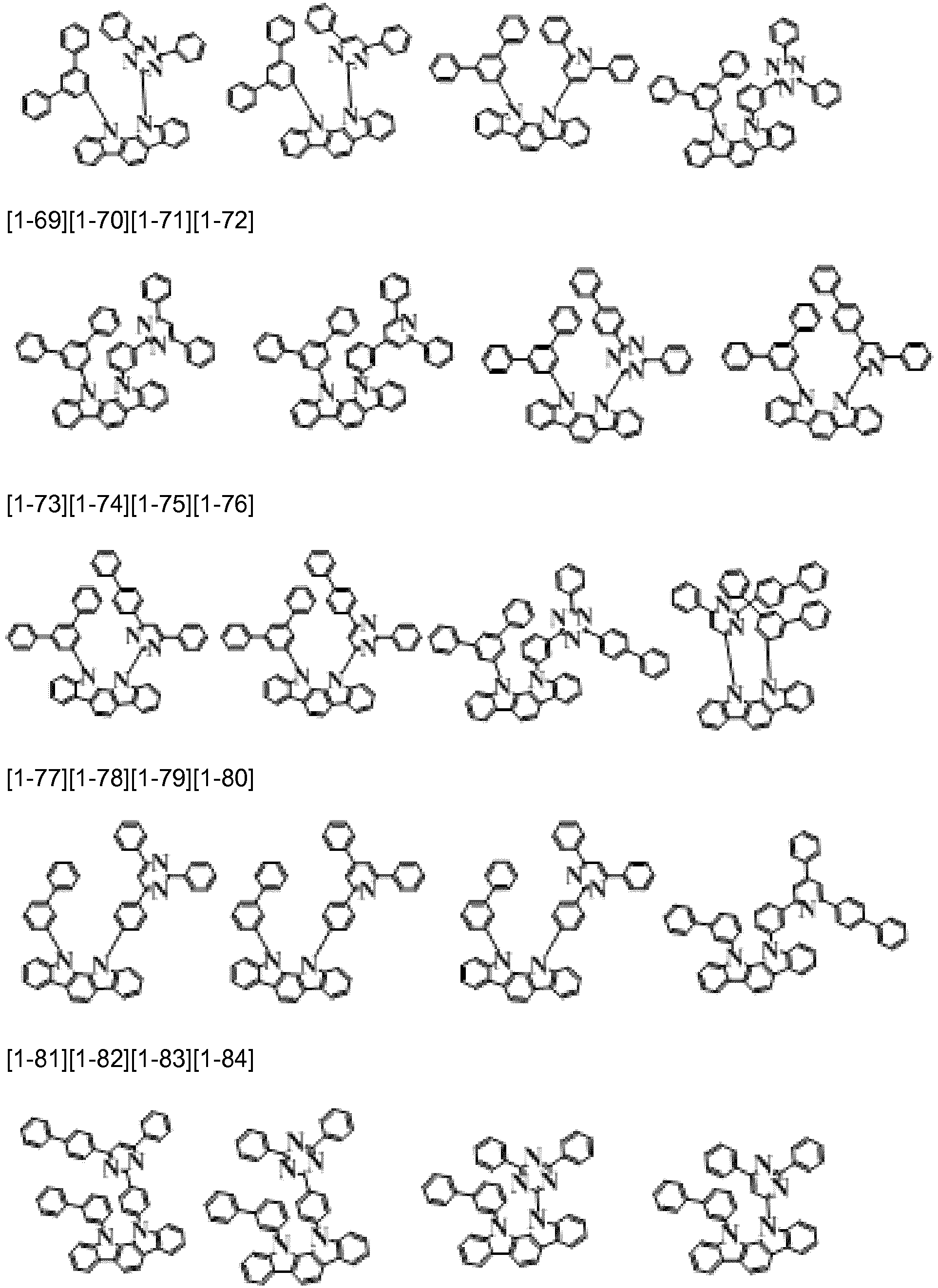

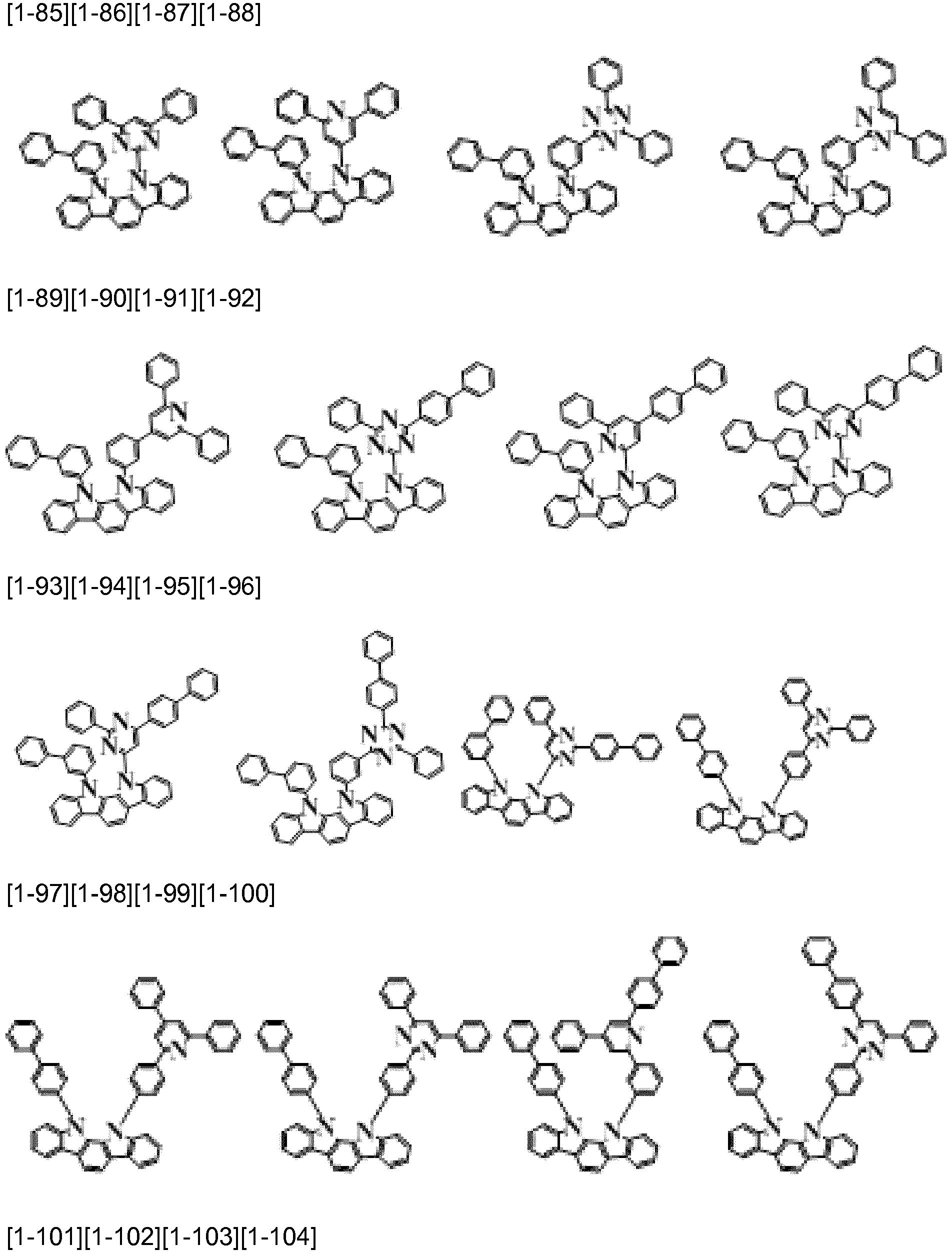

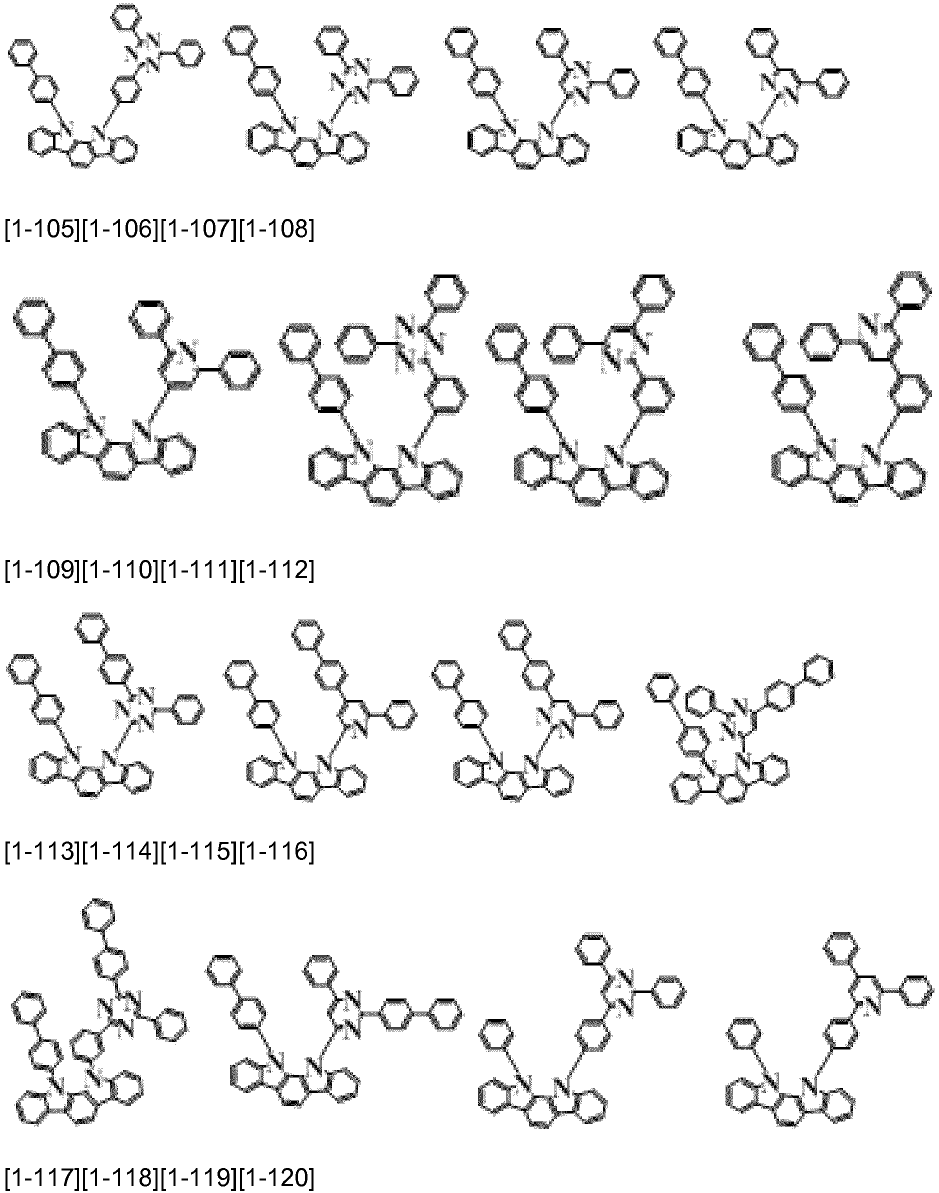

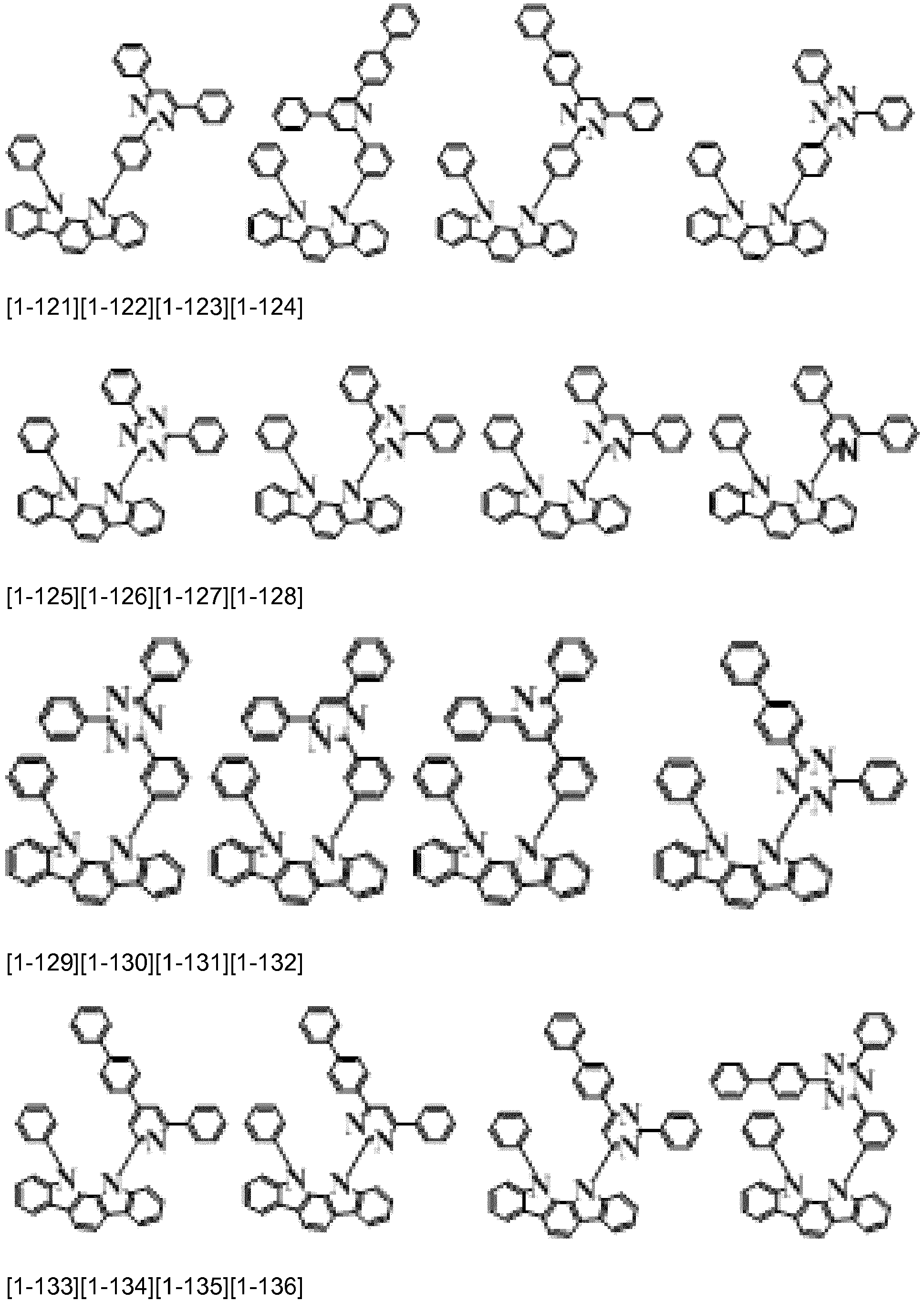

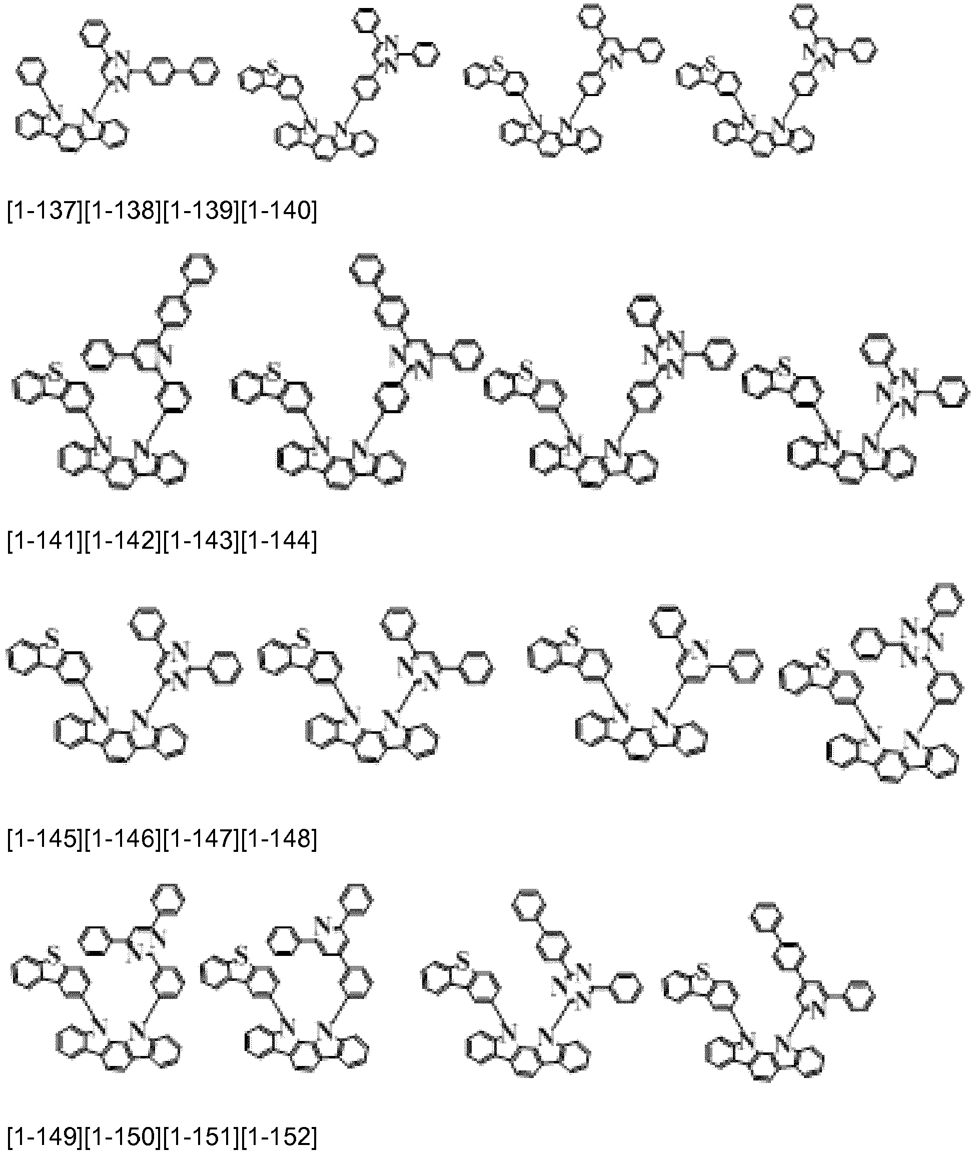

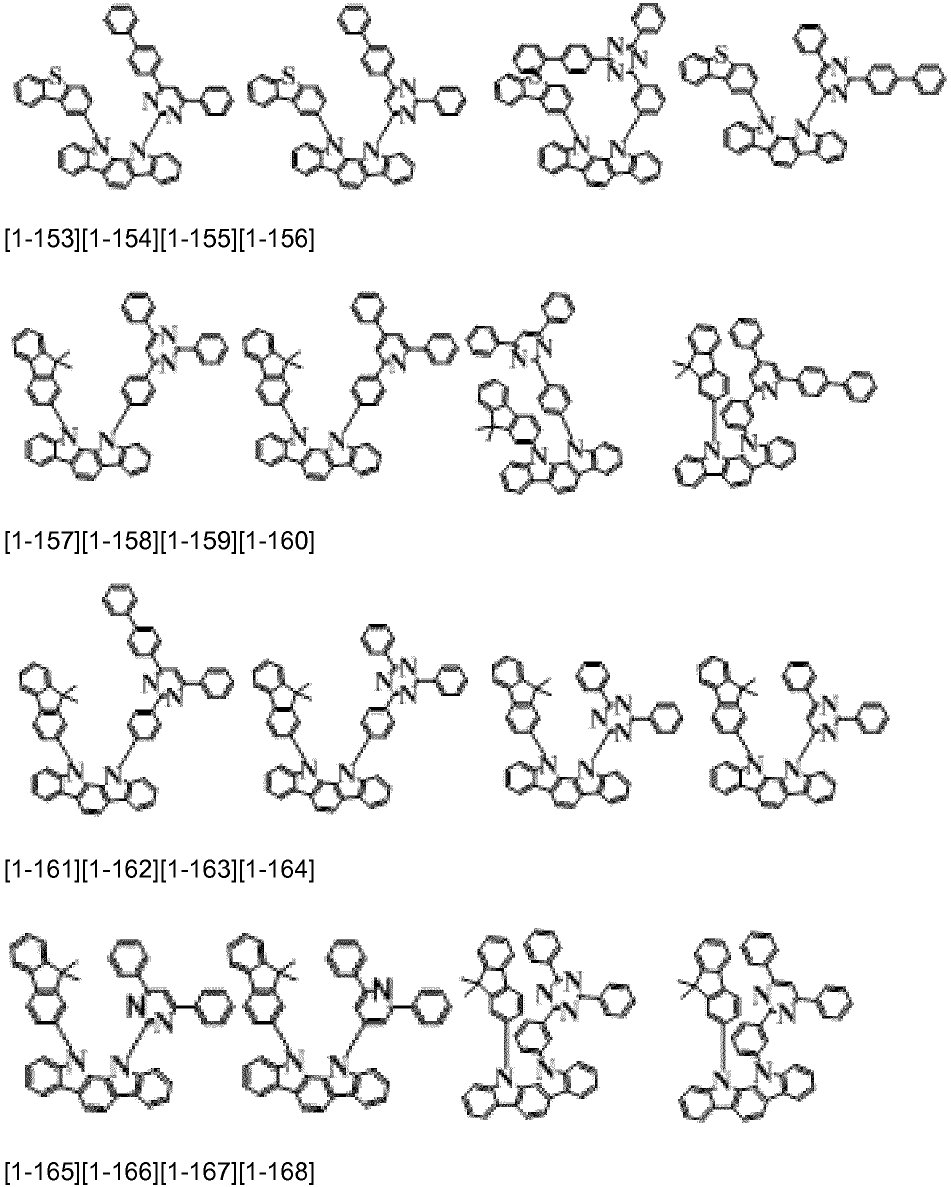

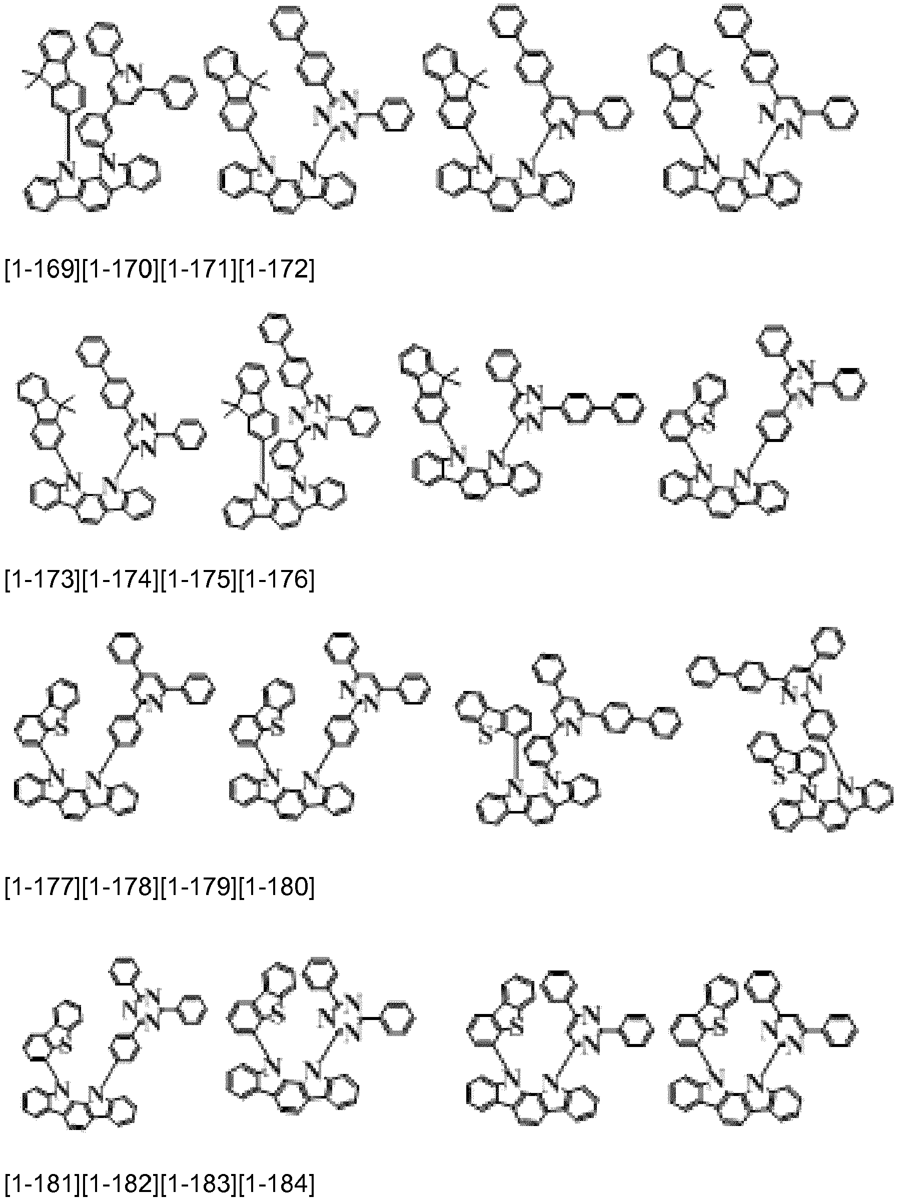

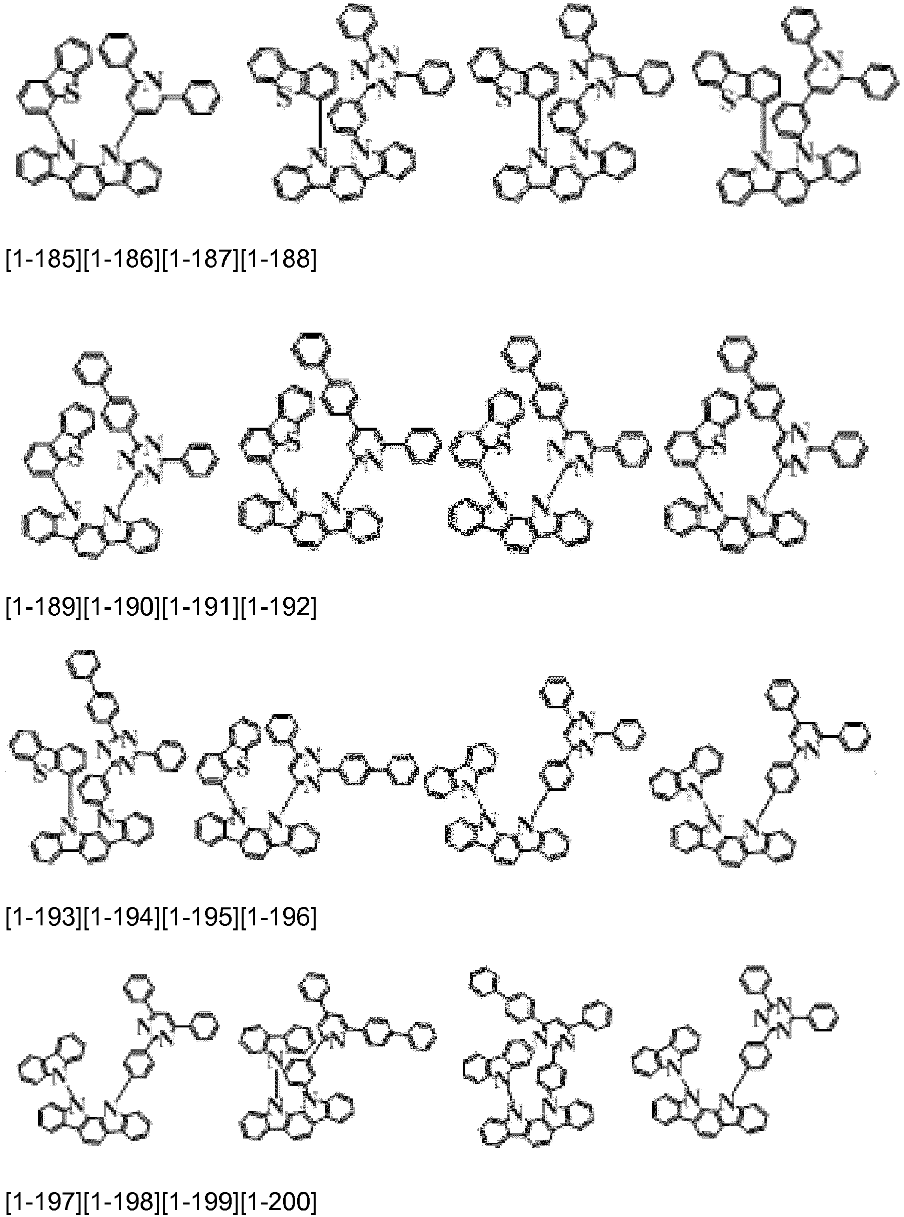

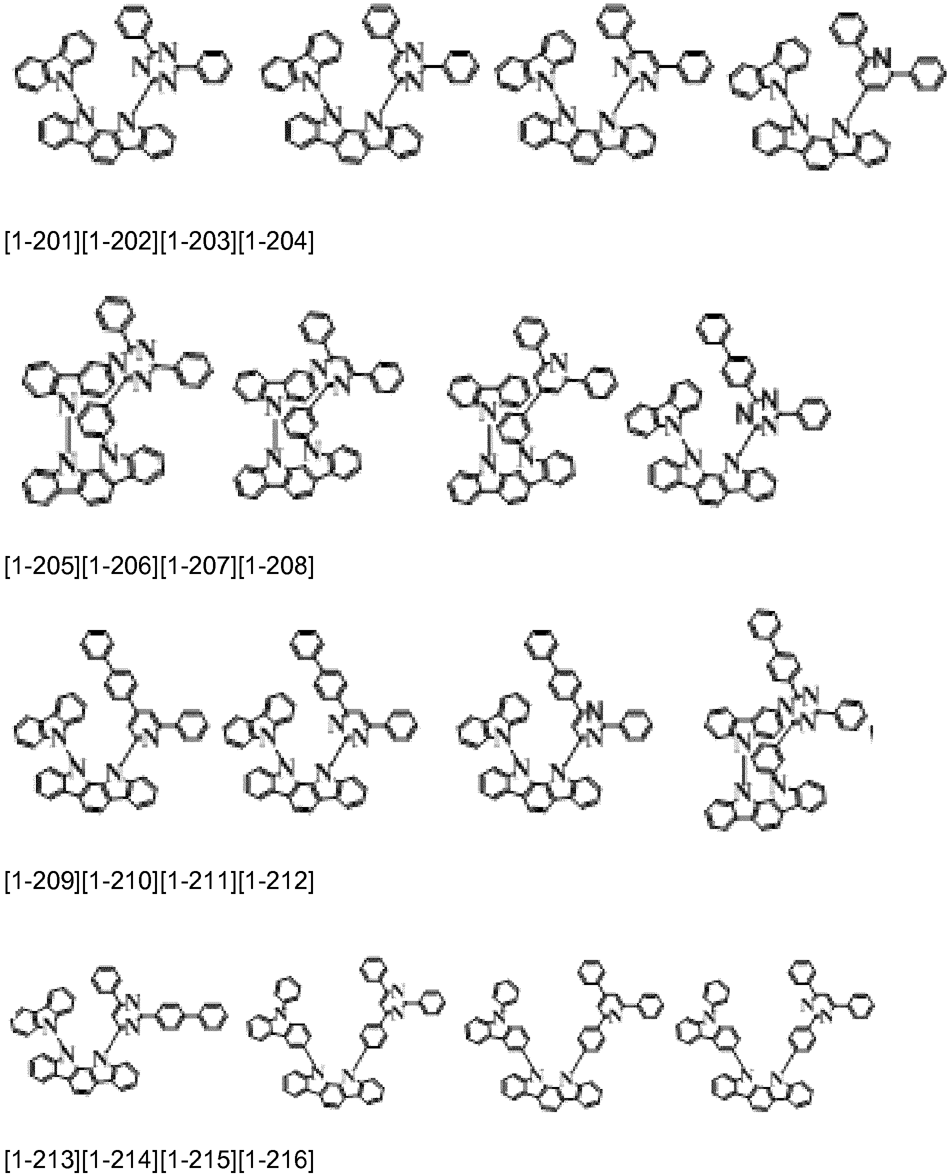

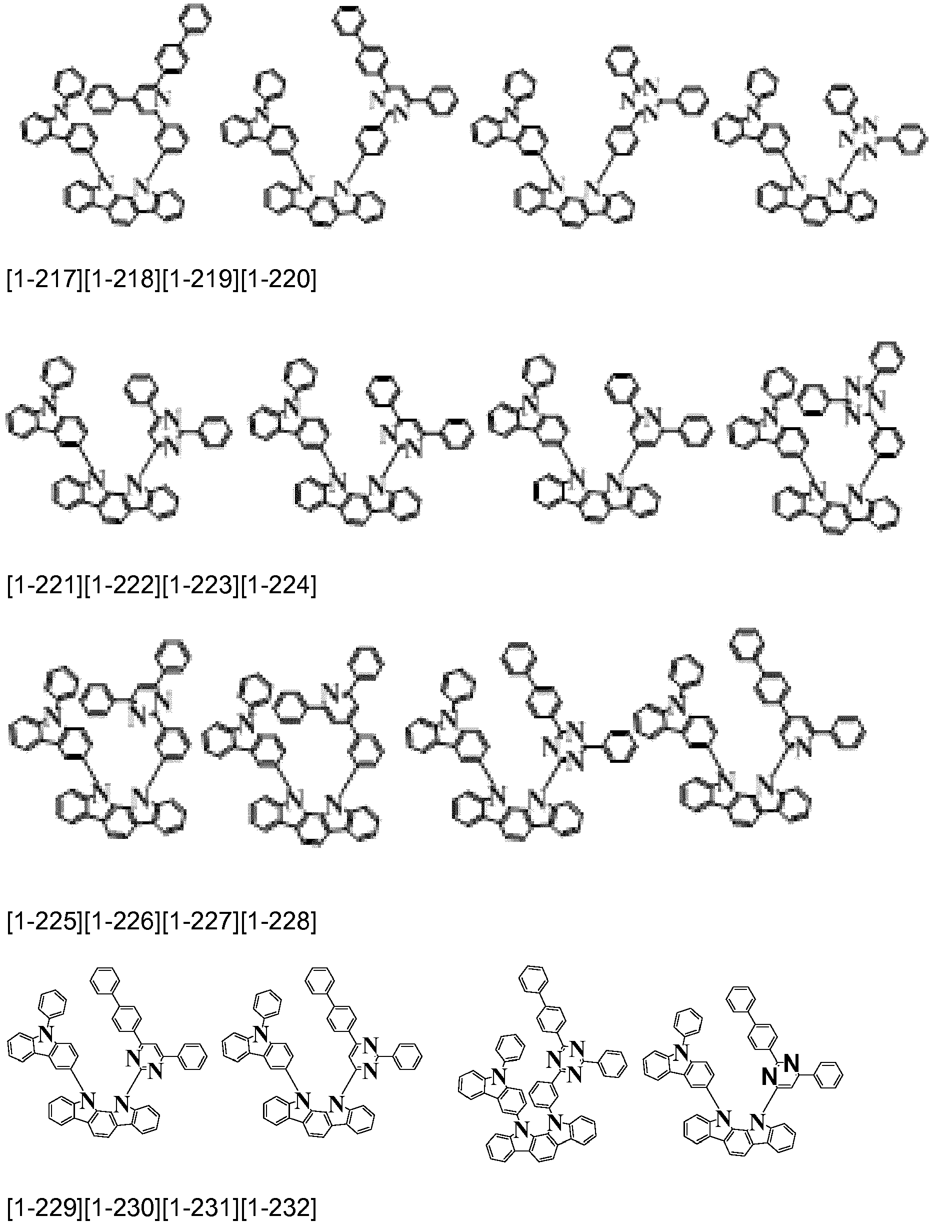

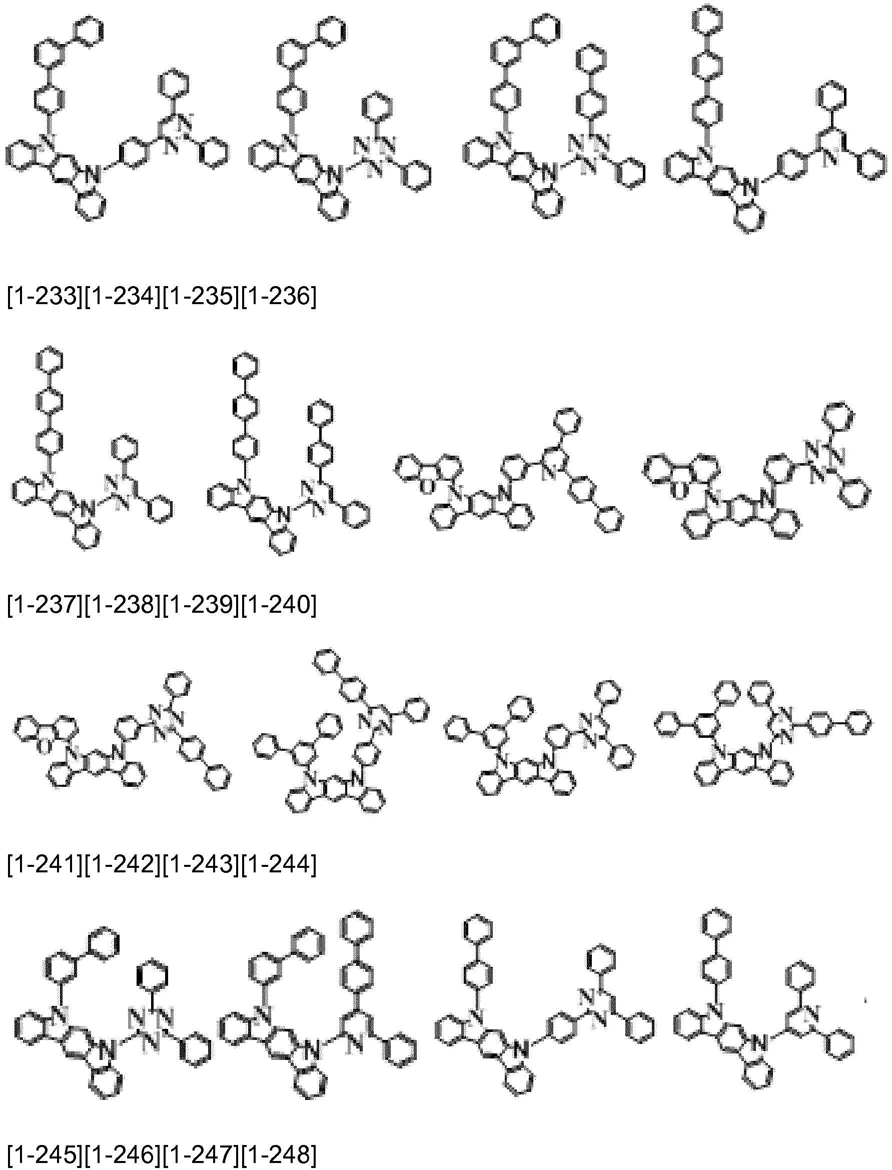

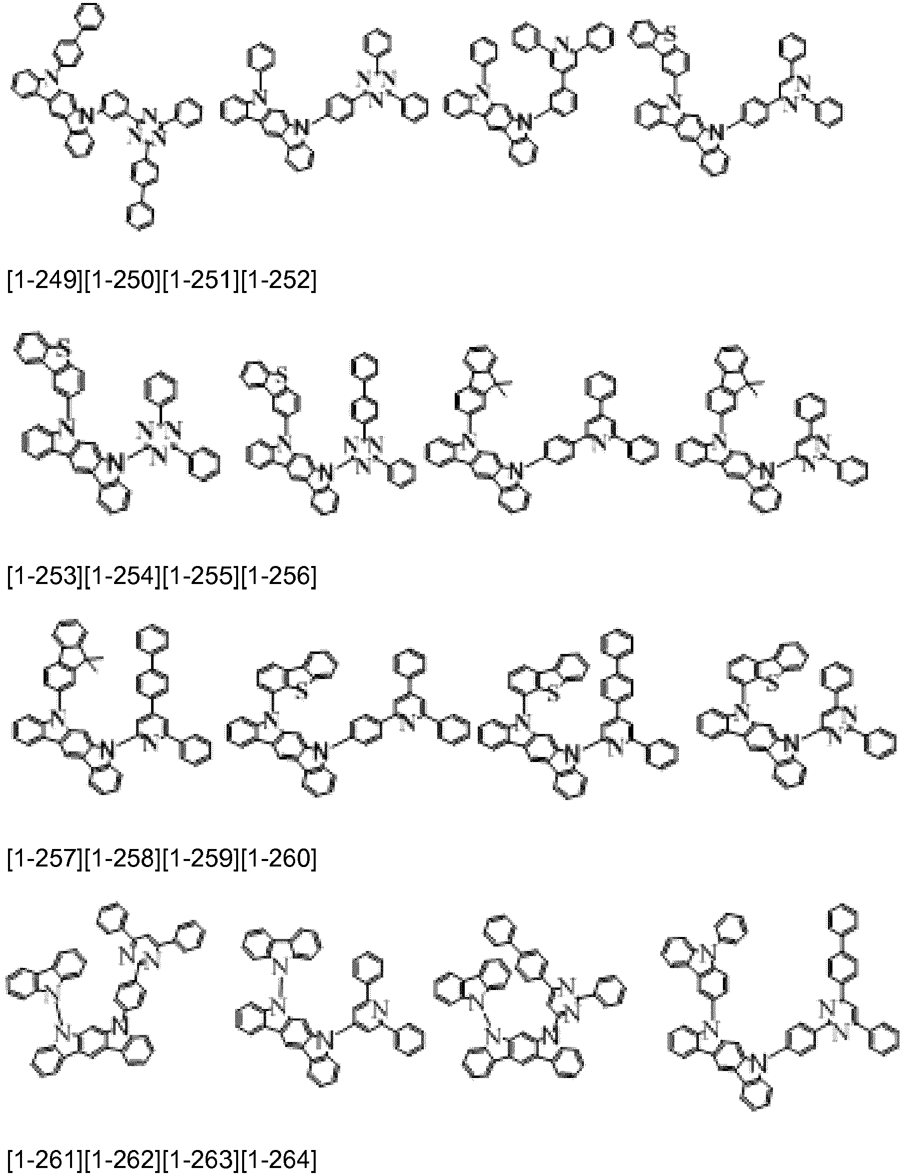

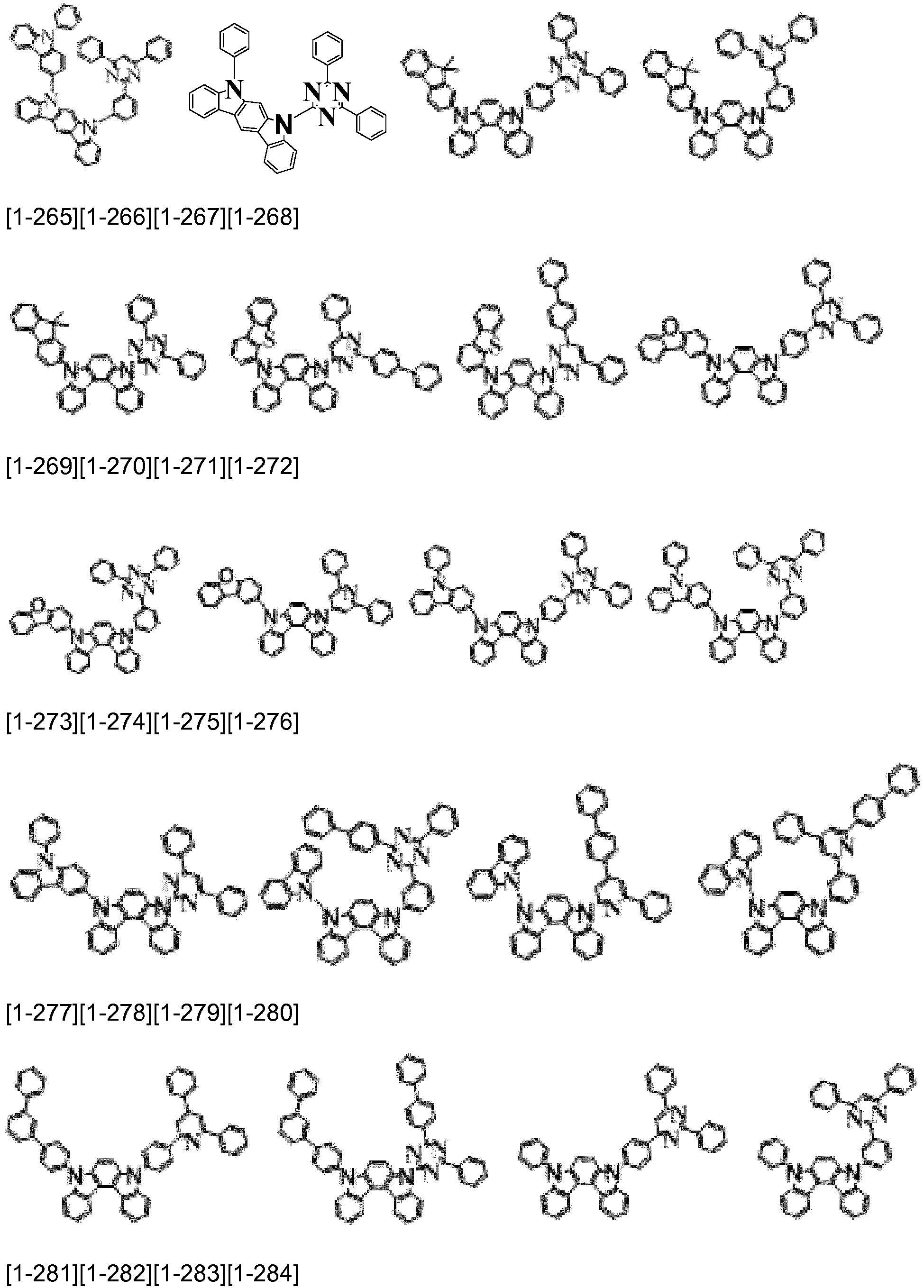

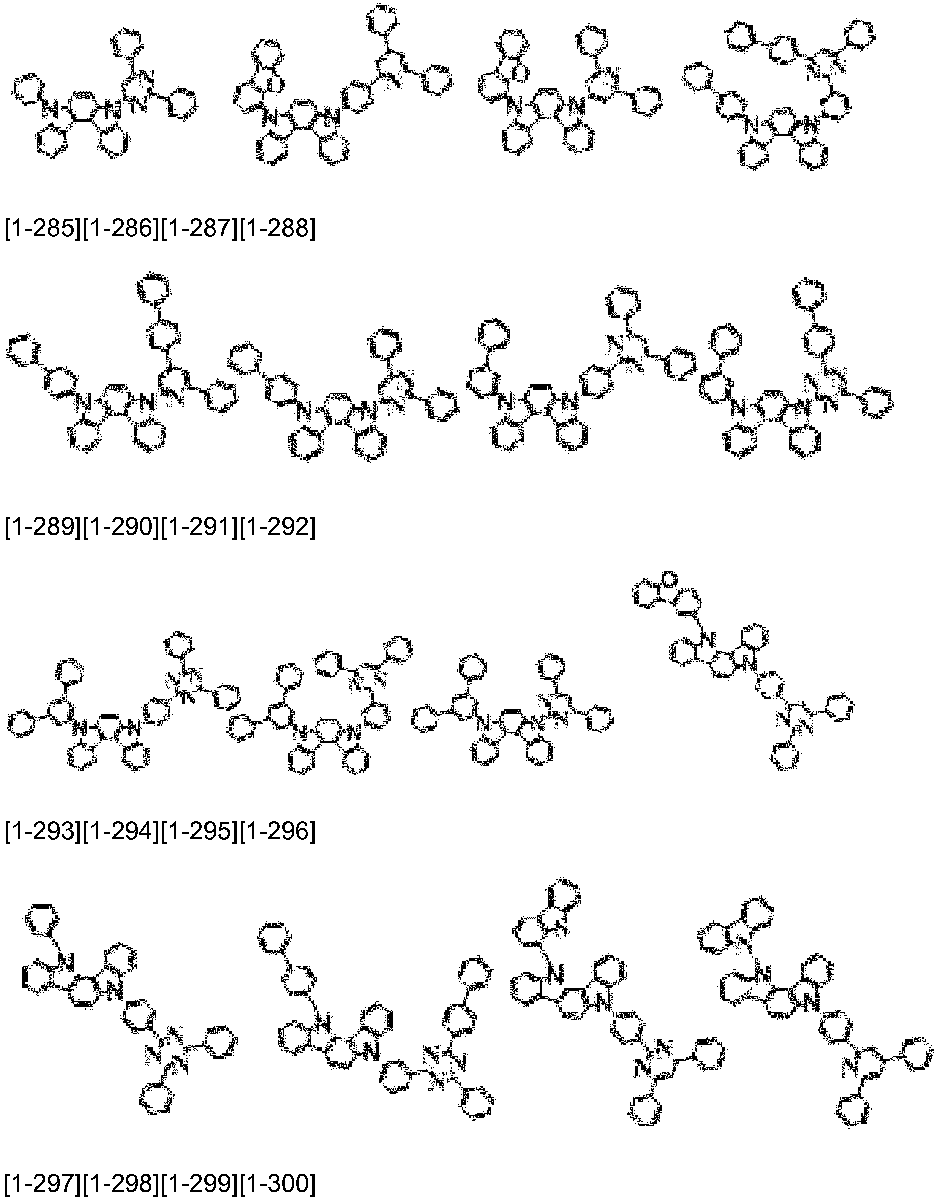

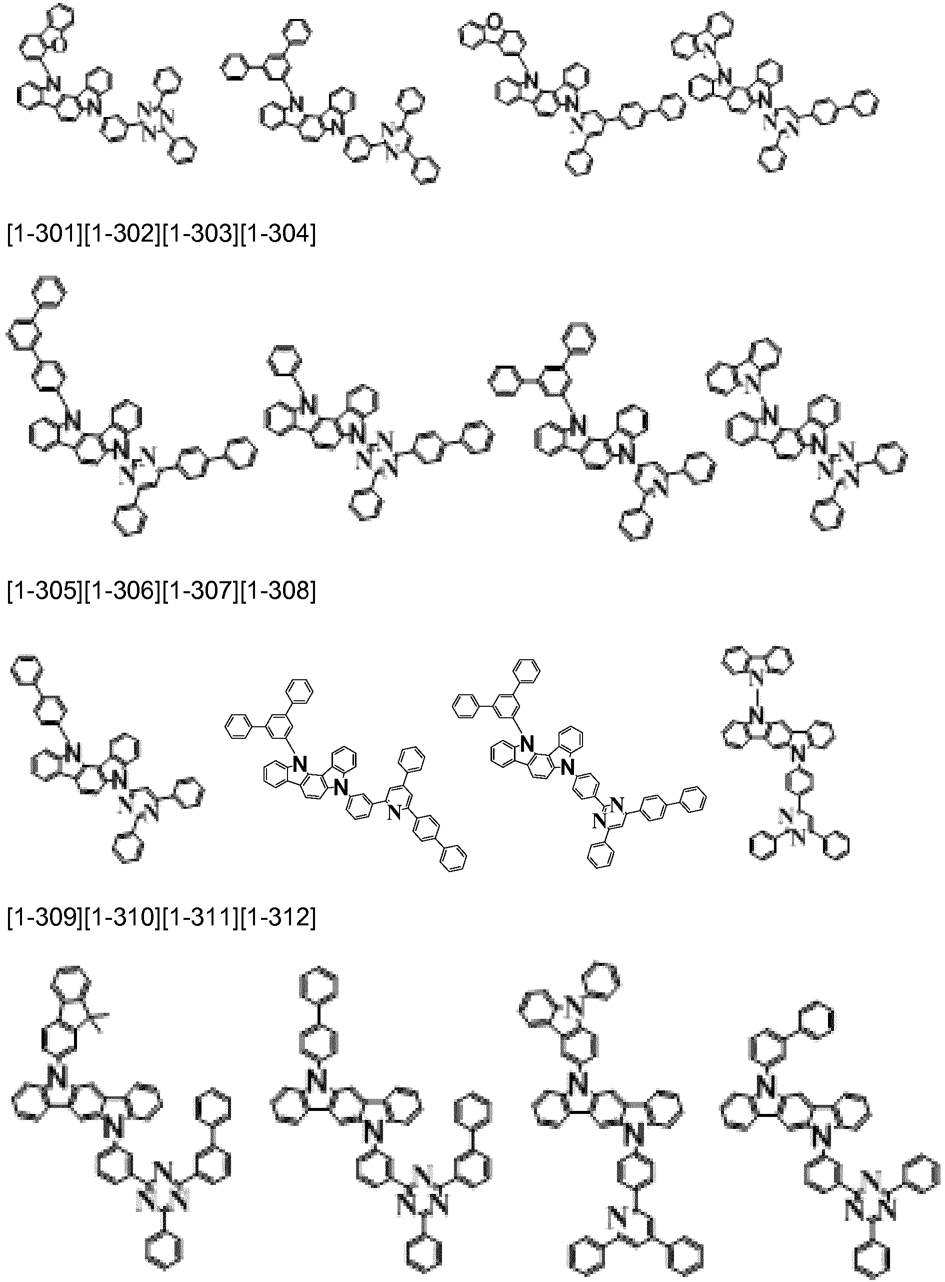

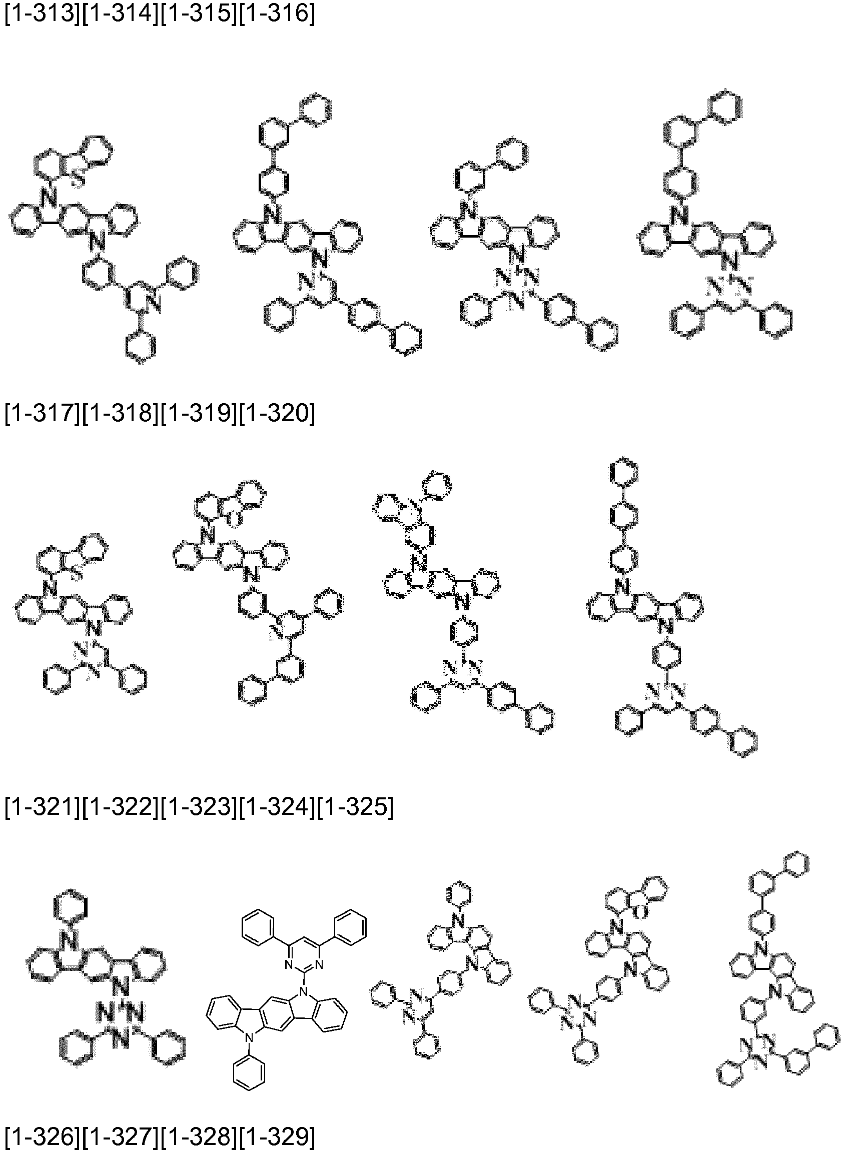

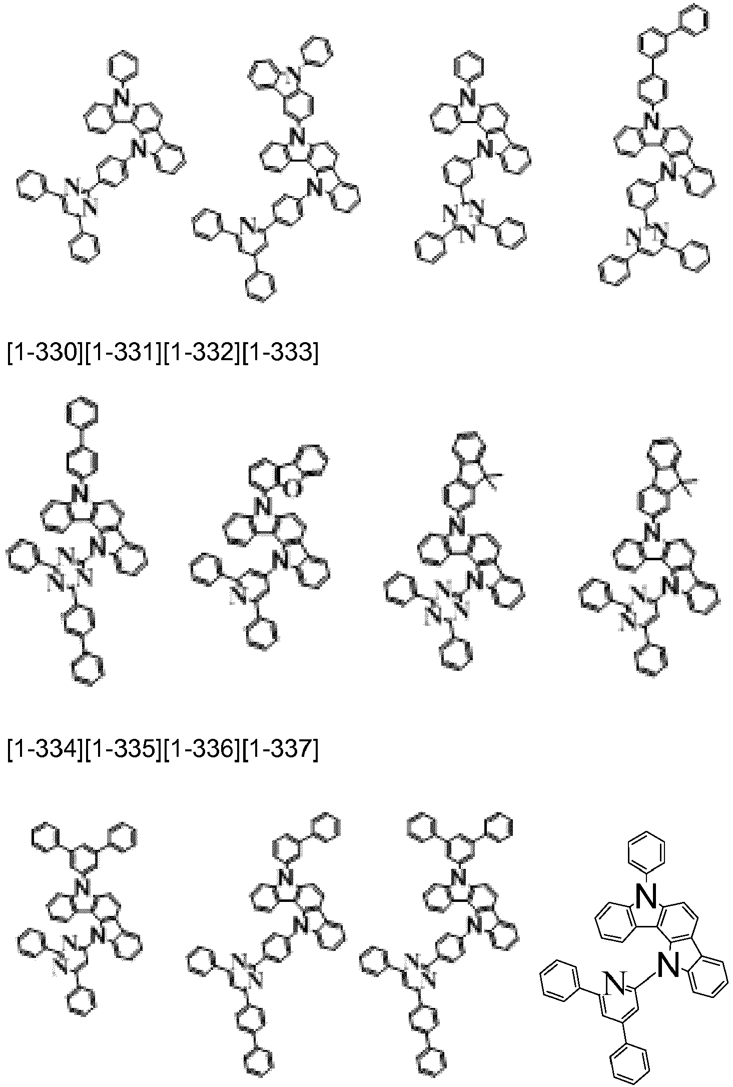

One or more of the first compound may be used.

The second compound includes at least one carbazolyl group, and may be represented by Chemical Formula 4.

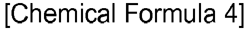

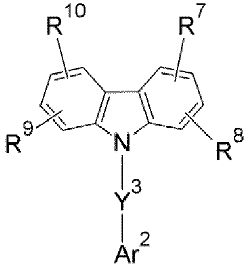

In Chemical Formula 4,
Y³ is a single bond, a substituted or unsubstituted C6 to C30 arylene group, a substituted or unsubstituted C2 to C30 heteroarylene group, or a combination thereof,
Ar² is a substituted or unsubstituted C6 to C30 aryl group, substituted or unsubstitutedC2 to C30 heteroaryl group, or a combination thereof,
R⁷ to R¹⁰ are each independently hydrogen, deuterium, a substituted or unsubstituted C1 to C20 alkyl group, a substituted or unsubstituted C6 to C50 aryl group, a substituted or unsubstituted C2 to C50 heteroaryl group, or a combination thereof, and
at least one of R⁷ to R¹⁰ and Ar² includes a substituted or unsubstituted triphenylene group or a substituted or unsubstituted carbazolyl group.

The second compound may be, for example represented by at least one of Chemical Formulae 4-I to 4-III.

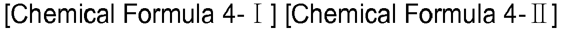

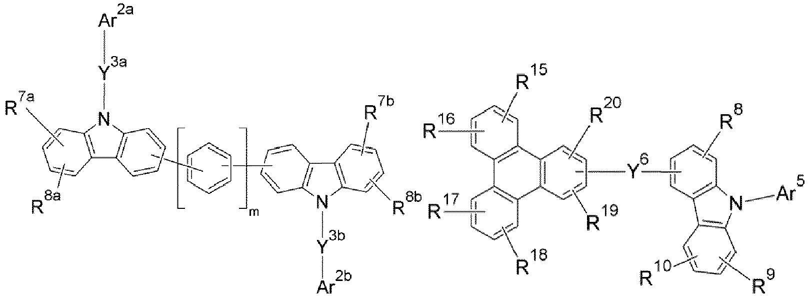

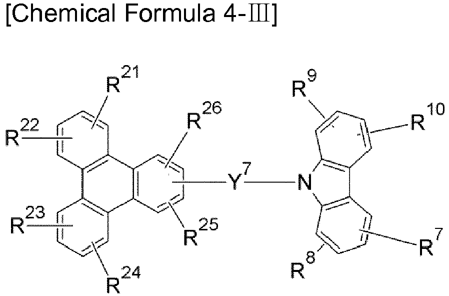

In Chemical Formulae 4-I to 4-III, Y^{3a}, Y^{3b}, Y⁶ and Y⁷ are each independently a single bond, a substituted or unsubstituted C6 to C30 arylene group, a substituted or unsubstituted C2 to C30 heteroarylene group, or a combination thereof,
Ar^{2a}, Ar^{2b} and Ar⁵ are each independently a substituted or unsubstituted C6 to C30 aryl group, a substituted or unsubstituted C2 to C30 heteroaryl group, or a combination thereof,
R^{7a}, R^{8a}, R^{7b}, R^{8b}, R⁷ to R¹⁰, and R¹⁵ to R²⁶ are each independently hydrogen, deuterium, a substituted or unsubstituted C1 to C20 alkyl group, a substituted or unsubstituted C6 to C50 aryl group, a substituted or unsubstituted C2 to C50 heteroaryl group, or a combination thereof, and
m is one of integers of 0 to 4.

The center core of biscarbazole of Chemical Formula 4-I may be one of structures listed in Group 6. The *-Y^{3a}-Ar^{2a}, and *-Y^{3b}-Ar^{2b} may be, for example one of substituents listed in Group 3.

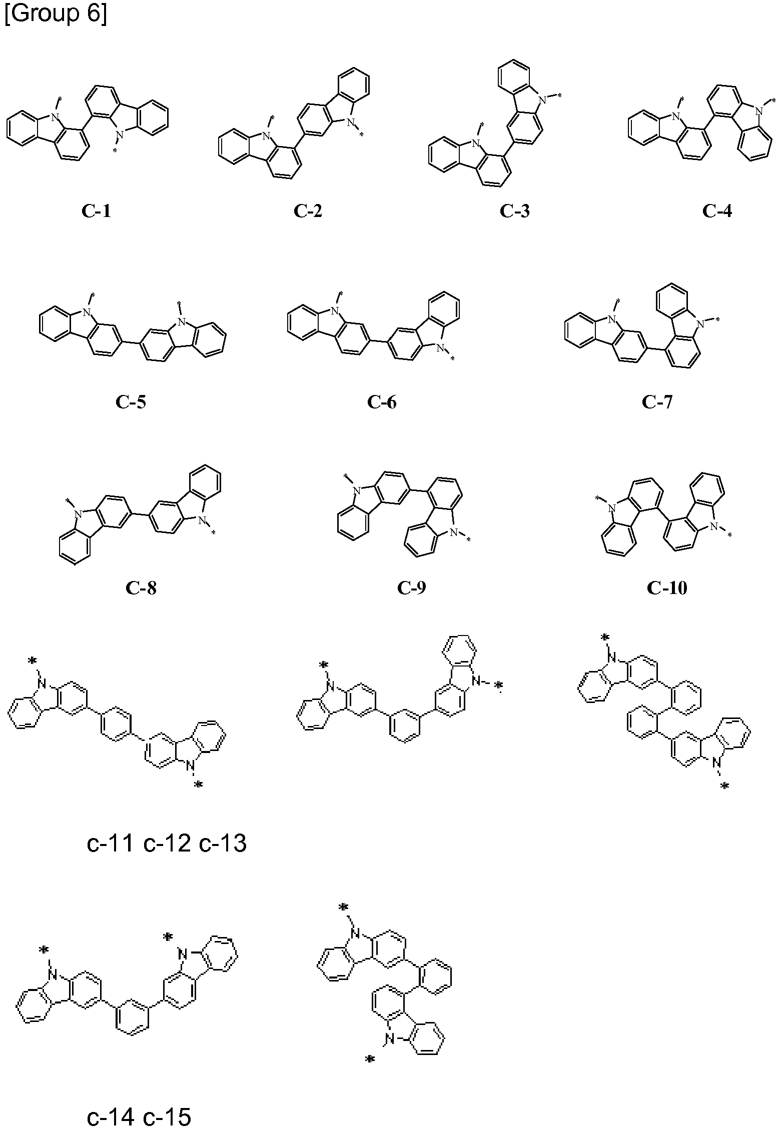

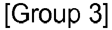

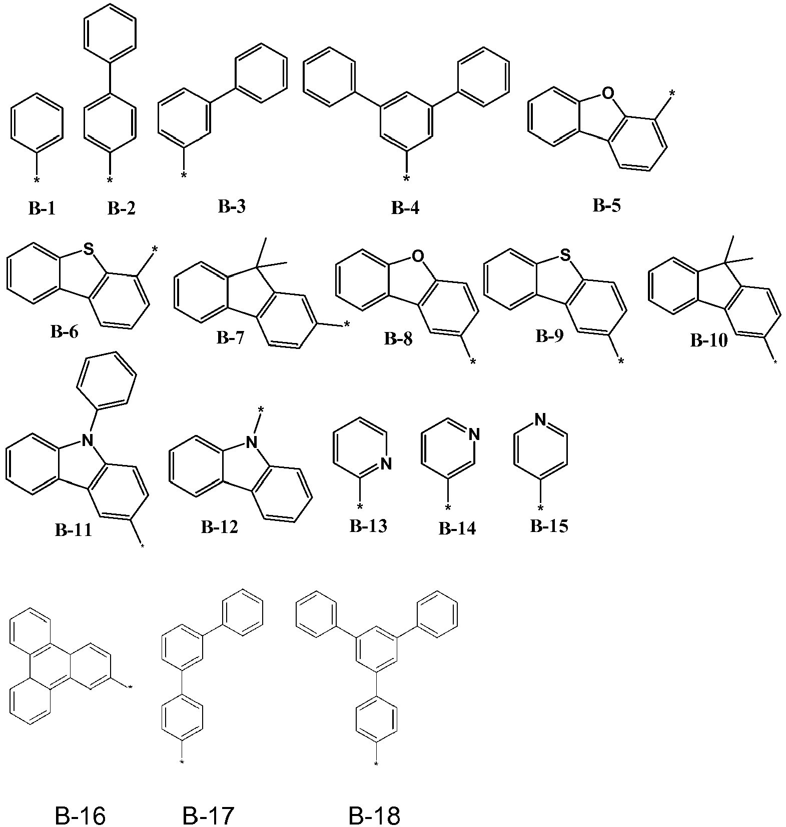

In Group 3 and Group 6, * is a linking point.

In Chemical Formula 4-II, Ar⁵ may be, for example a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted carbazolyl group, a substituted or unsubstituted benzofuranyl group, a substituted or unsubstituted benzothiophenyl group, a substituted or unsubstituted fluorenyl group, a substituted or unsubstituted dibenzothiophenyl group, a substituted or unsubstituted dibenzofuranyl group, a substituted or unsubstituted pyridinyl group, a substituted or unsubstituted pyrimidinyl group, or a combination thereof.

The second compound has bipolar characteristics that hole characteristics are relatively strong and may increase charge mobility and stability when used with the first compound for an emission layer and thus, remarkably improve luminous efficiency and life-span characteristics. In addition, the charge mobility may be controlled by adjusting a ratio between the second compound having hole characteristics and the first compound.

The Ar² may be, for example, a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted triphenylene group, a substituted or unsubstituted carbazolyl group, a substituted or unsubstituted benzofuranyl group, a substituted or unsubstituted benzothiophenyl group, a substituted or unsubstituted fluorenyl group, a substituted or unsubstituted dibenzofuranyl group, a substituted or unsubstituted dibenzothiophenyl group, a substituted or unsubstituted pyridinyl group, a substituted or unsubstituted pyrimidinyl group, or a combination thereof.

The second compound may be, for example one of compounds listed in Group 7, but is not limited thereto.

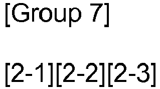

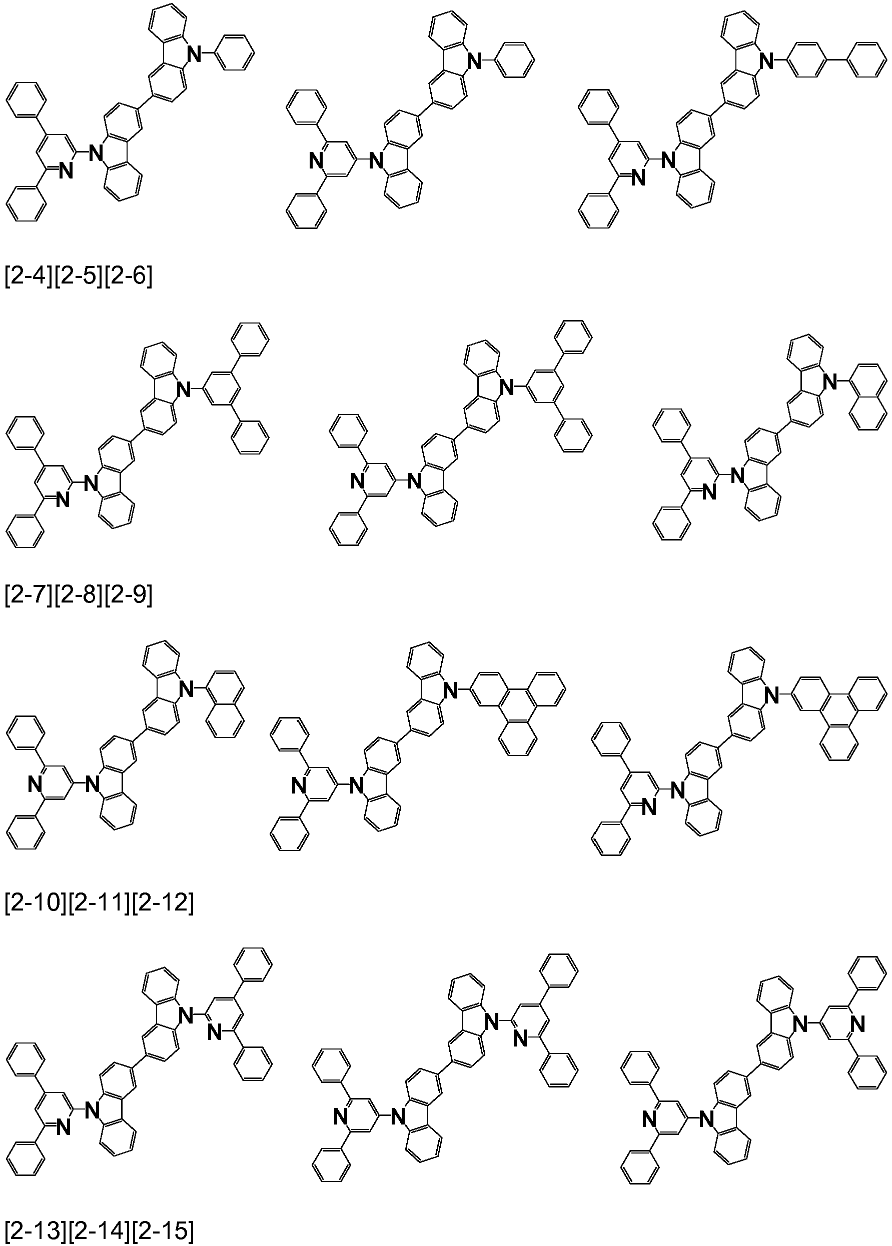

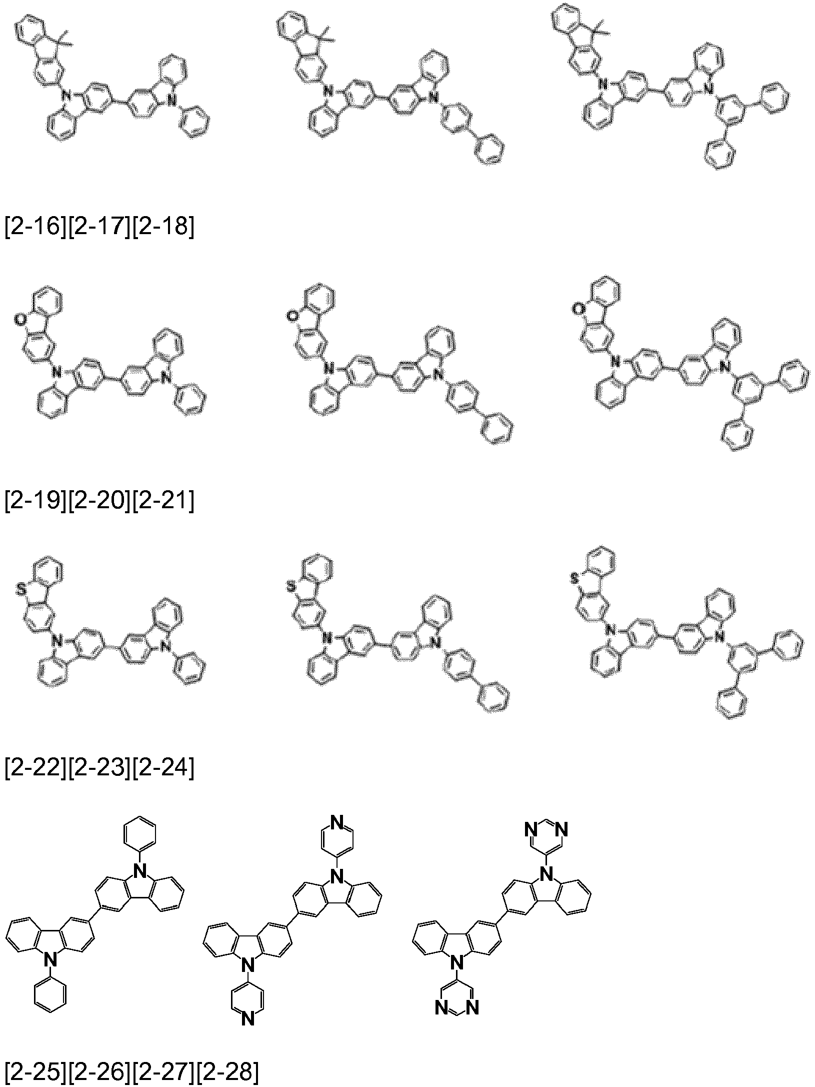

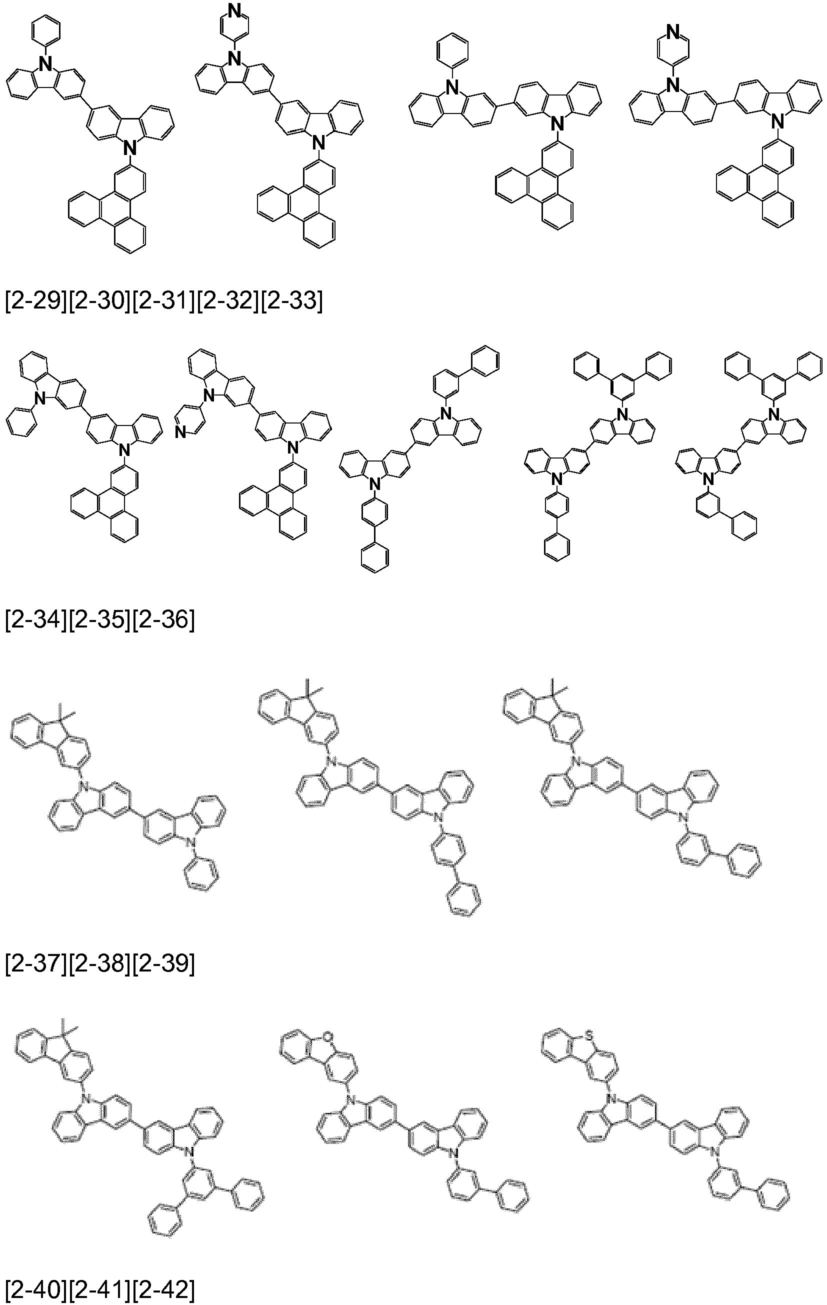

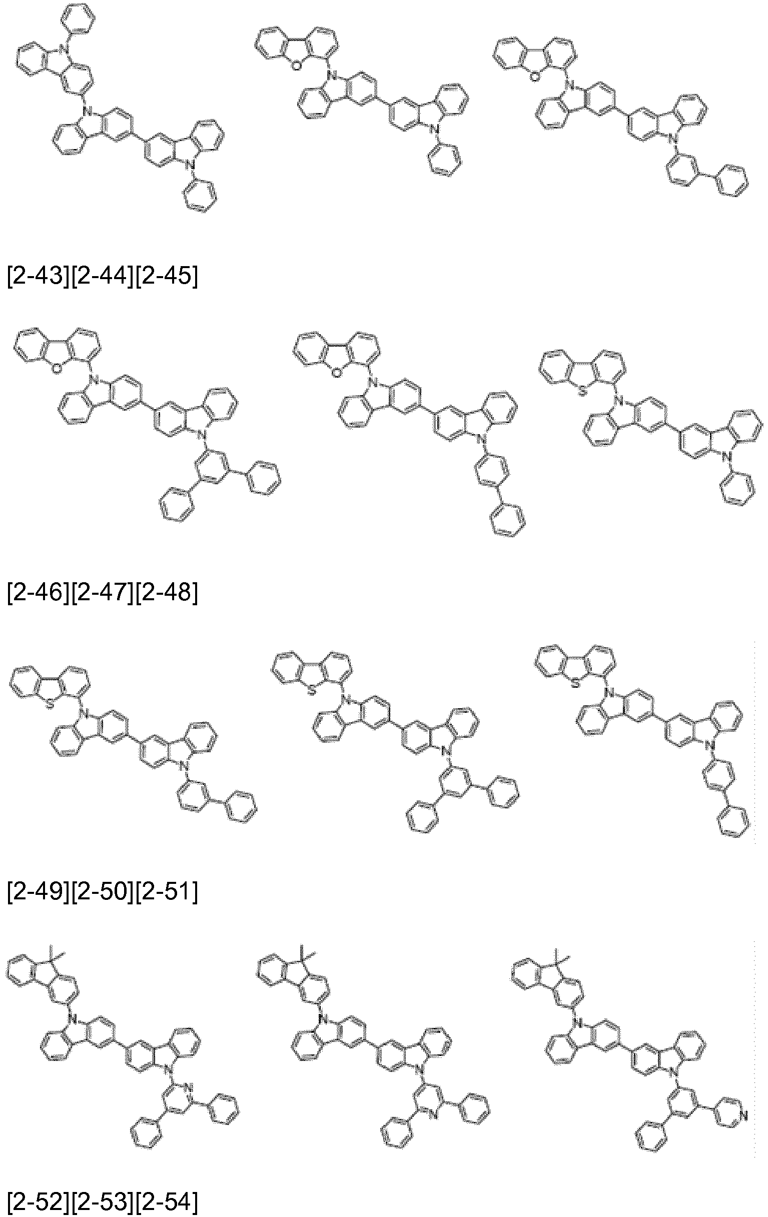

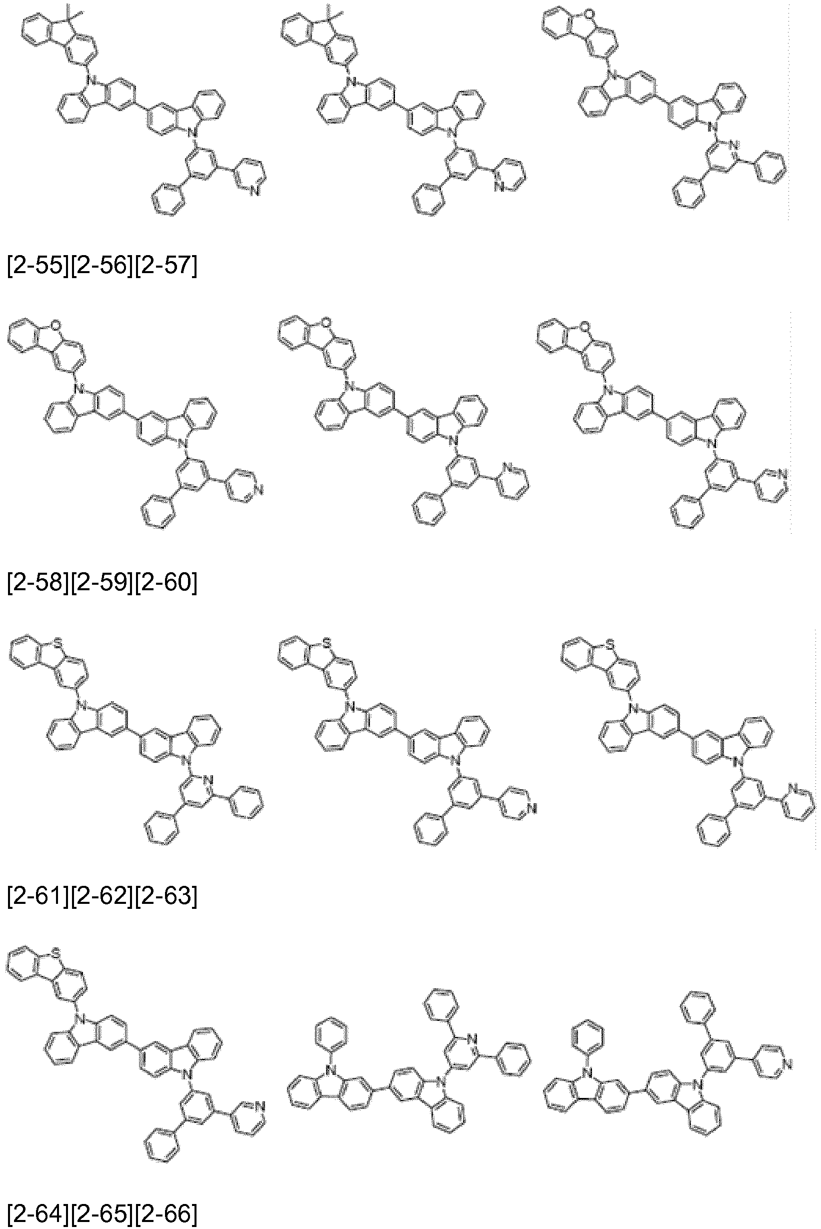

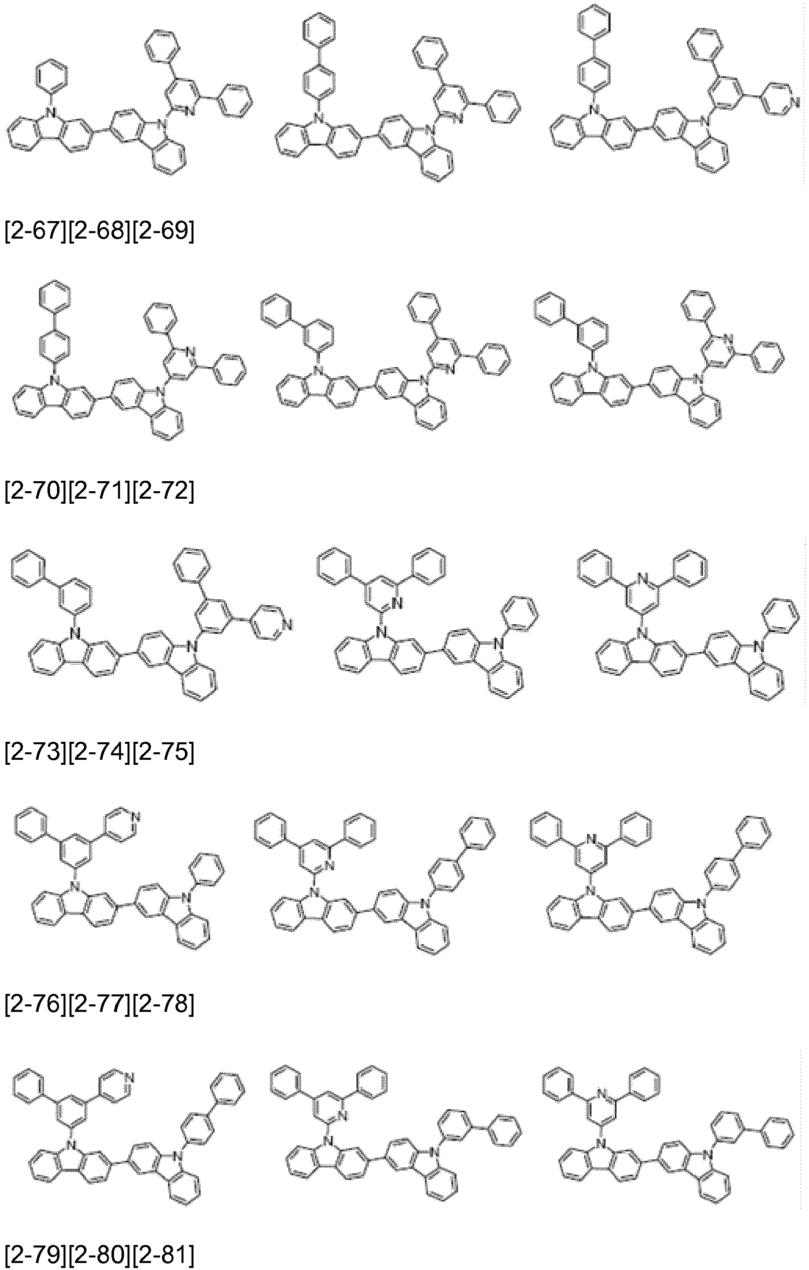

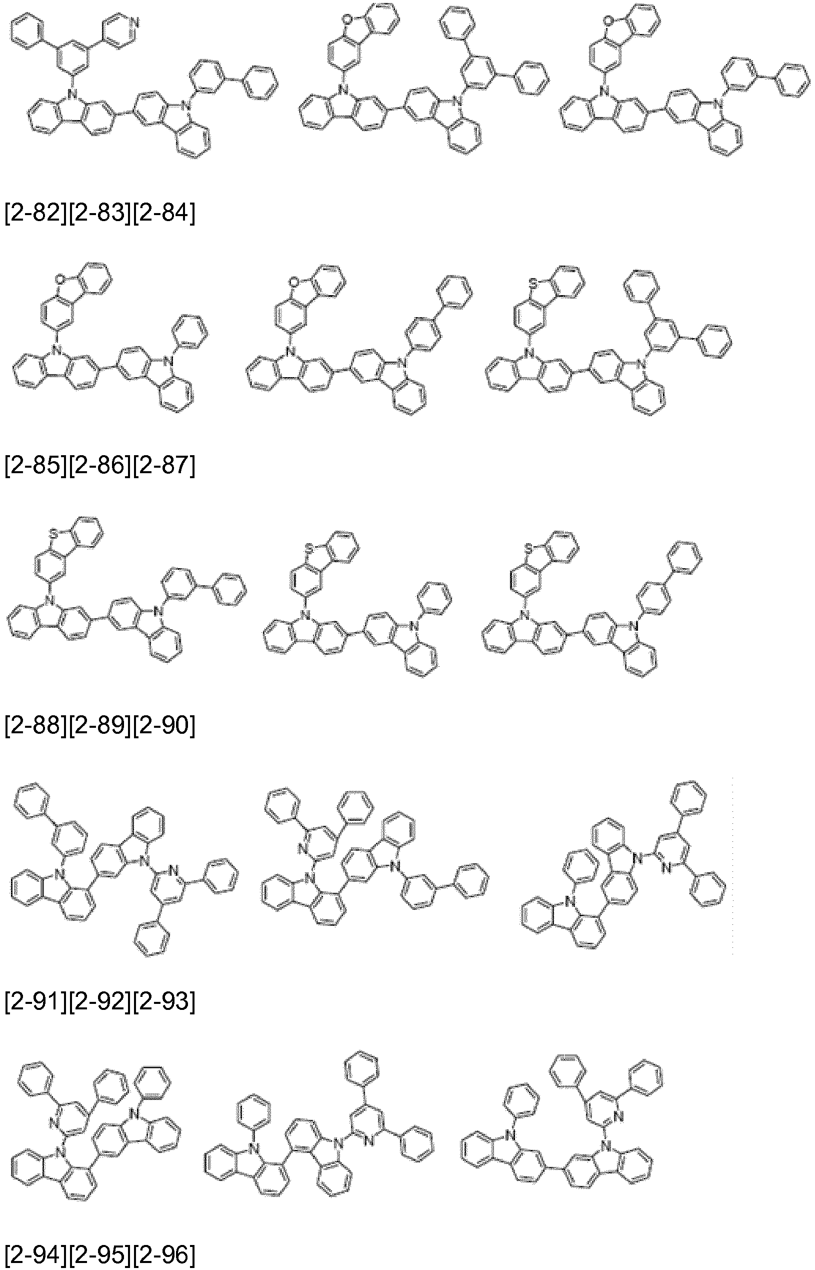

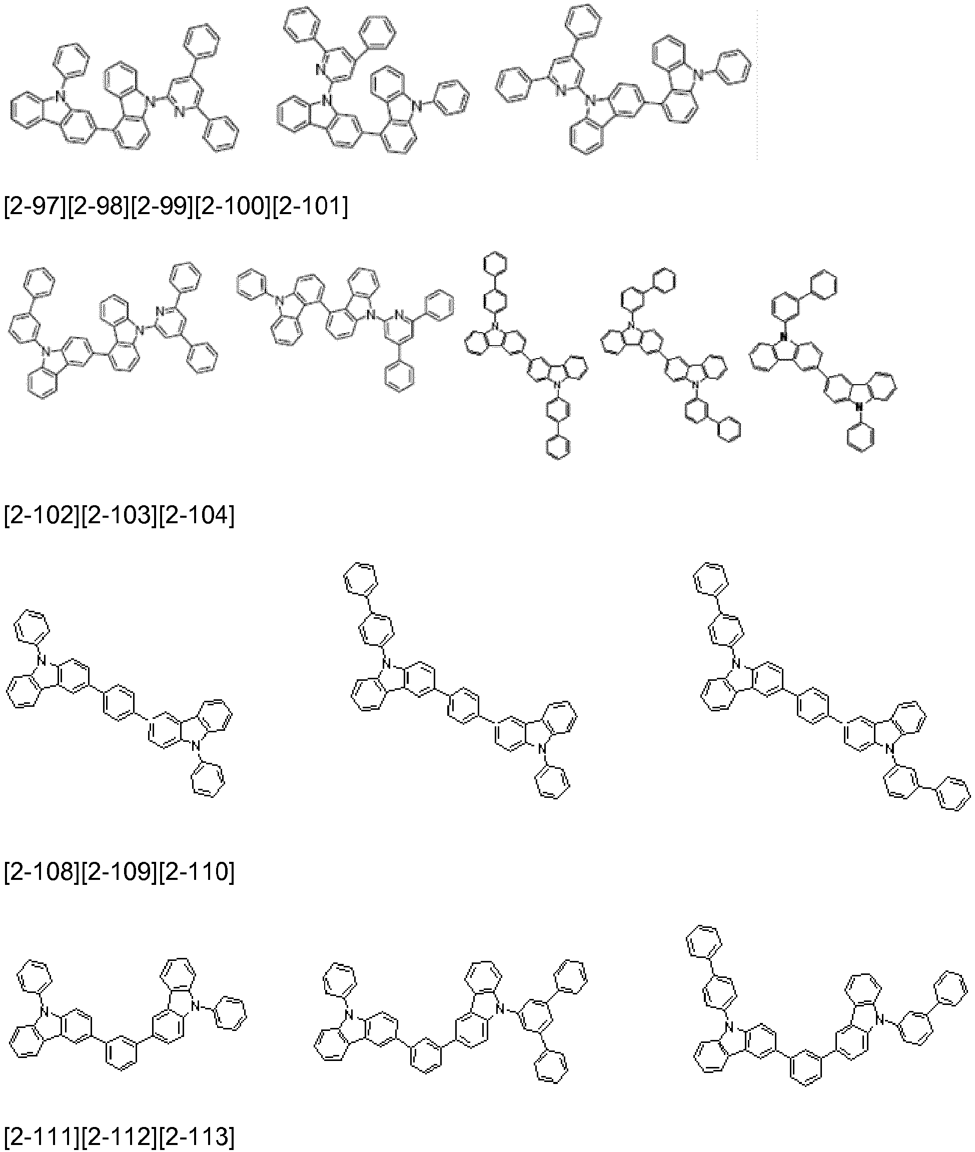

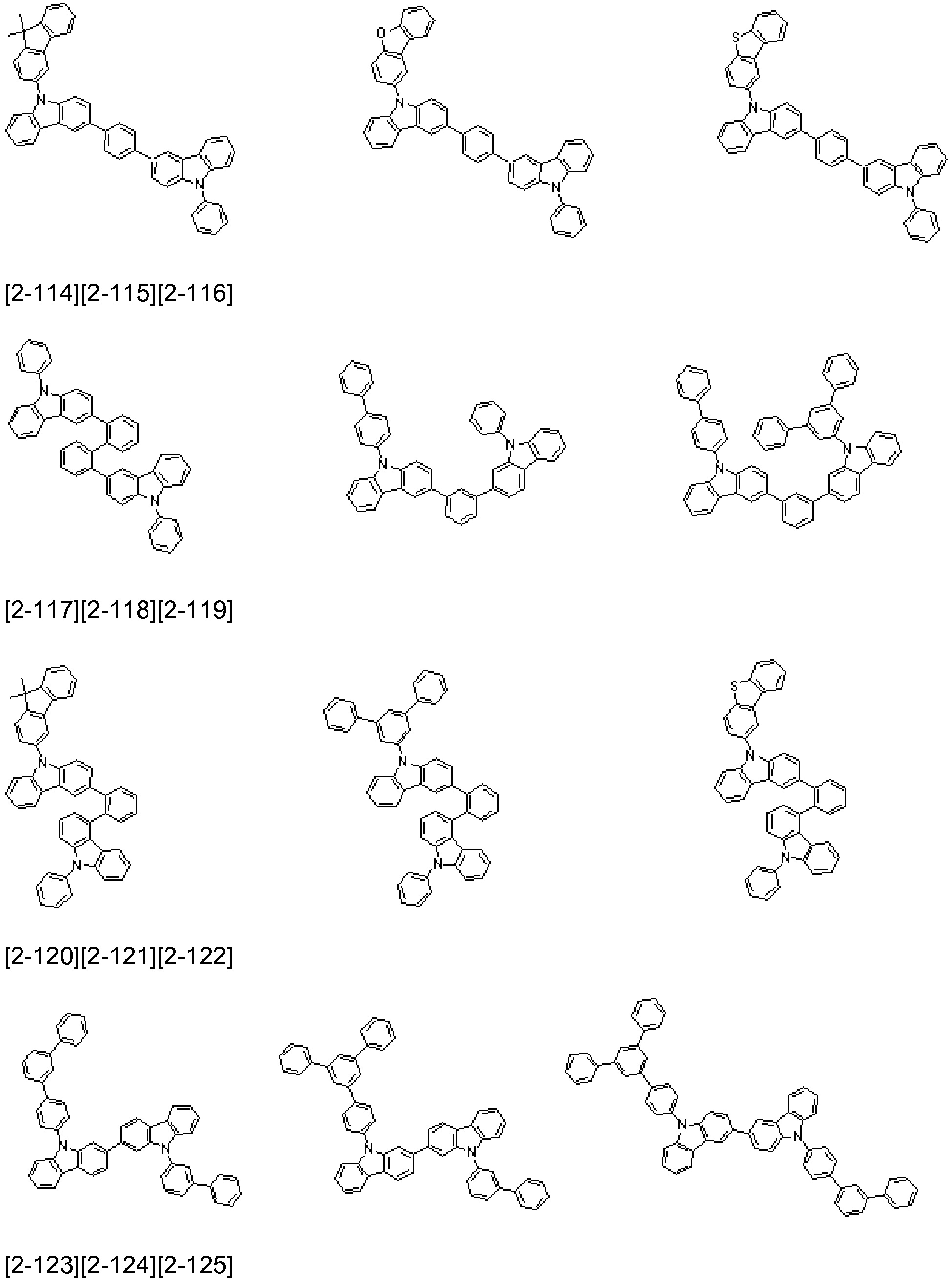

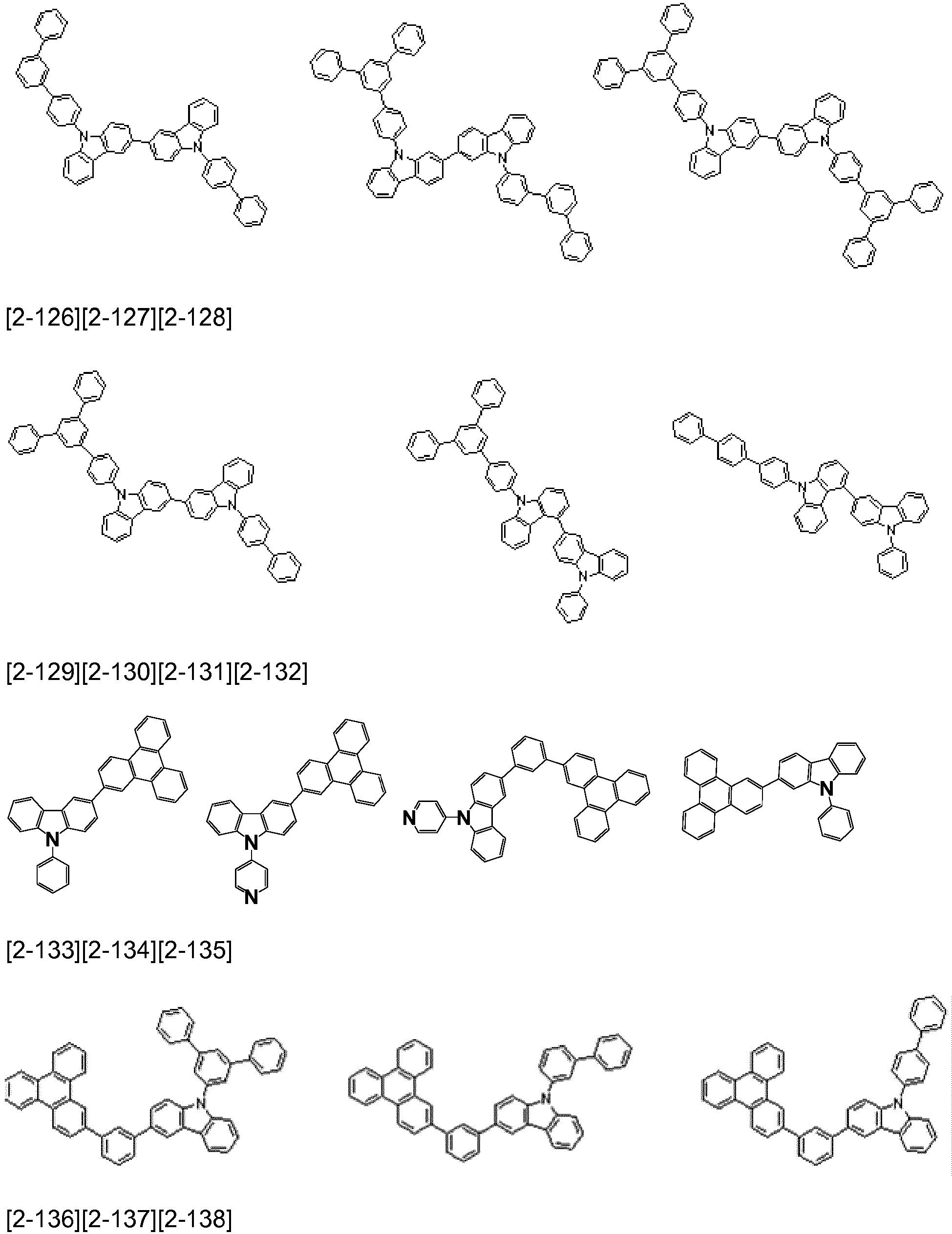

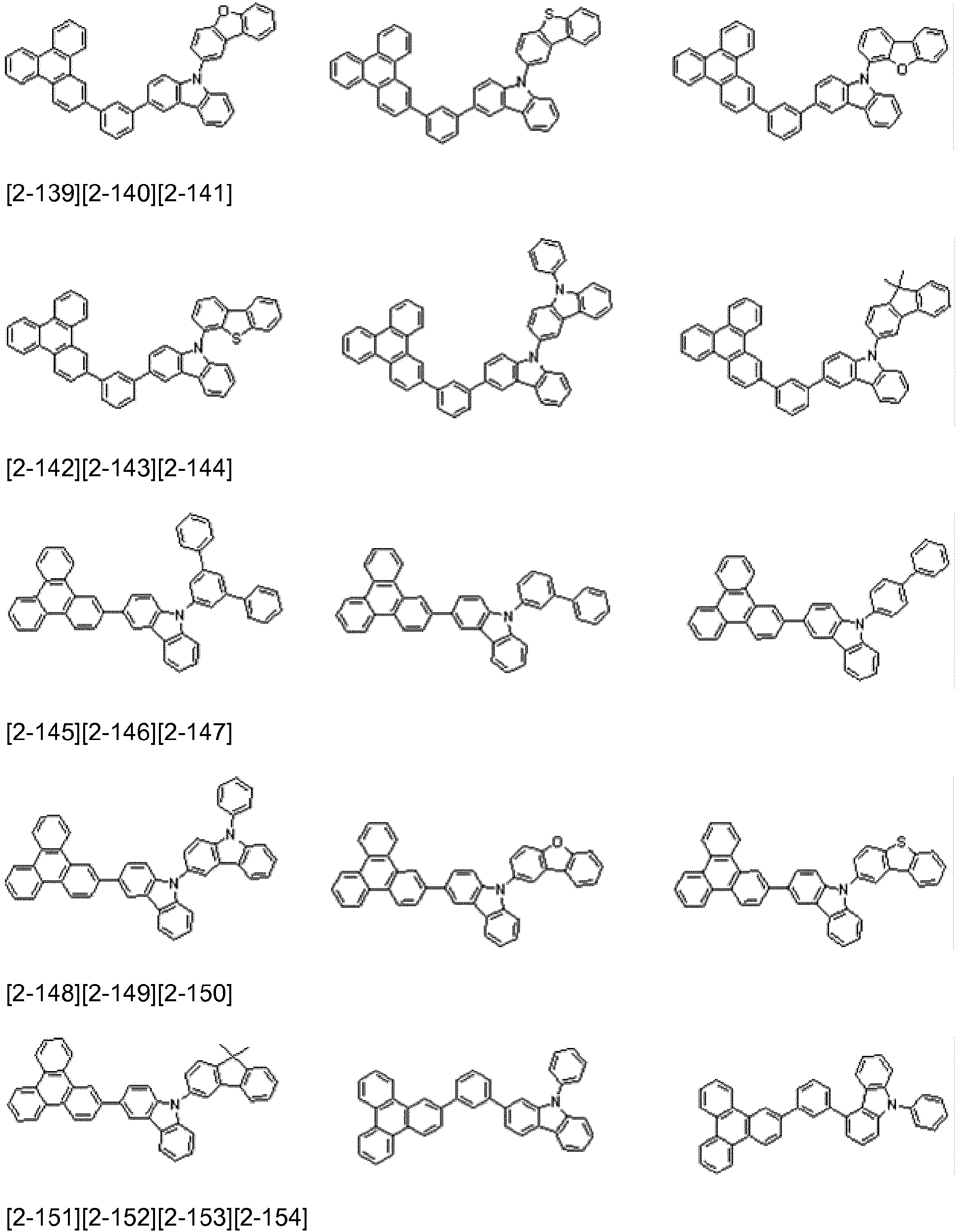

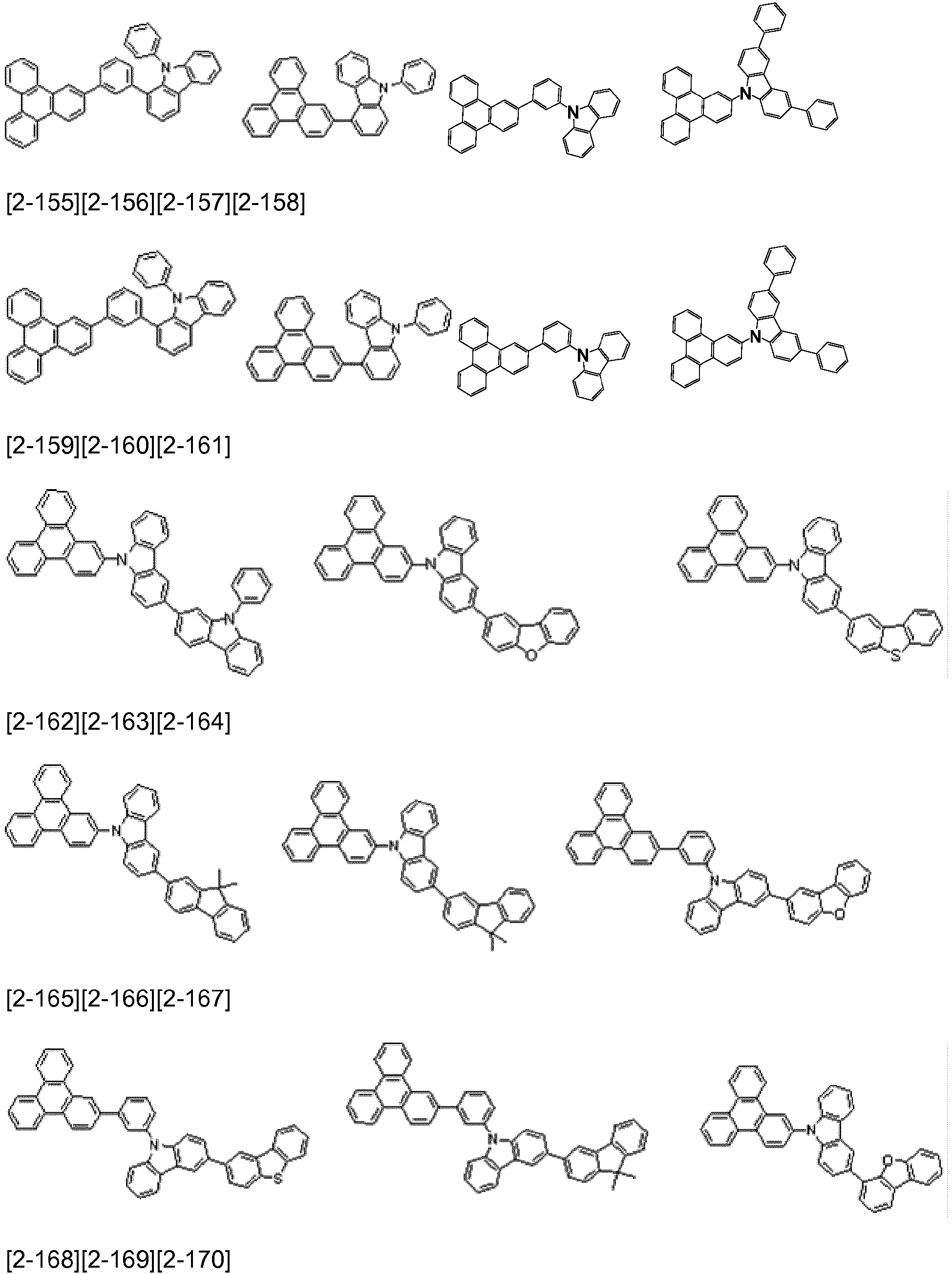

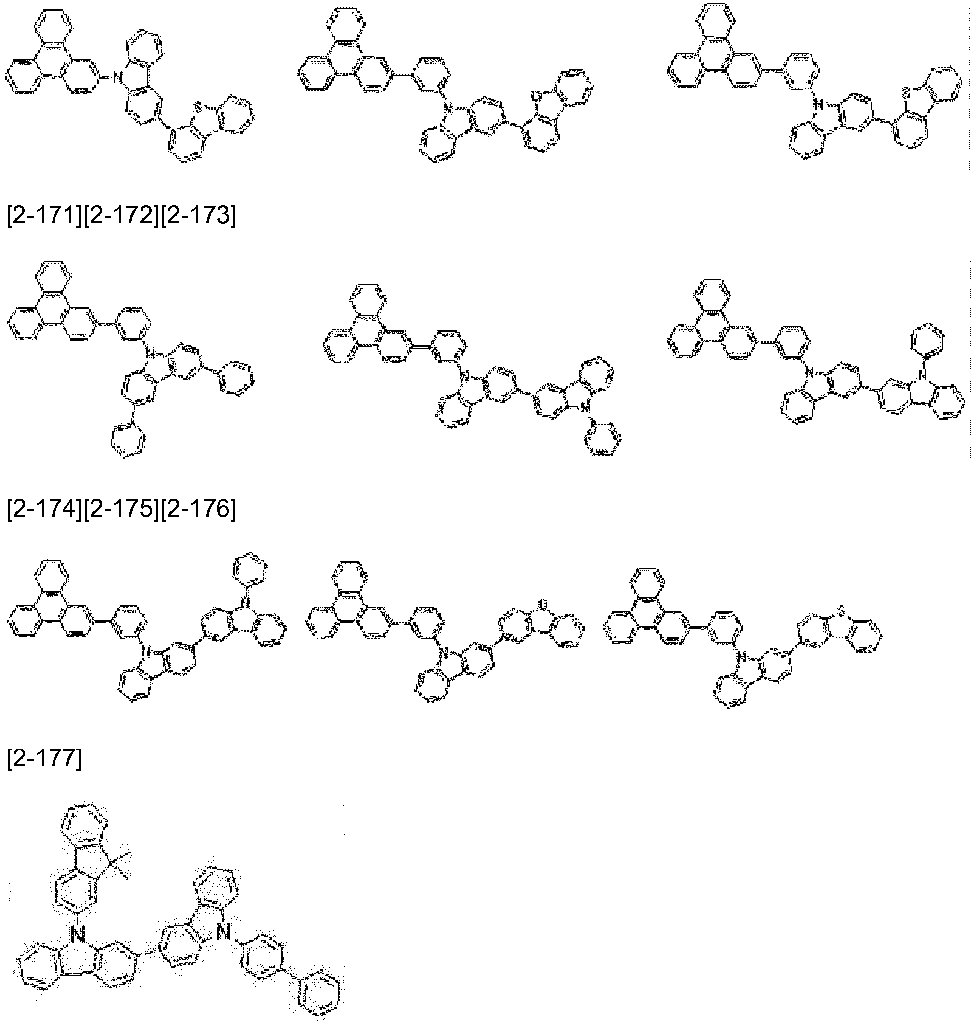

One or more of the second compound may be used.

Specifically, the emission layer 32 may simultaneously include the first compound and the second compound as a host and specifically, at least one from the first compound arranged in the group 4; and at least one from the second compounds represented by Chemical Formulae 4-I to 4-III. More specifically, the first compound represented by Chemical Formula 5c-1 in the group 4 and the second compound represented by Chemical Formula 4-I may be included.

In addition, the first compound and the second compound may be included for example in a weight ratio of about 1:10 to about 10:1, specifically, in a weight ratio of about 2:8 to about 8:2, in a weight ratio of about 3:7 to about 7:3, in a weight ratio of about 4:6 to about 6:4 and in a weight ratio of about 5:5. When included within the range, bipolar characteristics may be further effectively realized, and efficiency and a life-span are simultaneously improved.

The emission layer 32 may further include at least one compound as a host other than the above first compound and the second compound.

The emission layer 32 may further include a dopant. The dopant is a material that is mixed with the host in a small amount to cause light emission, and may be a material such as a metal complex that emits light by multiple excitation into a triplet or more. The dopant may be, for example an inorganic, organic, or organic/inorganic compound, and one or more kinds thereof may be used.

The dopant may be a red, green, or blue dopant, for example a phosphorescent dopant. Examples of the phosphorescent dopant may be an organometal compound including Ir, Pt, Os, Ti, Zr, Hf, Eu, Tb, Tm, Fe, Co, Ni, Ru, Rh, Pd, or a combination thereof. The phosphorescent dopant may be, for example a compound represented by Chemical Formula Z, but is not limited thereto.

[Chemical Formula Z] L₂MX

In Chemical Formula Z, M is a metal, and L and X are the same or different, and are a ligand to form a complex compound with M.

The M may be, for example Ir, Pt, Os, Ti, Zr, Hf, Eu, Tb, Tm, Fe, Co, Ni, Ru, Rh, Pd, or a combination thereof, and the L and X may be, for example a bidendate ligand.

The hole transport auxiliary layer 33 includes a third compound having relatively strong hole characteristics.

The hole transport auxiliary layer 33 includes the above third compound, reduce a HOMO energy level between the hole transport layer (HTL) 31 and the emission layer 32 to adjust hole injection characteristics, suppress accumulation of holes on the interface between the hole transport auxiliary layer 33 and the emission layer 32 and thus, deteriorate a quenching phenomenon that excitons are quenched on the interface by polaron. Accordingly, the device may be less degraded but stabilized and thus, may have improved efficiency and life-span.

The third compound may be a compound represented by Chemical Formula 5.

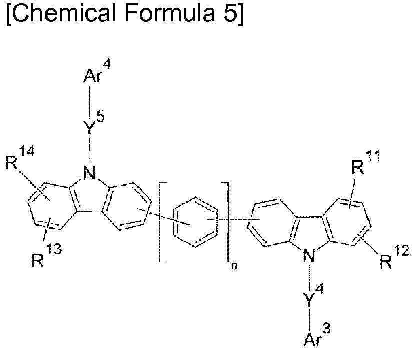

In Chemical Formula 5,
R¹¹ to R¹⁴ are each independently hydrogen, deuterium, a substituted or unsubstituted C1 to C30 alkyl group, a substituted or unsubstituted C6 to C30 aryl group, a substituted or unsubstituted C2 to C30 heteroaryl group, or a combination thereof,
Y⁴ and Y⁵ are each independently a single bond, a substituted or unsubstituted C6 to C30 arylene group, a substituted or unsubstituted C2 to C30 heteroarylene group, or a combination thereof,
Ar³ and Ar⁴ are each independently hydrogen, deuterium, a substituted or unsubstituted C1 to C30 alkyl group, a substituted or unsubstituted C3 to C30 cycloalkyl group, a substituted or unsubstituted C6 to C30 aryl group, a substituted or unsubstituted carbazolyl group, a substituted or unsubstituted dibenzofuranyl group, a substituted or unsubstituted dibenzothiophenyl group, a substituted or unsubstituted C6 to C30 arylamine group, a substituted or unsubstituted C1 to C30 alkoxy group, a substituted or unsubstituted C3 to C40 silyl group, a substituted or unsubstituted C1 to C30 alkylthiol group, a substituted or unsubstituted C6 to C30 arylthiol group, a halogen, a halogen-containing group, a cyano group, a hydroxy group, an amino group, a nitro group, or a combination thereof,
n is an integer ranging from 0 to 4,

The third compound may be represented by one of Chemical Formulae 5-I to 5-VII according to a kind of an intermediate linking group.

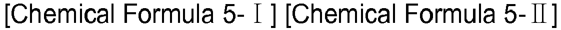

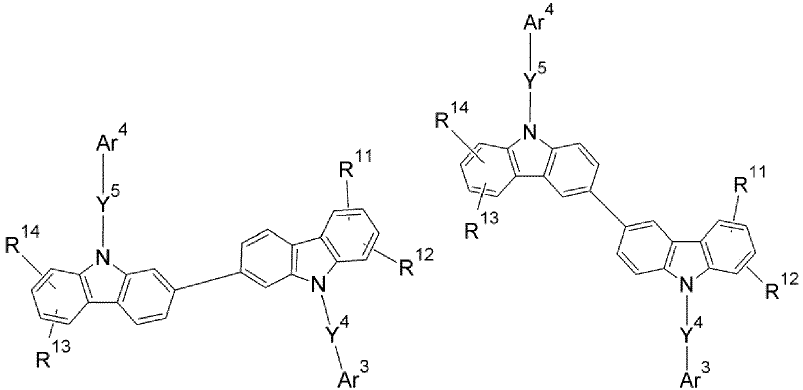

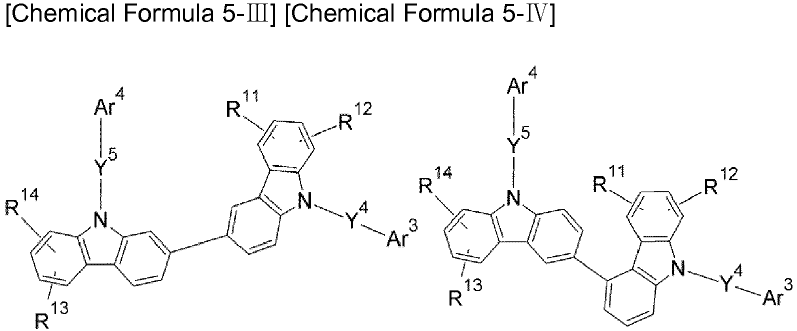

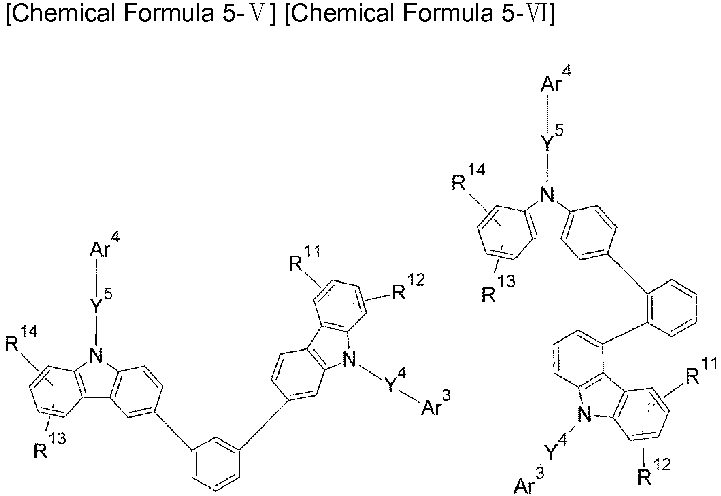

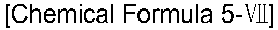

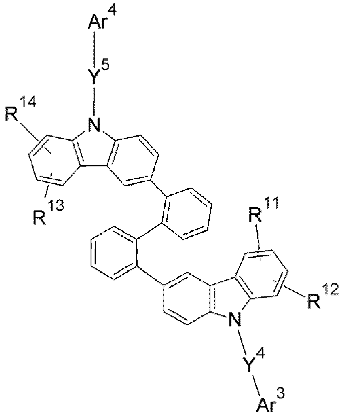

In Chemical Formula 5-I to Chemical Formula 5-VII, R¹¹ to R¹⁴, Y⁴ and Y⁵, Ar³ and Ar⁴ are the same as described above.

The Ar³ and Ar⁴ may be each independently selected from substituted or unsubstituted groups listed in Group 8.

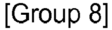

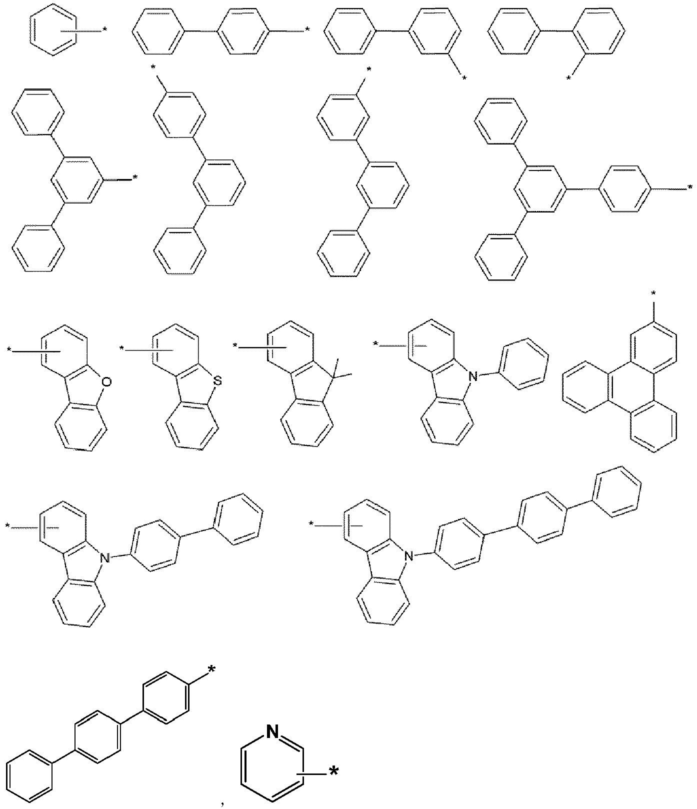

In Group 8, * is a linking point.

The third compound may be, for example one of compounds listed in Group 9, but is not limited thereto.

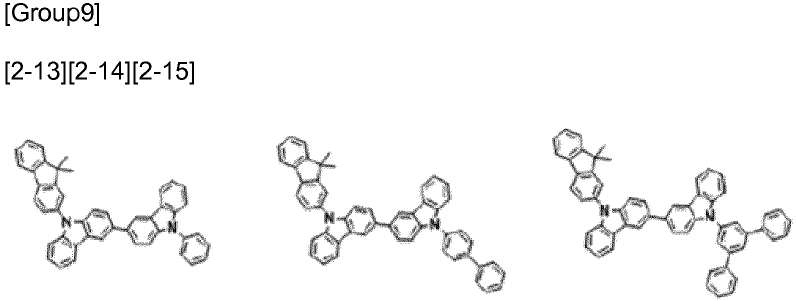

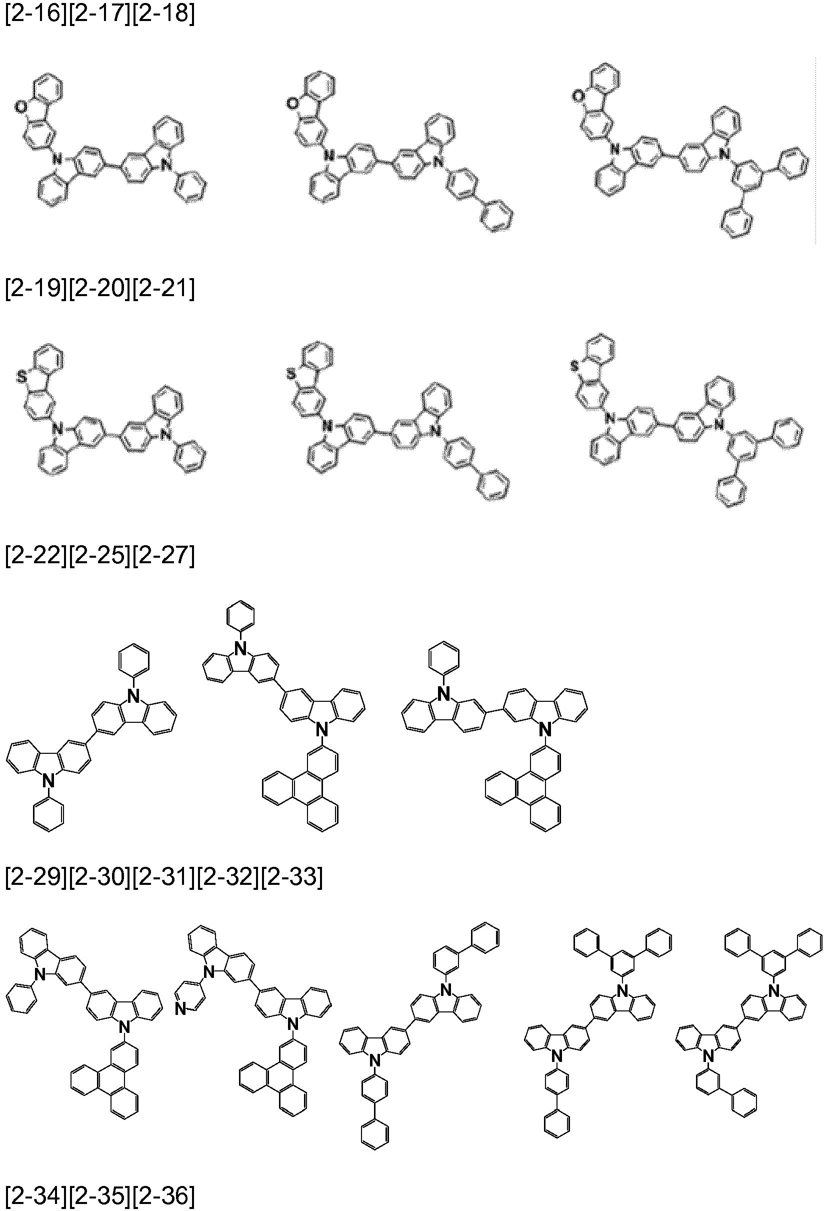

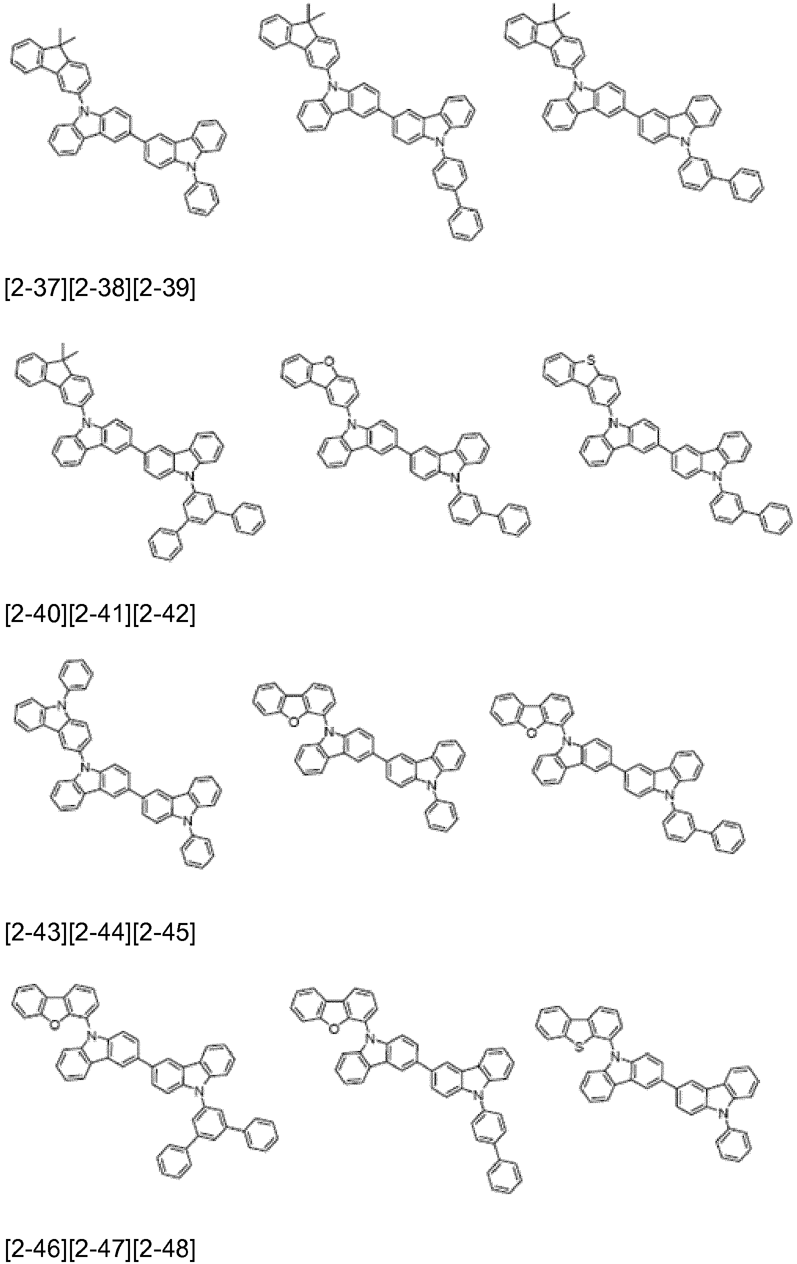

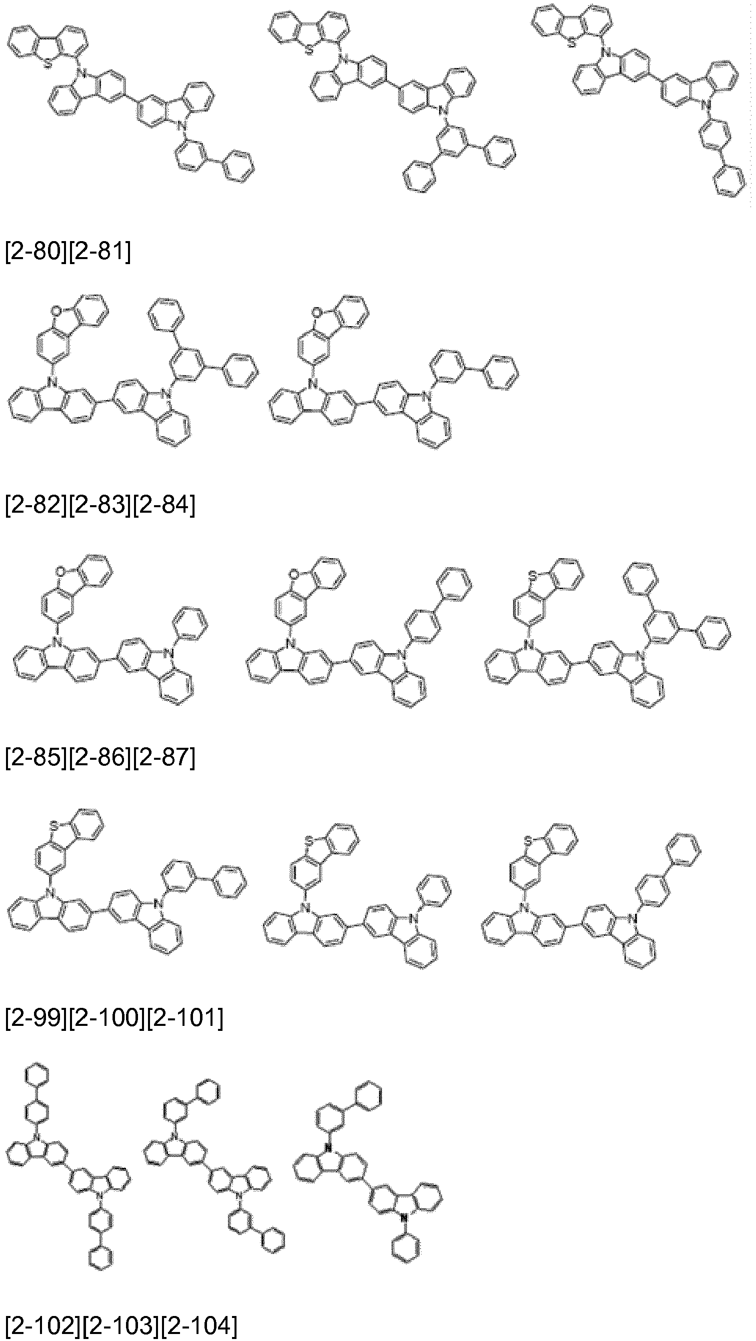

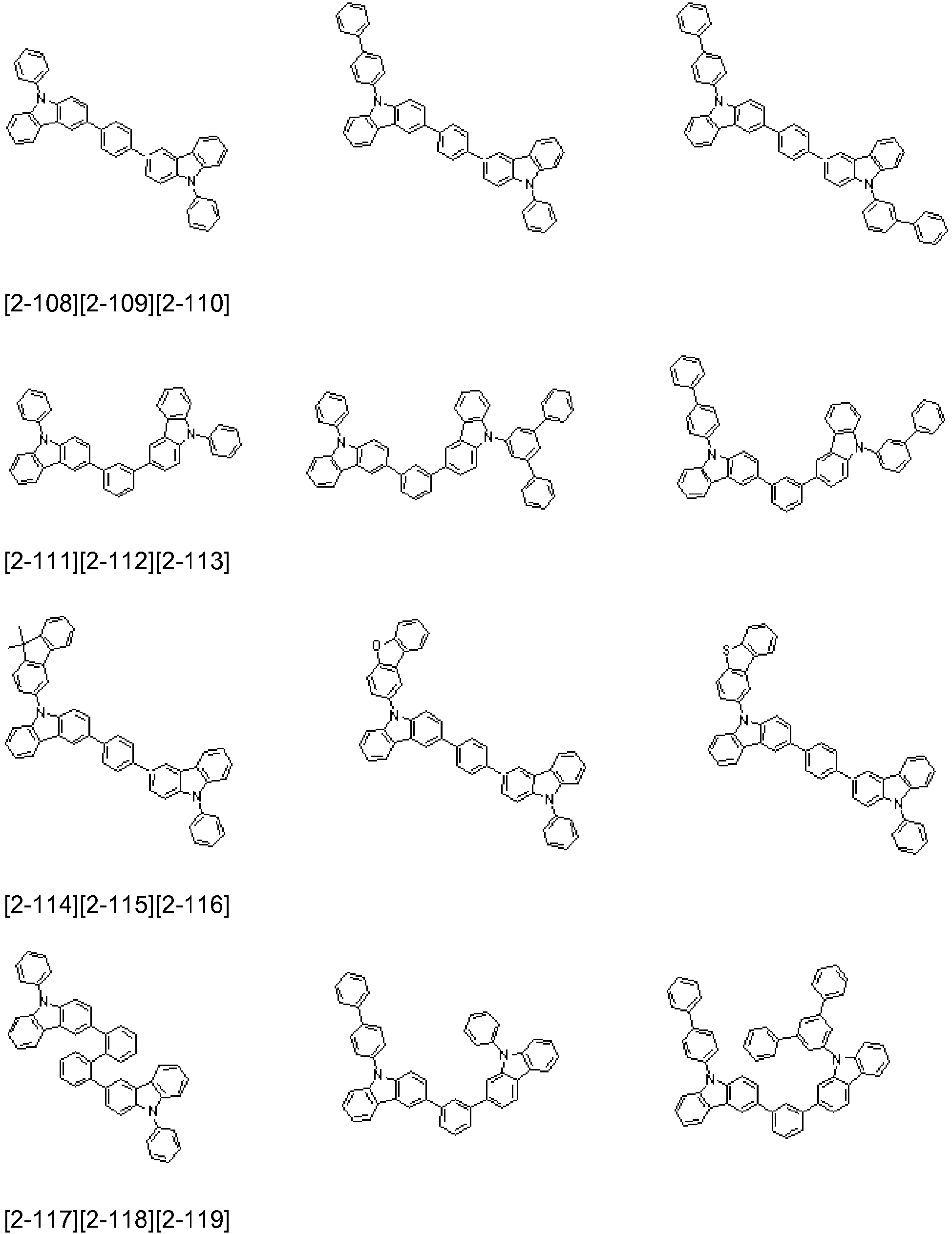

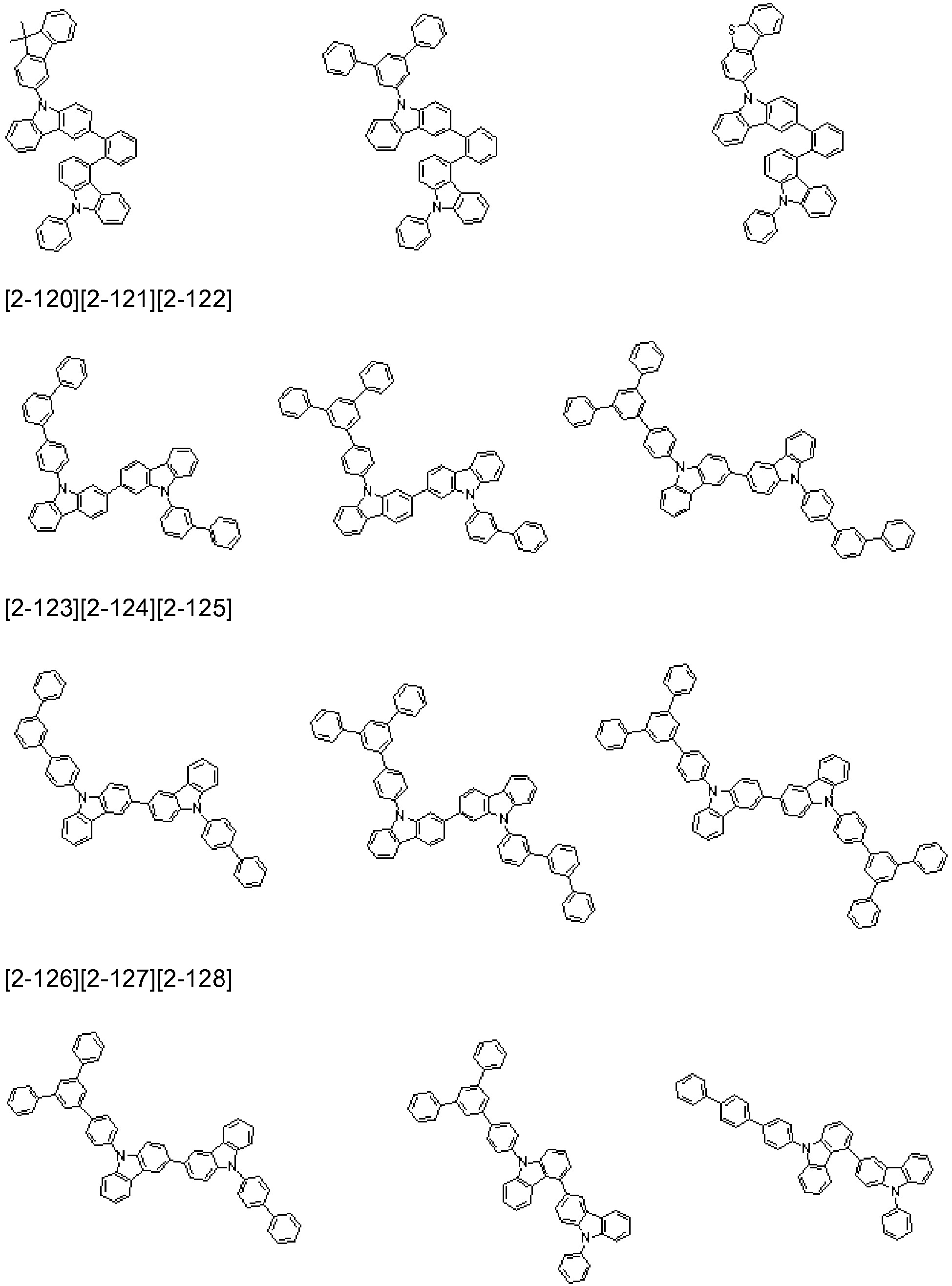

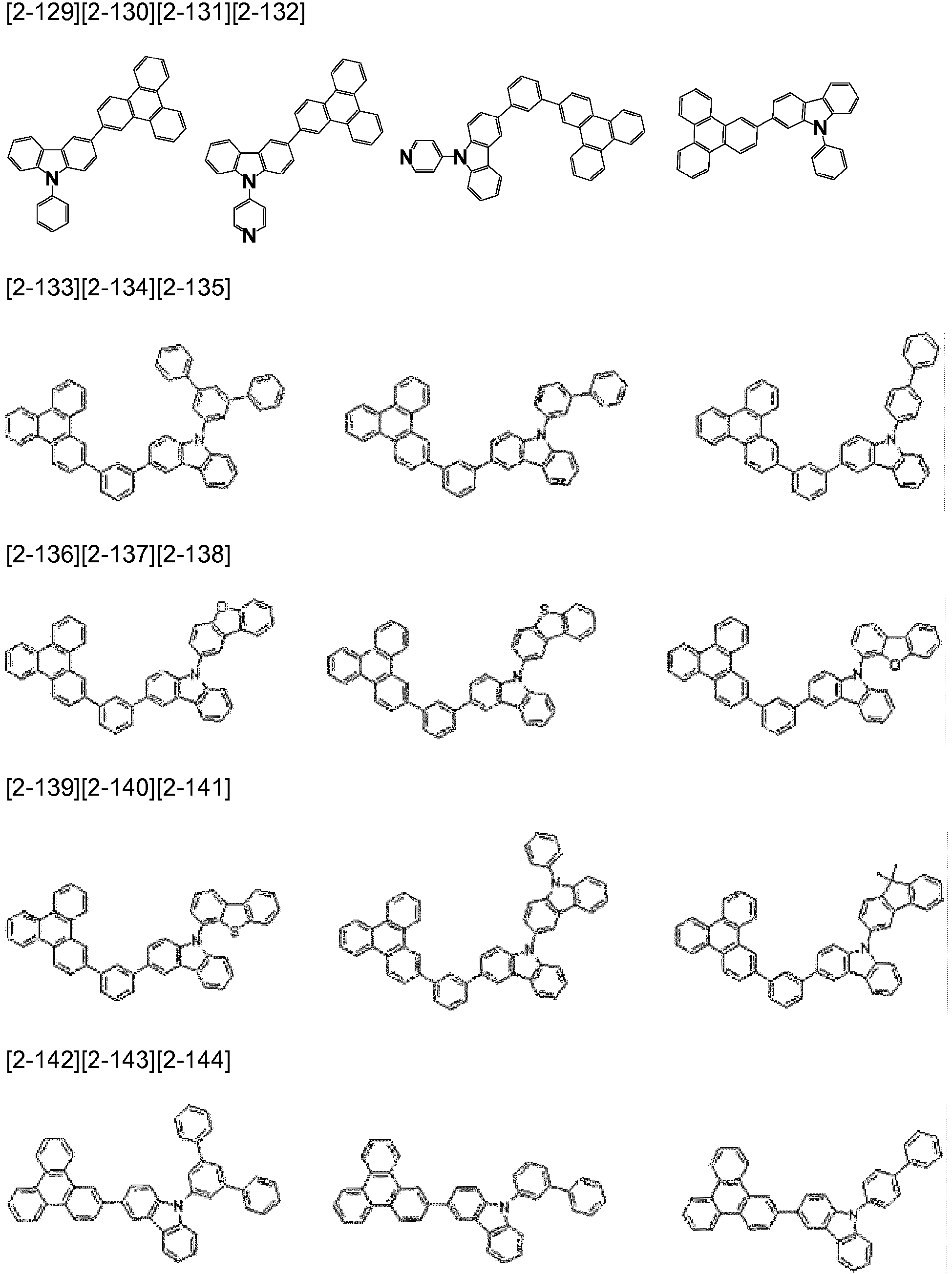

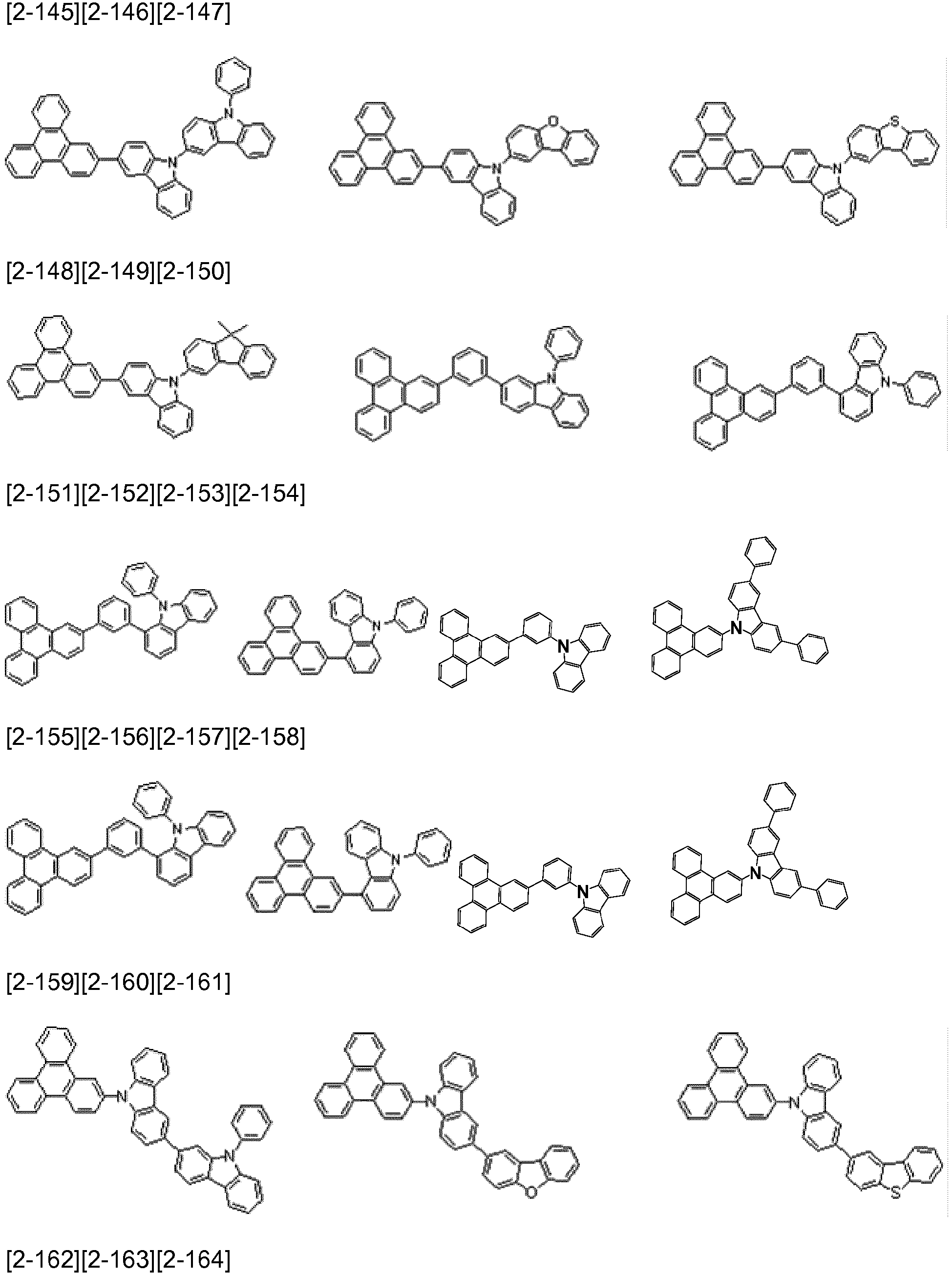

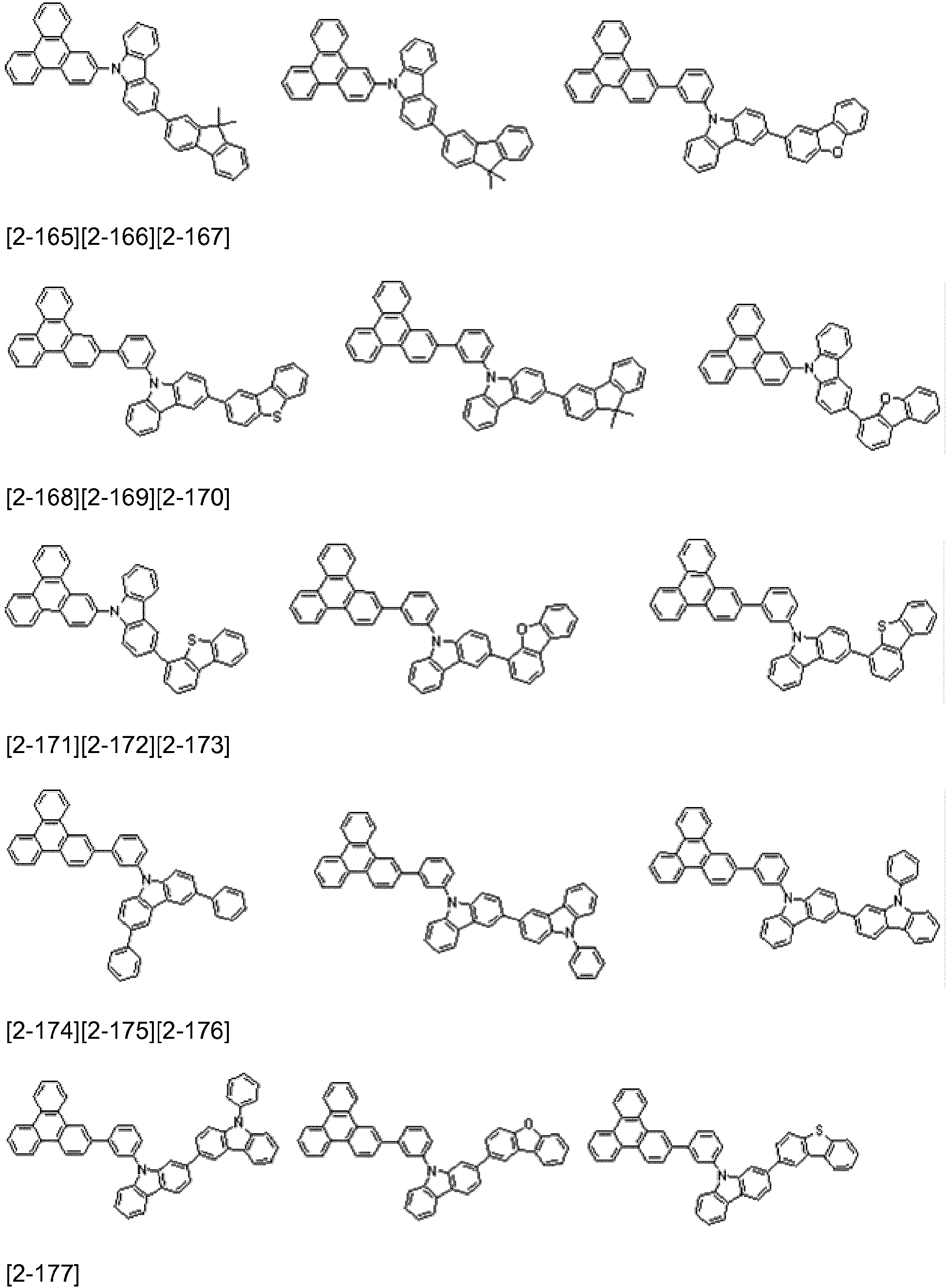

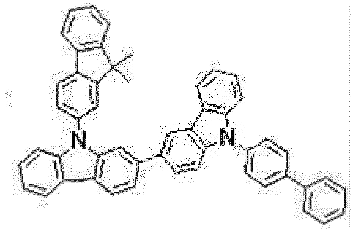

According to one embodiment of the present invention, an organic optoelectric device may simultaneously include an emission layer simultaneously including a first compound having strong electron characteristics and a second compound having strong hole characteristics and
a hole transport auxiliary layer including a third compound having sufficient hole transport and thus capable of adjusting hole injection characteristics by decreasing a HOMO energy level between the hole transport layer (HTL) 31 and the emission layer 32 and strong hole transport characteristics.
These compounds are used together and thus, may reduce accumulation of holes on the interface between the hole transport auxiliary layer 33 and the emission layer 32 and resultantly, a quenching phenomenon that excitons are quenched by polaron. Accordingly, a device may be less degraded and stabilized and thus, improve efficiency and a life-span.

In addition, the hole transport auxiliary layer is positioned between the emission layer and the hole transport layer (HTL) and thus, may adjust a HOMO energy level among the anode 10, the hole transport layer (HTL) 31 and the hole transport auxiliary layer 33 in tiers, efficiently transport holes, and resultantly contributes to improving efficiency and obtaining a long life-span.

Specifically, the emission layer may simultaneously include at least one first compound arranged in the group 4, at least one second compound represented by Chemical Formulas 4-I and 4-II, and one third compound represented by Chemical Formulae 5-II, 5-III and 5-V.

The hole transport auxiliary layer 35 may be coated to be about 0.1 nm to about 20.0 nm in a deposit or inkjet process on the hole transport layer (HTL), for example, about 0.2 nm to about 10.0 nm, about 0.3 nm to about 5 nm, about 0.3 nm to about 2 nm, and about 0.4 nm to about 1.0 nm.

The organic layer 30 may further include an electron transport layer 34. The electron transport layer 34 makes electron transfer from the cathode 20 to the emission layer 32 easy, and may be omitted as needed.

The organic layer 30 may optionally further include a hole injection layer (not shown) between the anode 10 and the hole transport layer 31 and/or an electron injection layer (not shown) between the cathode 20 and the electron transport layer 34.

The organic light emitting diode may be applied to an organic light emitting diode (OLED) display.

Hereinafter, the embodiments are illustrated in more detail with reference to examples. These examples, however, are not in any sense to be interpreted as limiting the scope of the invention.

Hereinafter, starting materials and reaction materials used in Examples and Synthesis Examples were purchased from Sigma-Aldrich Co. Ltd. or TCI Inc. or were easily synthesized using known methods unless there was particularly mentioned.

### Synthesis of First Compound

### Synthesis Example 1: Synthesis of Compound 1-121

A compound 1-121 as specific examples of a first compound represented by the following Reaction Scheme 1 may be synthesized through two steps.

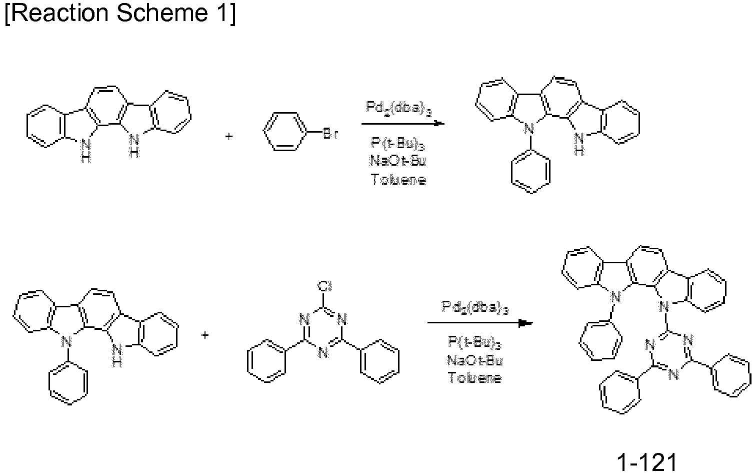

### First Step: Synthesis of 11-phenyl-11,12-dihydroindolo[2,3-a]carbazole

78.35 g (305.69 mmol) of 11,12-dihydroindolo[2,3-a]carbazole, 26.8 mL (254.74 mmol) of bromobenzene, 26.93 g (280.22 mmol) of NaOt-Bu and 7 g (7.64 mmmol) of Pd₂(dba)₃ were suspended in 1400 ml of toluene, 3.64 ml (15.28 mmol) of P(t-Bu)₃ was added thereto, and the mixture was refluxed and agitated for 12 hours. Then, distilled water was added thereto to perform extraction, and an organic layer formed therein was silica gel filtered. After removing an organic solution therefrom, a solid produced therein was recrystallized with dichloromethane and normal hexane, obtaining 46.2 g of 11-phenyl-11,12-dihydroindolo[2,3-a]carbazole (a yield : 55 %, LC Mass M+H⁺ = 333.13).

### Second Step: Synthesis of Compound 1-121

46.2 g (138.99 mmol) of 11-phenyl-11,12-dihydroindolo[2,3-a]carbazole, 37.2 g (138.99 mmol) of 2-chloro-4,6-diphenyl-1,3,5-triazine, 16.03 g (166.79 mmol) of NaOt-Bu and 7.63 g (8.34 mmmol) of Pd₂(dba)₃ were suspended in 500 ml of toluene, 12.2 ml (25.02 mmol) of P(t-Bu)₃ was added thereto, and the mixture was refluxed and agitated for 12 hours. Subsequently, distilled water was added thereto for extraction, and the obtained organic layer was silica gel-filtered. After removing an organic solution therefrom, a solid obtained therefrom was dissolved in a small amount of dichloromethane, the solution was dropped into methanol to obtain a precipitate, and the precipitate was recrystallized with dichloromethane and n-hxexane, obtaining 27.5 g of a compound 1-121 (a yield: 35 %, LC Mass M+H⁺ = 564.22).

### Synthesis Examples 2 to 6: Synthesis of Compound

A compound was synthesized according to the same method as Synthesis Example 1 except for using two starting materials provided in the following Table 1 instead of the starting material (corresponding to the starting material 1 the following Table 1) and the 2-chloro-4,6-diphenyl-1,3,5-triazine (corresponding to the starting material 2 in the following Table 1).

**[Table 1]**

| Synthesis Example | Starting material 1 | Starting material 2 | Product | Yield (%) LC-Mass (M+H⁺) |
|---|---|---|---|---|
| 2 | 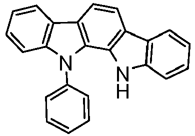 | 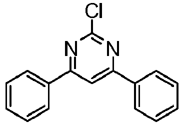 | 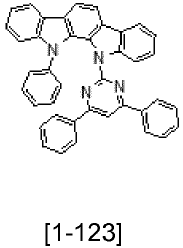 | 52 % |
| | | | | 563.22 |
| 3 | 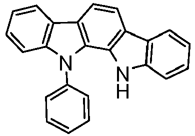 | 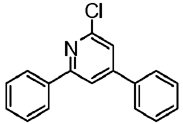 | 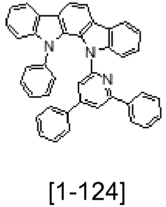 | 48 % |
| | | | | 562.23 |
| 4 | 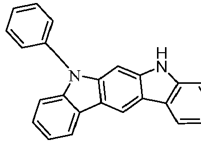 | 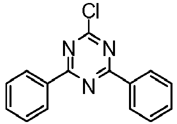 | 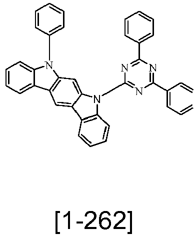 | 65 % |
| | | | | 564.21 |
| 5 | 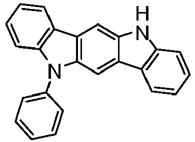 | 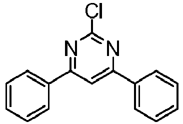 | 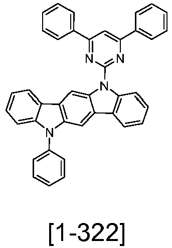 | 61 % |
| | | | | 563.22 |
| 6 | 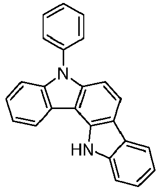 | 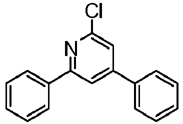 | 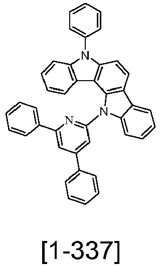 | 59 % |
| | | | | 562.22 |

### Synthesis of Second Compound

### Synthesis Example 7: Synthesis of Compound 2-132

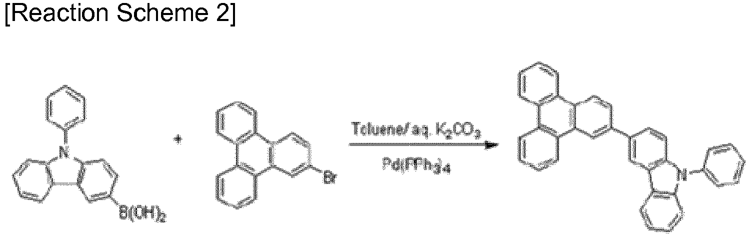

10 g (34.83 mmol) of the compound, phenylcarbazolyl boronic acid was dissolved in 0.2 L of toluene under a nitrogen environment, 11.77 g (38.31 mmol) of 2-bromotriphenylene and 0.80 g (0.7 mmmol) of tetrakis(triphenylphosphine)palladium were added thereto, and the mixture was agitated. Then, 14.44 g 104.49 mmol) of potassium carbonate saturated in water was heated and refluxed at 120 ° C for 12 hours. When the reaction was complete, water was added to the reaction solution, the mixture was extracted with dichloromethane (DCM) and then, filtered after removing anhydrous MgSO₄ therefrom and concentrated under a reduced pressure. The obtained residue was separated and purified through flash column chromatography, obtaining the compound 2-132 (14.4 g, 88 %).
HRMS (70 eV, El+): m/z calcd for C36H23N: 469.18, found: 469
Elemental Analysis: C, 92 %; H, 5 %

### Synthesis Example8: Synthesis of Compound 2-1

The synthesis was performed in the following Reaction Scheme 3.

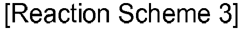

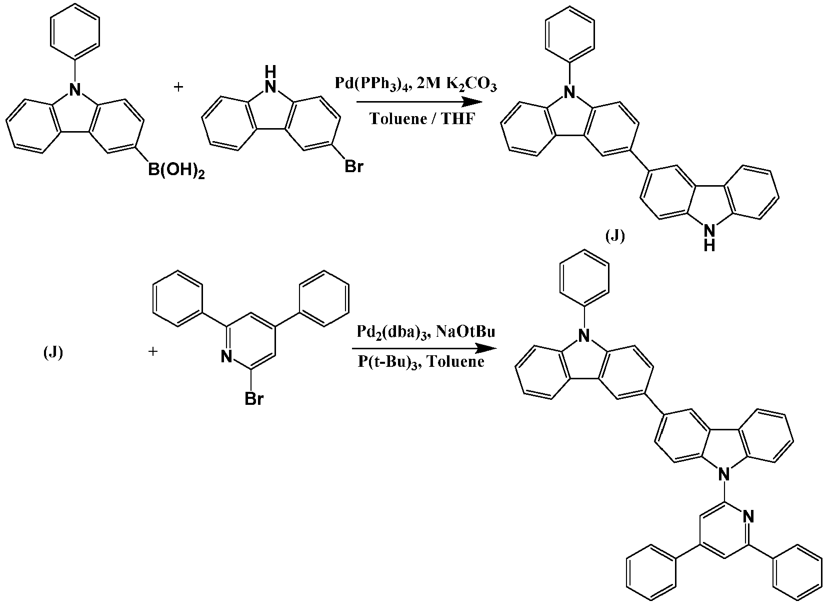

### First Step: Synthesis of Compound J

10 g (34.83 mmol) of 9-phenyl-9H-carbazol-3-yl boronic acid (-TCI), 11.77 g (38.31 mmol) of 3-bromocarbazole (Sigma-Aldrich Co., Ltd.), 14.44 g (104.49 mmol) of potassium carbonate, and 0.80 g (0.7 mmmol) of tetrakis-(triphenylphosphine)palladium (0) were suspended in 140 ml of toluene and 50 ml of distilled water, and the suspended solution was refluxed and agitated for 12 hours. Subsequently, the resultant was extracted with dichloromethane and distilled water, and an organic layer therein was silica gel-filtered. After completing the reaction, a solid produced by pouring methanol to the reactant was filtered and dissolved again in chlorobenzene, activated carbon and anhydrous magnesium sulfate were added thereto, and the mixture was agitated. The solution was filtered and recrystallized by using chlorobenzene and methanol, obtaining, 22.6 g (68 %) of a compound J.
HRMS (70 eV, El+): m/z calcd for C30H20N2:408.16, found: 408
Elemental Analysis: C, 88 %; H, 5 %

### Second Step: Synthesis of Compound 2-1

22.42 g (54.88 mmol) of the compound J, 20.43 g (65.85 mmol) of 2-bromo-4,6-diphenylpyridine (the compound B), and 7.92 g (82.32 mmol) of tertiarybutoxysodium were dissolved in 400 ml of toluene, and 1.65 g (1.65 mmol) of palladium dibenzylideneamine and1.78 g (4.39 mmol) of tertiarybutyl were added thereto in a dropwise fashion. The reaction solution was heated and agitated at 110° C under a nitrogen stream for 12 hours. When the reaction was complete, a solid produced by pouring methanol to the reactant was filtered and dissolved again in chlorobenzene, activated carbon and anhydrous magnesium sulfate were added thereto, and the mixture was agitated. The solution was filtered and recrystallized by using chlorobenzene and methanol, obtaining 28.10 g (80 %) of a compound 2-1.
HRMS (70 eV, El+): m/z calcd for C47H31 N3:637.25, found: 637
Elemental Analysis: C, 89 %; H, 5 %

### Synthesis Example 9: Synthesis of Compound 2-22

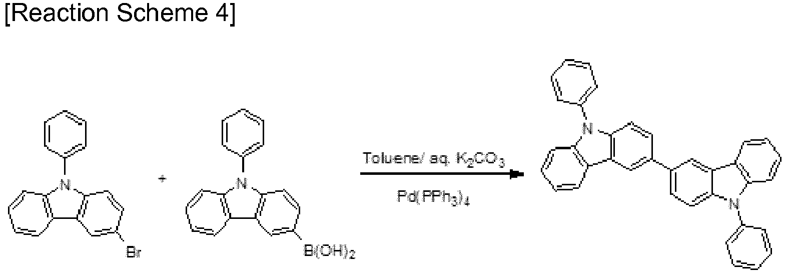

9.78 g (34.05 mmol) of 9-phenyl-9H-carbazol-3-yl boronic acid (-TCI), 9.97 g (30.95 mmol) of 3-bromo-9-phenylcarbazole (Sigma-Aldrich Co., Ltd.), and 12.83 g (92.86 mmol) of potassium carbonate, and 1.07 g (0.93 mmmol) of tetrakis-(triphenylphosphine)palladium (0) were suspended in 120 ml of toluene and 50 ml of distilled water and then, refluxed and agitated for 12 hours. Subsequently, the resultant was extracted with dichloromethane and distilled water, and an organic layer produced therein was silica gel-filtered. Subsequently, a solid obtained through silica gel column with hexane:dichloromethane = 7:3(v/v) after removing an organic solution therefrom was recrystallized with dichloromethane and n-hexane, obtaining 13.8 g (92 %) of a compound 2-22.
HRMS (70 eV, El+): m/z calcd for C36H24N2:484.19, found: 484
Elemental Analysis: C, 89 %; H, 5 %
LC Mass M+H⁺ = 485.20

### Synthesis Example 10: Synthesis of Compound 2-25

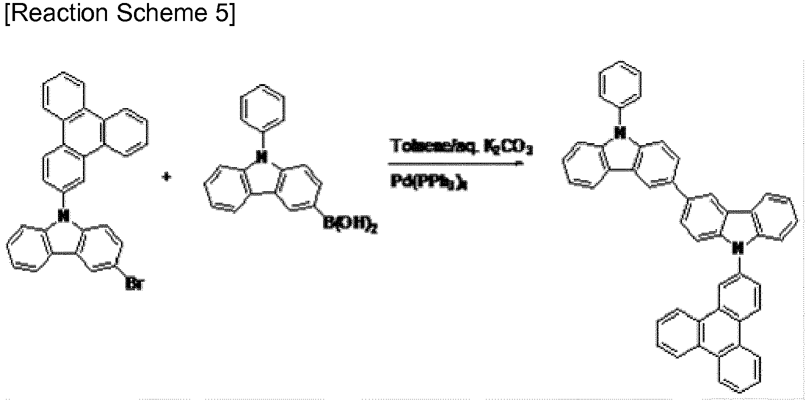

14.62 g (30.95 mmol) of the compound triphenylcarbazolyl bromide was dissolved in 0.2 L of Toluene under a nitrogen environment, 9.78 g (34.05 mmol) of phenylcarbazolylboronic acid, 1.07 g (0.93 mmmol) of tetrakis(triphenylphosphine)palladium were added thereto, and the mixture was agitated. Then, 12.83 g (92.86 mmol) of potassium carbonate saturated in water was heated and refluxed at 120 ° C for 12 hours. When the reaction was complete, water was added to the reaction solution, and the mixture was extracted with dichloromethane (DCM) an then, filtered after removing moisture with anhydrous MgSO₄ therefrom and concentrated under a reduced pressure. Then, a residue obtained therefrom was separated and purified through flash column chromatography, obtaining 16.7 g (85 %) of the compound 2-25.
HRMS (70 eV, El+): m/z calcd for C47H29N2: 621.23, found: 621
Elemental Analysis: C, 91 %; H, 5 %

### Synthesis Example 11: Synthesis of Compound 2-31

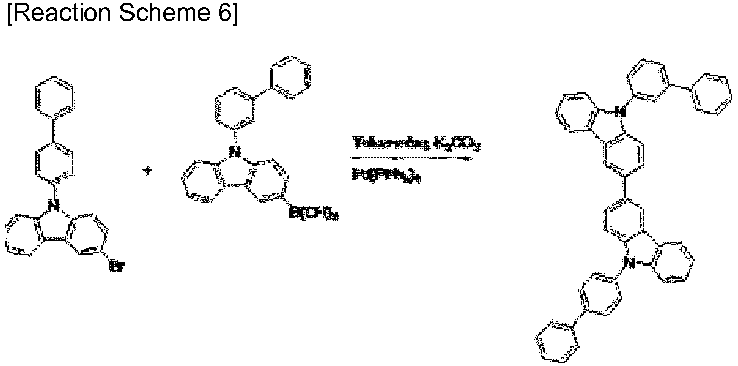

12.33 g (30.95 mmol) of the compound, Biphenylcarbazolyl bromide was dissolved in 0.2 L of Toluene under a nitrogen environment, 12.37 g (34.05 mmol) of biphenylcarbazolylboronic acid and 1.07 g (0.93 mmmol) of tetrakis(triphenylphosphine)palladium were added thereto, and the mixture was agitated. Then, 12.83 g (92.86 mmol) of potassium carbonate was added thereto, and the obtained mixture was heated and refluxed at 120 ° C for 12 hours. When the reaction was complete, water was added to the reaction solution, and the mixture was extracted with dichloromethane (DCM) and filtered after removing moisture with anhydrous MgSO₄ therefrom and concentrated under a reduced pressure. The obtained residue was separated and purified through flash column chromatography, obtaining 18.7 g (92 %) of a compound 2-31.
HRMS (70 eV, El+): m/z calcd for C48H32N2: 636.26, found: 636
Elemental Analysis: C, 91 %; H, 5 %

### Synthesis Example 12: Synthesis of Compound 2-19

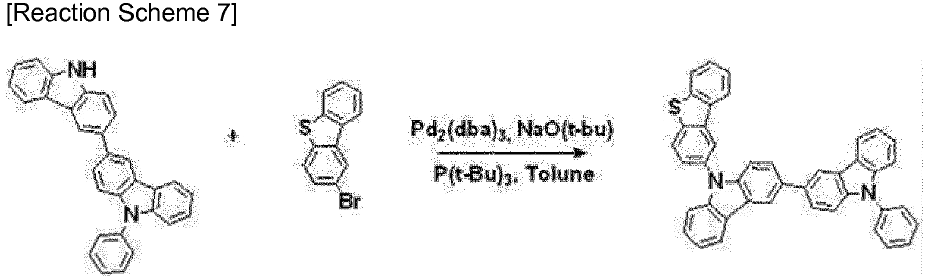

10.0 g (24.48 mmol) of the intermediate product J according to Synthesis Example 8, 6.76 g (25.7 mmol) of 2-bromo dibenzothiophene, 2.59 g (26.93 mmol) of NaO(t-Bu), and 0.224 g (0.24 mmmol) of Pd₂(dba)₃ were suspended in 100 ml of toluene, 0.15 mL (0.73 mmol) of tri-tertiary-butylphosphine was added thereto, and the mixture was refluxed and agitated for 12 hours.

When the reaction was complete, the resultant was extracted with toluene and distilled water, and an organic layer was dried with magnesium sulfate and filtered and then, concentrated under a reduced pressure. Then, a product therein was purified with n-hexane/ dichloromethane (8:2 of a volume ratio) through silica gel column chromatography and recrystallized with dichloromethane and acetone, obtaining 14.0 g of a compound 2-19 (a yield of 97%).

### Synthesis Example 13: Synthesis of Compound 2-108

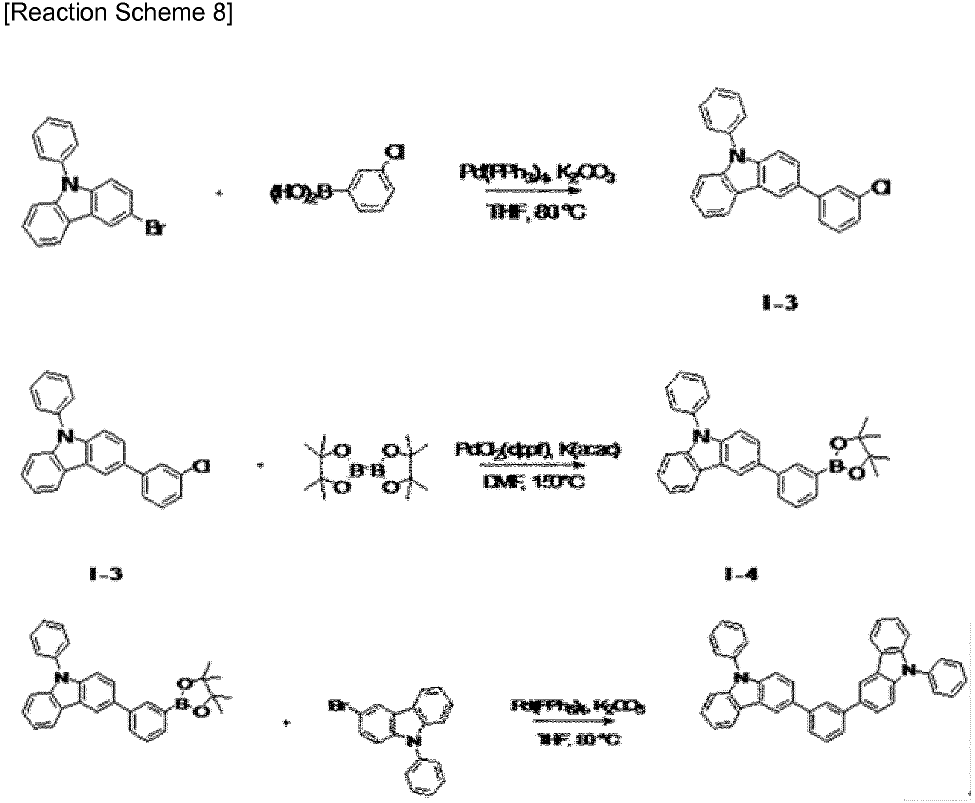

### First step: Synthesis of Compound I-3

100 g (310 mmol) of 3-bromo-9-phenyl-9H-carbazole was dissolved in 0.8 L of tetrahydrofuran (THF) under a nitrogen environment, 53.4 g (341 mmol) of 3-chlorophenylboronic acid and 3.58 g (3.10 mmol) of tetrakis(triphenylphosphine)palladium were added thereto, and the mixture was agitated. Then, 114 g (775 mmol) of potassium carbonate saturated in water was heated and refluxed at 80 ° C for 16 hours. When the reaction was complete, water was added to the reaction solution, and the mixture was extracted with dichloromethane (DCM) and then, filtered after removing moisture with anhydrous MgSO₄ therefrom and concentrated under a reduced pressure. The obtained residue was separated and purified through flash column chromatography, obtaining 91.0 g (83 %) of an intermediate I-3.
HRMS (70 eV, El+): m/z calcd for C24H16ClN: 353.0971, found: 353.
Elemental Analysis: C, 81 %; H, 5 %

### Second Step: Synthesis of Compound I-4

90 g (254 mmol) of the intermediate I-3 was dissolved in 0.8 L of dimethylforamide (DMF) in a nitrogen environment, 77.5 g (305 mmol) of bis(pinacolato)diboron and 2.70 g (2.54 mmol) of (1,1'-bis(diphenylphosphine)ferrocene)dichloropalladium (II) and 74.8 g (762 mmol) of potassium acetate were added thereto, and the mixture was heated and refluxed at 150 ° C for 25 hours. When the reaction was complete, water was added to the reaction solution, and the mixture was filtered and dried in a vacuum oven. The obtained residue was separated and purified through flash column chromatography, obtaining 67.9 g (60 %) of an intermediate I-4.
HRMS (70 eV, EI+): m/z calcd for C30H28BNO2: 445.2213, found: 445.
Elemental Analysis: C, 81 %; H, 6 %

### Third Step: Synthesis of Compound 2-108

20 g (44.9 mmol) of the intermediate I-4 was dissolved in 0.2 L of tetrahydrofuran (THF) in a nitrogen environment, 14.5 g (44.9 mmol) of 3-bromo-9-phenyl-9H-carbazole and 0.52 g (0.45 mmol) of tetrakis(triphenylphosphine)palladium were added thereto, and the mixture was agitated. Then, 16.5 g (112 mmol) of potassium carbonate was added thereto, and the obtained mixture was heated and refluxed at 80 ° C for 17 hours. When the reaction was complete, water was added to the reaction solution, and the mixture was extracted with dichloromethane (DCM) and then, filtered after removing moisture with anhydrous MgSO₄ and concentrated under a reduced pressure. This obtained residue was separated and purified through flash column chromatography, obtaining 21.4 g (85 %) of a compound 2-108.
HRMS (70 eV, El+): m/z calcd for C42H28N2: 560.2252, found: 560.
Elemental Analysis: C, 90 %; H, 5 %

### Synthesis Example 14: Synthesis of Compound 2-180

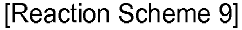

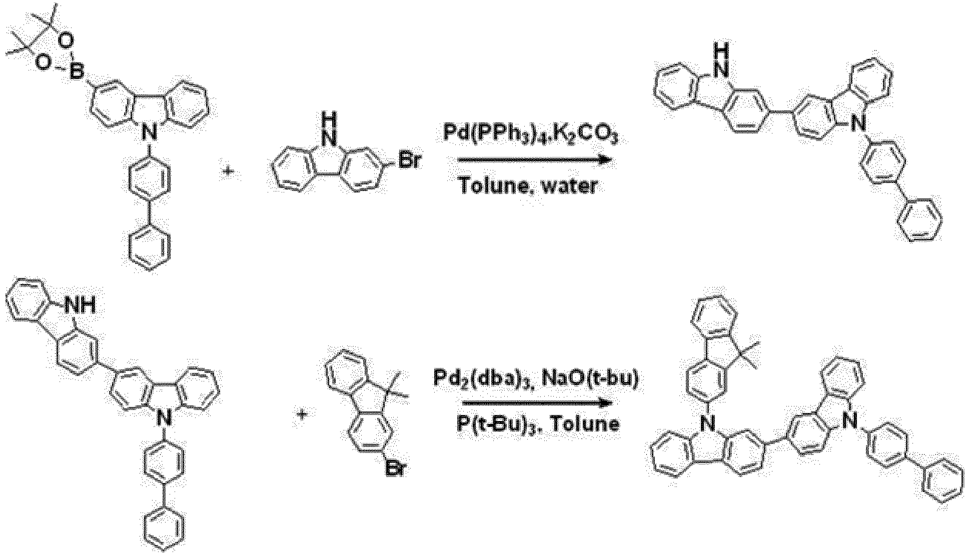

### First Step; Synthesis of Intermediate Product 150-a

20.0 g (44.91 mmol) of 9-biphenylcarbazole-3-boronic ester, 12.166 g (49.4 mmol) of 2-bromo carbazole, 0.519 g (0.45 mmol) of Pd(PPh₃)₄, and 12.41 g (89.81 mmmol) of K₂CO₃ were suspended in 200 mL of toluene and 100 mL of water under a nitrogen stream, and the suspended solution was refluxed and agitated for 18 hours. When the reaction was complete, the resultant was extracted with toluene and distilled water, a crystal produced therein was dissolved with monochlorobenzene and filered, and the filtered solution was concentrated under a reduced pressure. After removing an organic solution therefrom, a product therefrom was recrystallized with dichloromethane, obtaining 13.3 g of an intermediate 150-a (a yield: 61 %).

### Second Step; Synthesis of Compound 2-180

10.0 g (20.64 mmol) of the intermediate 150-a, 5,92 g (21.67 mmol) of 2-bromo dimethylfluorene, 2.18 g (22.70 mmol) of NaO(t-Bu), and 0.189 g (0.21 mmmol) of Pd₂(dba)₃ were suspended in 85 ml of toluene, 0.125 mL (0.62 mmol) of tri-tertiary-butylphosphine was added thereto, and the mixture was refluxed and agitated for 12 hours.

When the reaction was complete, the resultant was extracted with toluene and distilled water, an organic layer obtained therefrom was dried with magnesium sulfate and filtered, and the filtered solution was concentrated under a reduced pressure. Then, a product therefrom was purified with n-hexane/ dichloromethane (8:2volume ratio) through silica gel column chromatography and recrystallized with dichloromethane and ethylacetate, obtaining 11.2 g of a compound 2-180 (a yield of 80 %).

### Manufacture of Organic Light Emitting Diode

### Example 1

A glass substrate coated with ITO (indium tin oxide) to be 1500 A thick was ultrasonic wave-washed with a distilled water. Subsequently, the glass substrate was ultrasonic wave-washed with a solvent such as isopropyl alcohol, acetone, methanol, and the like, moved to a plasma cleaner, cleaned by using oxygen plasma for 10 minutes, and then, moved to a vacuum depositor. The ITO transparent electrode was used as a positive electrode, a 700Å-thick hole injection layer (HIL) was formed thereon by vacuum-depositing N4,N4'-diphenyl-N4,N4'-bis(9-phenyl-9H-carbazol-3-yl)biphenyl-4,4'-diamine) (the compound A), and a hole transport layer (HTL) was formed thereto by depositing 1,4,5,8,9,11-hexaazatriphenylene-hexacarbonitrile (HAT-CN) (the compound B) to be 50 Å thick and N-(biphenyl-4-yl)-9,9-dimethyl-N-(4-(9-phenyl-9H-carbazol-3-yl)phenyl)-9H-fluoren-2-amine) (the compound C) to be 700 Å thick. On the hole transport layer (HTL), a 320 Å-thick hole transport auxiliary layer was formed by vacuum-depositing the compound 2-31 according to Synthesis Example 11. Subsequently, on the hole transport auxiliary layer, a 400 Å-thick emission layer was formed by simultaneously using the compound 1-121 according to Synthesis Example 1 and the compound 2-132 according to Synthesis Example 7 as a host doping them with tris(4-methyl-2,5-diphenylpyridine)iridium (III) (the compound D) in an amount of 7 wt% as a dopant and vacuum-depositing the host doped with the dopant. Herein, the compound 1-122 and the compound 2-132 were used in a weight ratio of 1:1.

Subsequently, on the emission layer, a 300 Å-thick electron transport layer (ETL) was formed by simultaneously vacuum-depositing 8-(4-(4-(naphthalen-2-yl)-6-(naphthalen-3-yl)-1,3,5-triazin-2-yl)phenyl)quinoline) (the compound E) and Liq in a ratio of 1:1, and on the electron transport layer (ETL), a cathode was formed by sequentially vacuum-depositing Liq to be 15 Å thick and Al to be 1200 Å thick, manufacturing an organic light emitting diode.

The organic light emitting diode has a structure of six layered organic thin films and specifically,
a structure of ITO/A 700 Å/B 50 Å/C 700 Å/hole transport auxiliary layer [2-31 320 Å]/EML [1-121:2-132:D= X:X:7 %] 400 Å/E:Liq 300 Å/Liq 15 Å/Al 1200 Å.
(X= a weight ratio)

### Example 2

An organic light emitting diode was manufactured according to the same method as Example 1 except for using the compound 2-1 according to Synthesis Example 8 instead of the compound 2-132 for the emission layer.

### Example 3

An organic light emitting diode was manufactured according to the same method as Example 1 except for using the compound 2-22 according to Synthesis Example 9 instead of the compound 2-132 for the emission layer.

### Example 4

An organic light emitting diode was manufactured according to the same method as Example 1 except for using the compound 2-25 according to Synthesis Example 10 instead of the compound 2-132 for the emission layer.

### Example 5

An organic light emitting diode was manufactured according to the same method as Example 1 except for using the compound 2-31 according to Synthesis Example 11 instead of the compound 2-132 for the emission layer.

### Example 6

An organic light emitting diode was manufactured according to the same method as Example 1 except for using the compound 2-19 according to Synthesis Example 12 instead of the compound 2-31 for the hole transport auxiliary layer.

### Example 7

An organic light emitting diode was manufactured according to the same method as Example 1 except for using the compound 2-108 according to Synthesis Example 13 instead of the compound 2-31 for the hole transport auxiliary layer.

### Example 8

An organic light emitting diode was manufactured according to the same method as Example 1 except for using the compound 2-180 according to Synthesis Example 14 instead of the compound 2-31 for the hole transport auxiliary layer.

### Reference Example 1

An organic light emitting diode was manufactured according to the same method as Example 1 except for depositing the compound C to form a 1020 Å thick hole transport layer (HTL) without the hole transport auxiliary layer.

### Reference Example 2

An organic light emitting diode was manufactured according to the same method as Example 2 except for depositing the compound C to form a 1020 Å thick hole transport layer (HTL) without the hole transport auxiliary layer.

### Reference Example 3

An organic light emitting diode was manufactured according to the same method as Example 3 except for depositing the compound C to form a 1020 Å thick hole transport layer (HTL) without the hole transport auxiliary layer.

### Reference Example 4

An organic light emitting diode was manufactured according to the same method as Example 4 except for depositing the compound C to form a 1020 Å thick hole transport layer (HTL) without the hole transport auxiliary layer.

### Reference Example 5

An organic light emitting diode was manufactured according to the same method as Example 5 except for depositing the compound C to form a 1020 Å-thick hole transport layer (HTL) without the hole transport auxiliary layer.

### Comparative Example 1

An organic light emitting diode was manufactured according to the same method as Example 1 except for depositing the compound C to form a 1020 Å-thick hole transport layer (HTL) without the hole transport auxiliary layer and using the compound 1-121 instead of the mixture of the compound 1-121 and the compound 2-132 for the emission layer.

### Comparative Example 2

An organic light emitting diode was manufactured according to the same method as Example 1 except for depositing the compound C to form a 1020 Å-thick hole transport layer (HTL) without the hole transport auxiliary layer and using only the compound 2-132 instead of the mixture of the compound 1-121 and the compound 2-132 for the emission layer.

### Evaluation

Driving voltages and luminous efficiency characteristics of Examples 1 to organic light emitting diodes according to Example 8, Reference Examples 1 to 5, and Comparative Examples 1 and 2 were measured.

Specific measurement methods were as follows, and the results were provided in Table 2.

### (1) Measurement of Current Density Change Depending on Voltage Change

The obtained organic light emitting diodes were measured for current value flowing in the unit device while increasing the voltage from 0 V to 10 V using a current-voltage meter (Keithley 2400), the measured current value was divided by area to provide the results.

### (2) Measurement of Luminance Change Depending on Voltage Change

Luminance was measured by using a luminance meter (Minolta Cs-1000A), while the voltage of the organic light emitting diodes was increased from 0 V to 10 V.

### (3) Measurement of Luminous Efficiency

Current efficiency (cd/A) at the same current density (10 mA/cm²) were calculated by using the luminance, current density, and voltages (V) from the items (1) and (2).

**[Table 2]**

| | Hole transport auxiliary layer | Emission layer | | | Driving voltage (V) | Light emitting efficiency (cd/A) | Luminance (cd/m² ) | Color coordinate (x, y) |
|---|---|---|---|---|---|---|---|---|
| | | First compound | Second compound | First compound: second compound (wt/wt) | | | | |
| Example 1 | 2-31 | 1-121 | 2-132 | 1:1 | 4.17 | 54.2 | 6000 | (0.374, 0.598) |
| Example 2 | 2-31 | 1-121 | 2-1 | 1:1 | 4.31 | 53.4 | 6000 | (0.374, 0.600) |
| Example 3 | 2-3 | 1-121 | 2-22 | 1:1 | 3.85 | 57.1 | 6000 | (0.373, 0.601) |
| Example 4 | 2-31 | 1-121 | 2-25 | 1:1 | 4.09 | 56.8 | 6000 | (0.369, 0.602) |
| Example 5 | 2-31 | 1-121 | 2-31 | 1:1 | 3.80 | 52.9 | 6000 | (0.366, 0.605) |
| Example 6 | 2-19 | 1-121 | 2-132 | 1:1 | 4.33 | 49.0 | 6000 | (0.367, 0.603) |
| Example 7 | 2-108 | 1-121 | 2-132 | 1:1 | 4.55 | 56.1 | 6000 | (0.377, 0.594) |
| Example 8 | 2-180 | 1-121 | 2-132 | 1:1 | 4.38 | 55.1 | 6000 | (0.374, 0.599) |
| Reference Example 1 | - | 1-121 | 2-132 | 1:1 | 4.28 | 36.8 | 6000 | (0.365, 0.606) |
| Reference Example 2 | - | 1-121 | 2-1 | 1:1 | 4.28 | 42.7 | 6000 | (0.361, 0.609) |
| Reference Example 3 | - | 1-121 | 2-22 | 1:1 | 3.87 | 37.1 | 6000 | (0.370, 0.602) |
| Referen e Example 4 | - | 1-121 | 2-25 | 1:1 | 3.84 | 43.8 | 6000 | (0.374, 0.599) |
| Reference Example 5 | - | 1-121 | 2-31 | 1:1 | 4.00 | 33.0 | 6000 | (0.362, 0.605) |
| Comparative Example 1 | | 1-121 | | | - | 26.5 | 6000 | (0.379, 0.595) |
| Comparative Example 2 | | 2-132 | | | 7.89 | 12.0 | 6000 | (0.357, 0.605) |

Referring to Table 2, the organic light emitting diodes according to Examples 1 to 8 simultaneously showed remarkably improved driving voltage and luminous efficiency characteristics compared with the organic light emitting diodes according to Comparative Examples 1 and 2.

In addition, the organic light emitting diodes according to Examples 1 to 8 showed improved luminous efficiency compared with the organic light emitting diodes according to Reference Examples 1 to 5.

While this invention has been described in connection with what is presently considered to be practical exemplary embodiments, it is to be understood that the invention is not limited to the disclosed embodiments. Therefore, the aforementioned embodiments should be understood to be exemplary but not limiting the present invention in any way.

## Claims

1. An organic optoelectric device comprising
an anode (10) and a cathode (20) facing each other, an emission layer (32) between the anode (10) and the cathode, (20) a hole transport layer (31) between the anode (10) and the emission layer, (32) and a hole transport auxiliary layer (33) between the hole transport layer (31) and the emission layer, (32) wherein the emission layer (32) comprises at least one of a first compound including moieties represented by Chemical Formulae 1 to 3 sequentially linked and at least one of a second compound represented by Chemical Formula 4, and
the hole transport auxiliary layer (33) comprises at least one of a third compound represented by Chemical Formula 5: 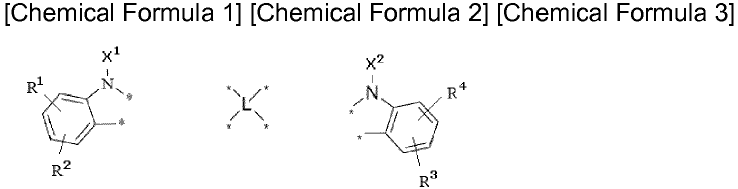 wherein, in Chemical Formulae 1 to 3,
X¹ is *-Y¹-ET,
X² is *-Y²-Ar¹,
Y¹ and Y² are each independently a single bond, a substituted or unsubstituted C6 to C30 arylene group, a substituted or unsubstituted C2 to C30 heteroarylene group, or a combination thereof,
Ar¹ is a substituted or unsubstituted C6 to C30 aryl group, a substituted or unsubstituted C2 to C30 heteroaryl group, or a combination thereof,
L is a substituted or unsubstituted C2 or C3 alkenylene group or a substituted or unsubstituted C6 to C20 arylene group,
R¹ to R⁴ are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof,
ET is represented by Chemical Formula 1a, and
* is a linking point, 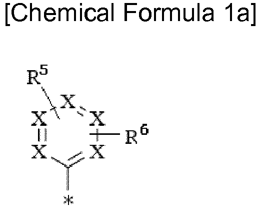
wherein, in Chemical Formula 1a,
X is N, C or CR^{a},
at least one of X is N,
R⁵, R⁶ and R^{a} are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof, and
* is a linking point, 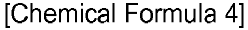 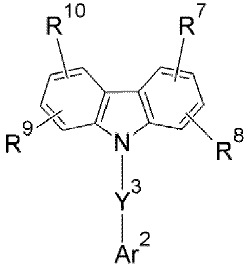
wherein in Chemical Formula 4,
Y³ is a single bond, a substituted or unsubstituted C6 to C30 arylene group, a substituted or unsubstituted C2 to C30 heteroarylene group, or a combination thereof,
Ar² is a substituted or unsubstituted C6 to C30 aryl group, substituted or unsubstitutedC2 to C30 heteroaryl group, or a combination thereof,
R⁷ to R¹⁰ are each independently hydrogen, deuterium, a substituted or unsubstituted C1 to C20 alkyl group, a substituted or unsubstituted C6 to C50 aryl group, a substituted or unsubstituted C2 to C50 heteroaryl group, or a combination thereof, and
at least one of R⁷ to R¹⁰ and Ar² includes a substituted or unsubstituted triphenylene group or a substituted or unsubstituted carbazolyl group, 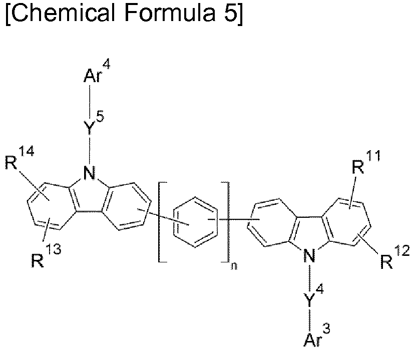
wherein, in Chemical Formula 5,
R¹¹ to R¹⁴ are each independently hydrogen, deuterium, a substituted or unsubstituted C1 to C30 alkyl group, a substituted or unsubstituted C6 to C30 aryl group, a substituted or unsubstituted C2 to C30 heteroaryl group, or a combination thereof,
Y⁴ and Y⁵ are each independently a single bond, a substituted or unsubstituted C6 to C30 arylene group, a substituted or unsubstituted C2 to C30 heteroarylene group, or a combination thereof,
Ar³ and Ar⁴ are each independently hydrogen, deuterium, a substituted or unsubstituted C1 to C30 alkyl group, a substituted or unsubstituted C3 to C30 cycloalkyl group, a substituted or unsubstituted C6 to C30 aryl group, a substituted or unsubstituted carbazolyl group, a substituted or unsubstituted dibenzofuranyl group, a substituted or unsubstituted dibenzothiophenyl group, a substituted or unsubstituted C6 to C30 arylamine group, a substituted or unsubstituted C1 to C30 alkoxy group, a substituted or unsubstituted C3 to C40 silyl group, a substituted or unsubstituted C1 to C30 alkylthiol group, a substituted or unsubstituted C6 to C30 arylthiol group, a halogen, a halogen-containing group, a cyano group, a hydroxy group, an amino group, a nitro group, or a combination thereof, and
n is an integer ranging from 0 to 4,
wherein "substituted" of Chemical Formulae 1 to 5 refers to that at least one hydrogen is replaced by deuterium, a halogen, a hydroxy group, an amino group, a substituted or unsubstituted C1 to C30 amine group, a nitro group, a substituted or unsubstituted C1 to C40 silyl group, a C1 to C30 alkyl group, a C3 to C30 cycloalkyl group, a C2 to C30 heterocycloalkyl group, a C6 to C30 aryl group, a C2 to C30 heteroaryl group, a C1 to C20 alkoxy group, a fluoro group, a C1 to C10 trifluoroalkyl group, or a cyano group.

2. The organic optoelectric device of claim 1, wherein X¹ of Chemical Formula 1 is one of substituents listed in Group 2: 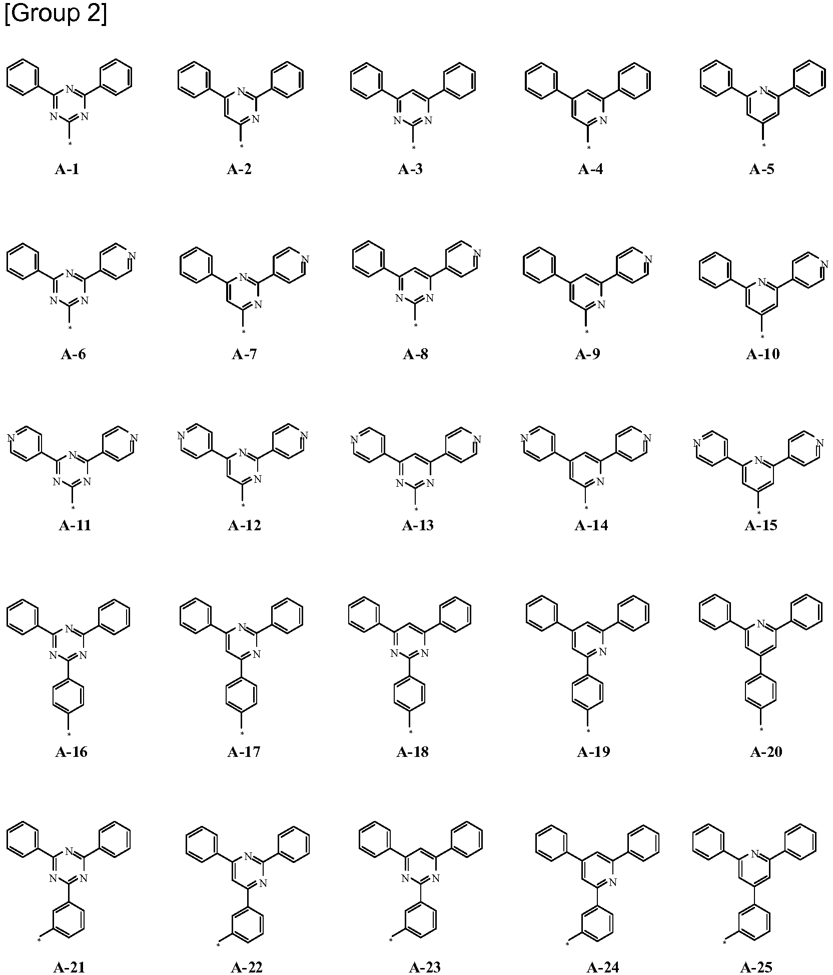 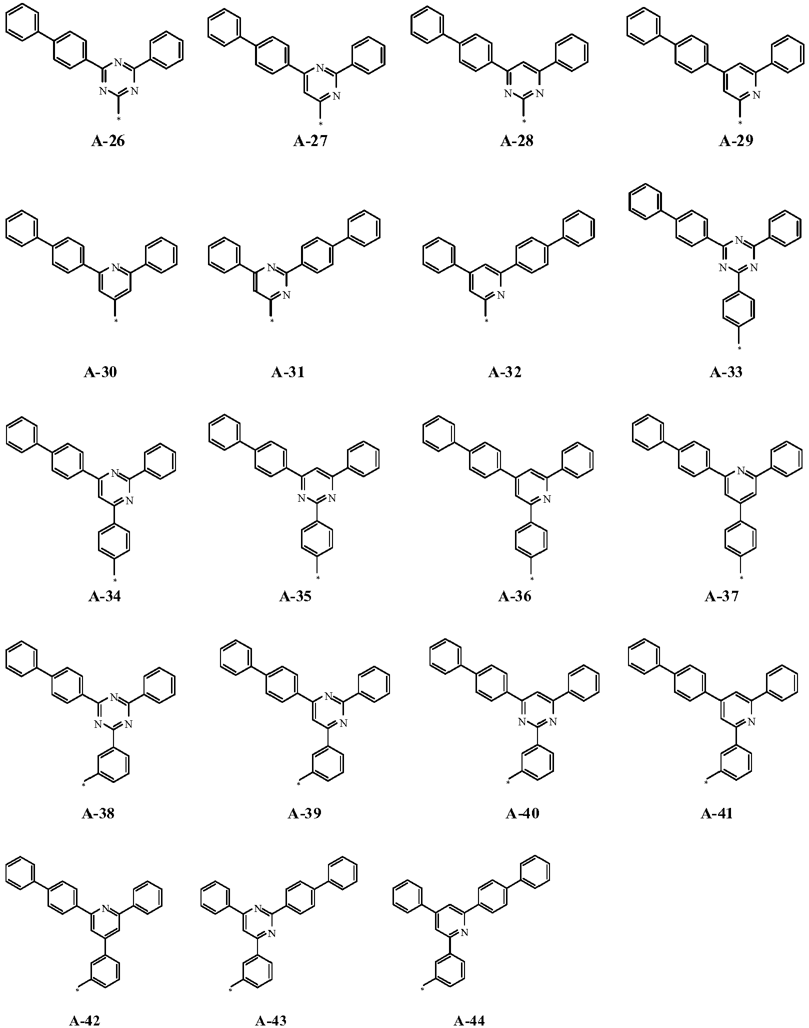 wherein, in Group 2,
* is a linking point.

3. The organic optoelectric device of claim 1 or 2, wherein moiety represented by Chemical Formula 2 is represented by one of Chemical Formulae 2-1 to 2-3: 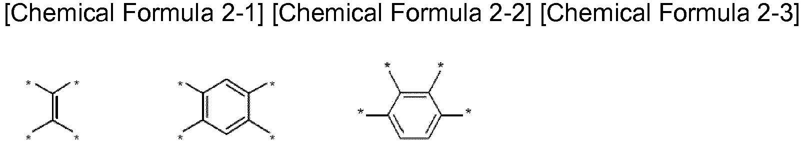 wherein, in Chemical Formulae 2-1 to 2-3,
* is a linking point.

4. The organic optoelectric device of any one of claims 1 to 3, wherein the Ar¹ is a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted carbazolyl group, a substituted or unsubstituted benzofuranyl group, a substituted or unsubstituted benzothiophenyl group, a substituted or unsubstituted fluorenyl group, a substituted or unsubstituted dibenzothiophenyl group, a substituted or unsubstituted dibenzofuranyl group, or a combination thereof.

5. The organic optoelectric device of any one of claims 1 to 4, wherein X² of Chemical Formula 3 is one of substituents listed in Group 3: 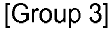 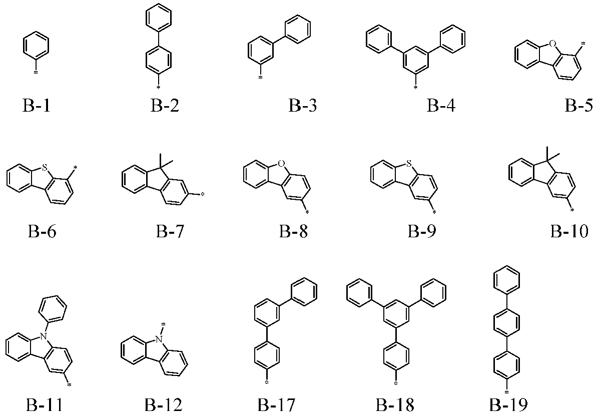 wherein, in Group 3, * is a linking point.

6. The organic optoelectric device of any one of claims 1 to 5, wherein the first compound is one of substituents listed in Group 4: 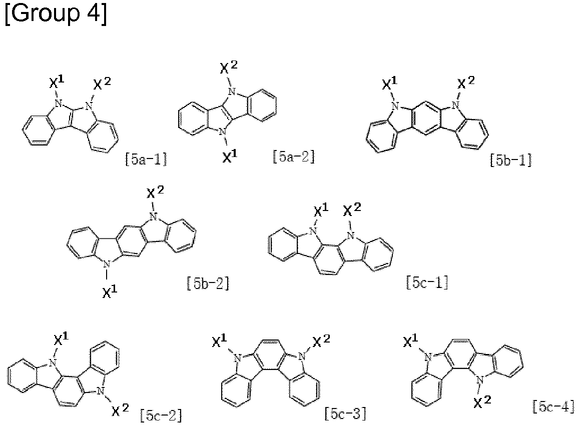 wherein, in Group 4,
X¹ is *-Y¹-ET,
X² is *-Y²-Ar¹,
Y¹ and Y² are each independently a single bond, a substituted or unsubstituted C6 to C30 arylene group, a substituted or unsubstituted C2 to C30 heteroarylene group, or a combination thereof,
Ar¹ is a substituted or unsubstituted C6 to C30 aryl group, a substituted or unsubstituted C2 to C30 heteroaryl group, or a combination thereof,
ET is represented by Chemical Formula 1a, and
* is a linking point, 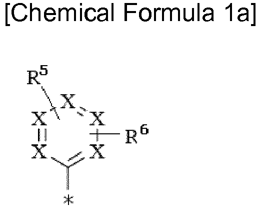
wherein, in Chemical Formula1a,
X is N, C or CR^{a},
at least one of X is N,
R⁵, R⁶ and R^{a} are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof, and
* is a linking point.

7. The organic optoelectric device of any one of claims 1 to 6,
wherein, in Group 4, X¹ is *-Y¹-ET, X² is *-Y²-Ar¹,
Y¹ and Y² are each independently a single bond, a substituted or unsubstituted C6 to C30 arylene group or a combination thereof,
Ar¹ is a substituted or unsubstituted phenyl group, a substituted or unsubstituted biphenyl group, a substituted or unsubstituted terphenyl group, a substituted or unsubstituted quaterphenyl group, a substituted or unsubstituted naphthalenyl group, a substituted or unsubstituted dibenzofuranyl group, a substituted or unsubstituted dibenzothiophenyl group, a substituted or unsubstituted fluorenyl group, or a substituted or unsubstituted carbazolyl group,
ET is represented by Chemical Formula 1a, 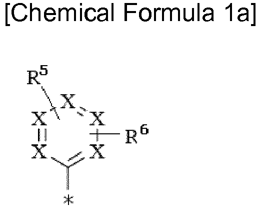 wherein, in Chemical Formula1a,
X is N, C or CR^{a},
at least one of X is N,
R⁵, R⁶ and R^{a} are each independently hydrogen, deuterium, a substituted or unsubstituted C1 to C20 alkyl group, a substituted or unsubstituted C6 to C30 aryl group, or a combination thereof, and
* is a linking point.

8. The organic optoelectric device of any one of claims 1 to 7, wherein the second compound is represented by at least one of Chemical Formulae 4- I to 4-III: 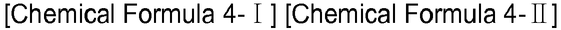 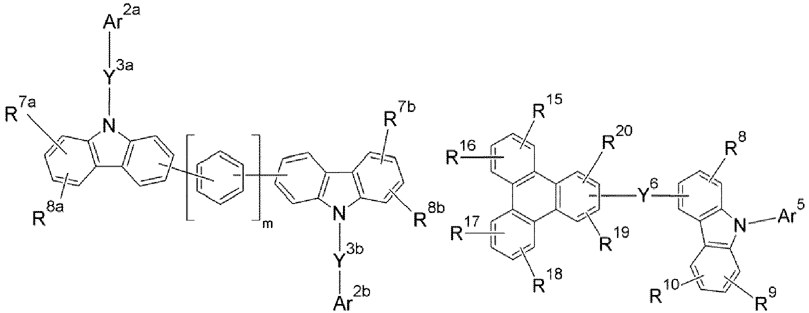 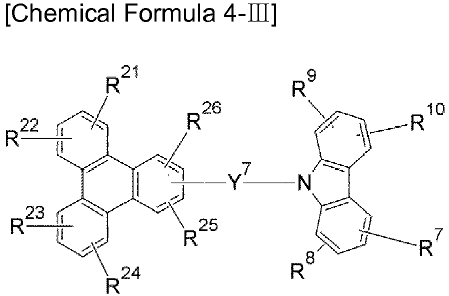 wherein, in Chemical Formulae 4- I to 4-III,
Y^{3a}, Y^{3b}, Y⁶ and Y⁷ are each independently a single bond, a substituted or unsubstituted C6 to C30 arylene group, a substituted or unsubstituted C2 to C30 heteroarylene group, or a combination thereof,
Ar^{2a}, Ar^{2b} and Ar⁵ are each independently a substituted or unsubstituted C6 to C30 aryl group, a substituted or unsubstituted C2 to C30 heteroaryl group, or a combination thereof,
R^{7a}, R^{8a}, R^{7b}, R^{8b}, R⁷ to R¹⁰, and R¹⁵ to R²⁶ are each independently hydrogen, deuterium, a substituted or unsubstituted C1 to C20 alkyl group, a substituted or unsubstituted C6 to C50 aryl group, a substituted or unsubstituted C2 to C50 heteroaryl group, or a combination thereof, and
m is an integer of 0 to 4.

9. The organic optoelectric device of any one of claims 1 to 8, wherein Chemical Formula 4- I is one of structures listed in Group 6, and the *-Y^{3a}-Ar^{2a}, and *-Y^{3b}-Ar^{2b} are is one of substituents listed in Group 3: 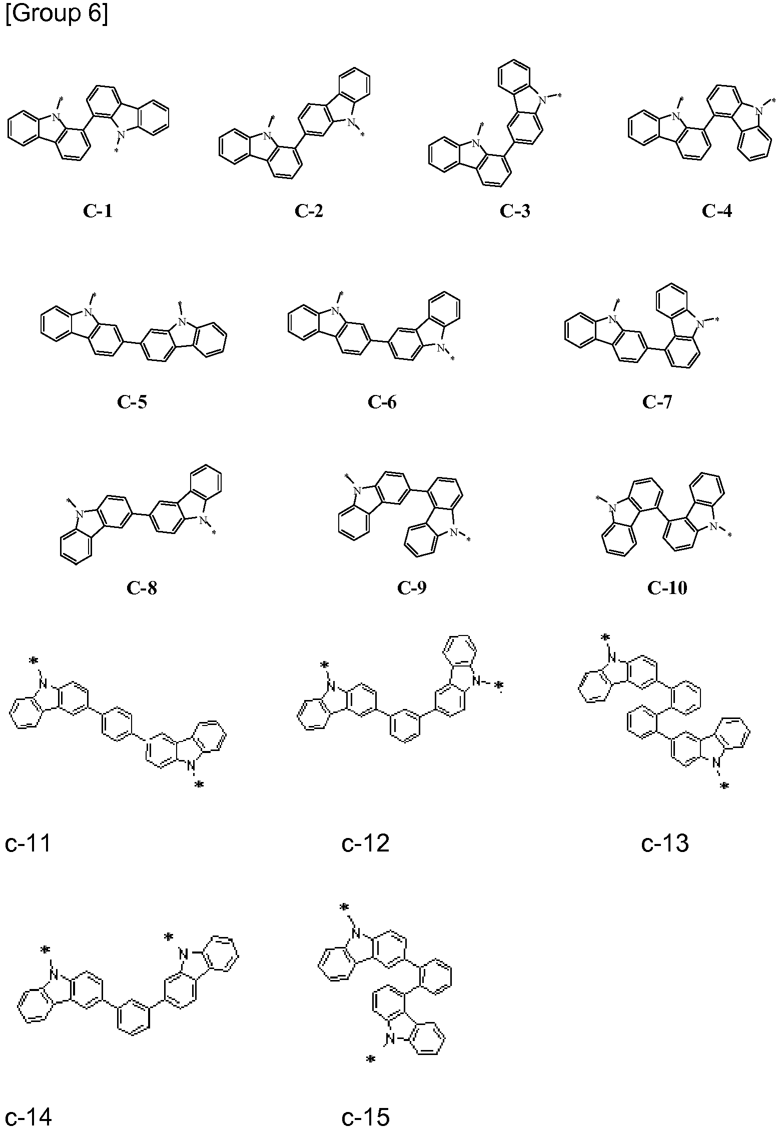 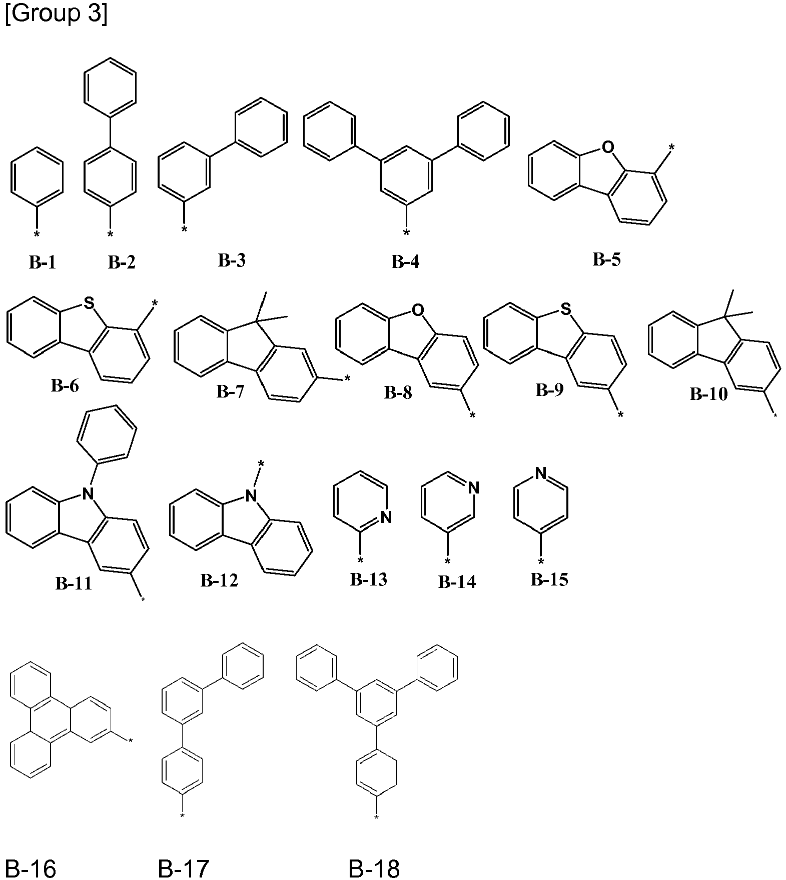 wherein, in Group 3 and Group 6, * is a linking point.

10. The organic optoelectric device of any one of claims 1 to 9, wherein Ar² of Chemical Formula 4 is a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted carbazolyl group, a substituted or unsubstituted benzofuranyl group, a substituted or unsubstituted benzothiophenyl group, a substituted or unsubstituted fluorenyl group, a substituted or unsubstituted dibenzofuranyl group, a substituted or unsubstituted dibenzothiophenyl group, a substituted or unsubstituted pyridinyl group, a substituted or unsubstituted pyrimidinyl group, or a combination thereof.

11. The organic optoelectric device of any one of claims 1 to 10, wherein the third compound is represented by at least one of Chemical Formulae 5- I to 5-VII: 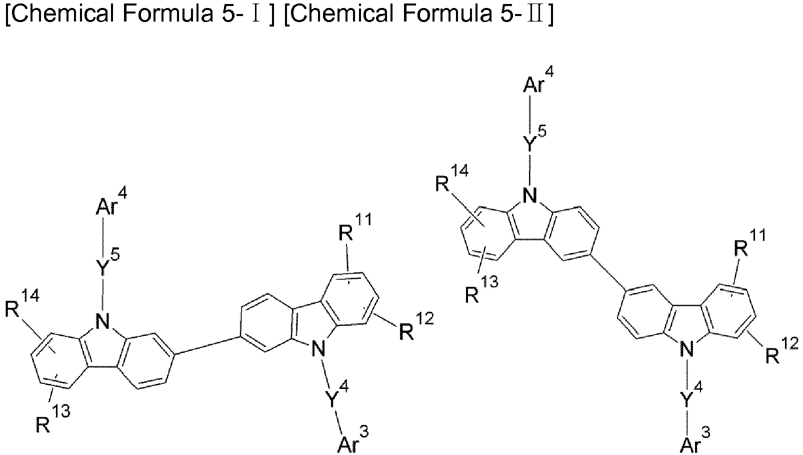 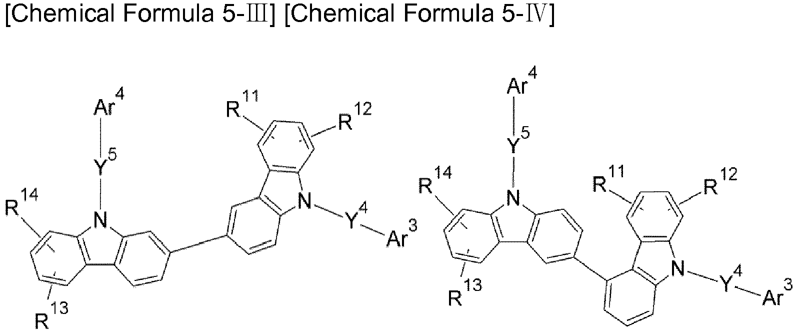 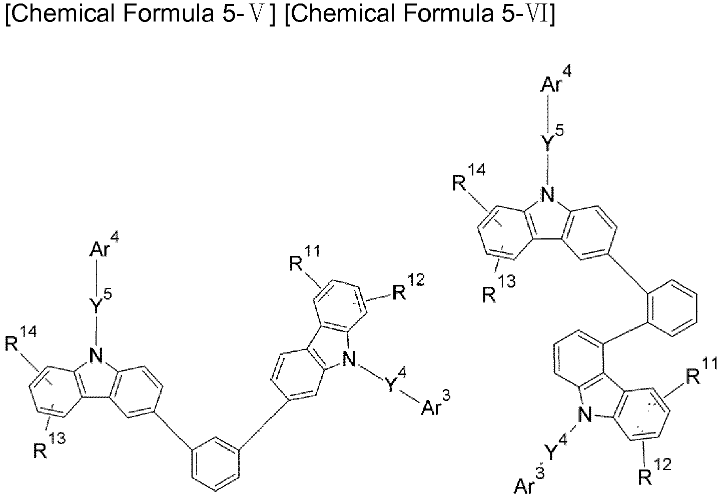 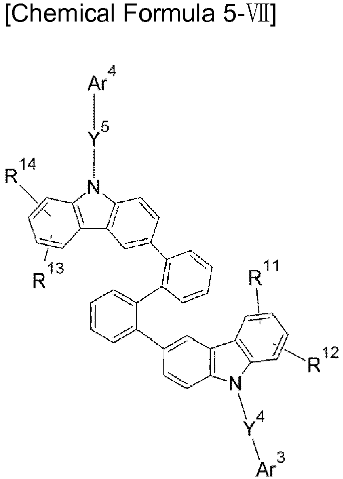 wherein, in Chemical Formula 5- I to Chemical Formula 5-VII,
R¹¹ to R¹⁴ are each independently hydrogen, deuterium, a substituted or unsubstituted C1 to C30 alkyl group, a substituted or unsubstituted C6 to C30 aryl group, a substituted or unsubstituted C2 to C30 heteroaryl group, or a combination thereof,
Y⁴ and Y⁵ are each independently a single bond, a substituted or unsubstituted C6 to C30 arylene group, a substituted or unsubstituted C2 to C30 heteroarylene group, or a combination thereof,
Ar³ and Ar⁴ are each independently a substituted or unsubstituted phenyl group, a substituted or unsubstituted biphenyl group, a substituted or unsubstituted terphenyl group, a substituted or unsubstituted quarterphenyl group, a substituted or unsubstituted fluorenyl group, a substituted or unsubstituted dibenzofuranyl group, a substituted or unsubstituted dibenzothiophenyl group, a substituted or unsubstituted triphenylenyl group, or a combination thereof,
wherein "substituted" of Chemical Formulae 5-I to 5-VII refers to that at least one hydrogen is replaced by deuterium, a halogen, a hydroxy group, an amino group, a C1 to C30 amine group, a nitro group, a C1 to C40 silyl group, a C1 to C30 alkyl group, a C1 to C10 alkylsilyl group, a C3 to C30 cycloalkyl group, a C2 to C30 heterocycloalkyl group, a C6 to C30 aryl group, a C2 to C30 heteroaryl group, a C1 to C20 alkoxy group, a fluoro group, a C1 to C10 trifluoroalkyl group or a cyano group.

12. The organic optoelectric device of any one of claims 1 to 11, wherein the Ar³ and Ar⁴ are each independently selected from substituted or unsubstituted groups listed in Group 8: 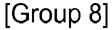 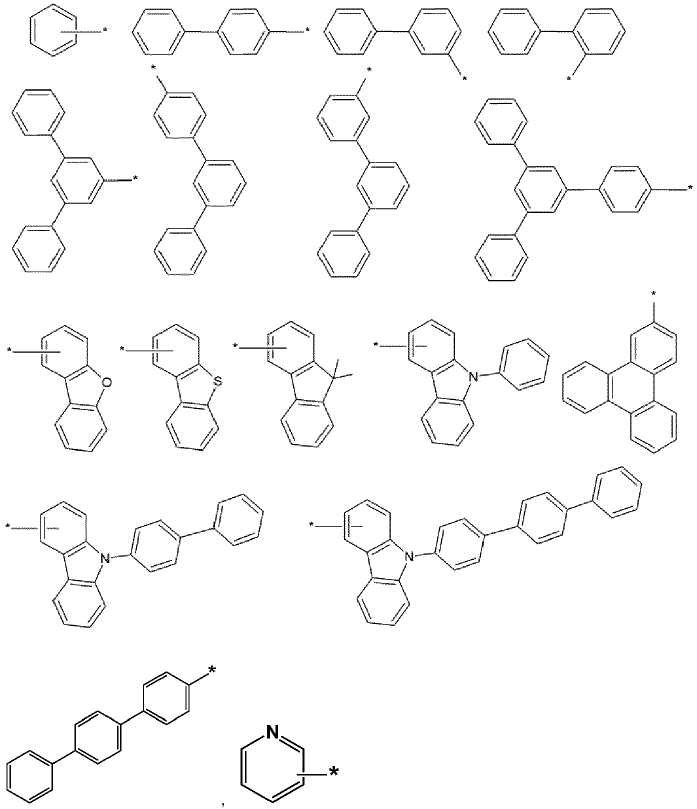 wherein, in Group 8, * is a linking point.

13. The organic optoelectric device of any one of claims 1 to 12, wherein the emission layer comprises at least one of first compounds listed in Group 4, and
at least one of second compounds represented by Chemical Formulae 4-I and 4-II, and
the hole transport auxiliary layer comprises at least one of third compounds represented by Chemical Formulae 5-II, 5-III and 5-V: 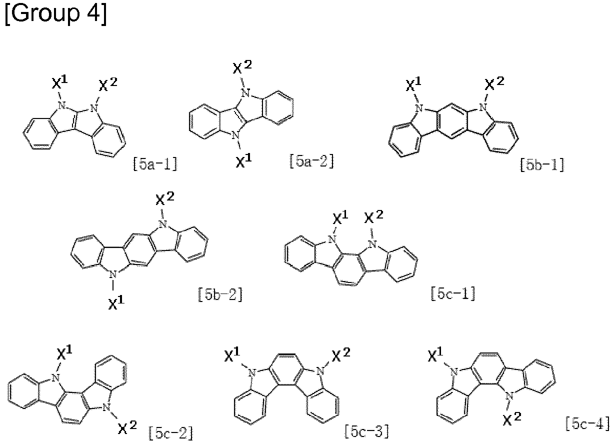 wherein in Group 4, X¹ is *-Y¹-ET, X² is*-Y² -Ar¹, wherein Y¹ and Y² are each independently a single bond, a substituted or unsubstituted C6 to C30 arylene group, a substituted or unsubstituted C2 to C30 heteroarylene group, or a combination thereof, Ar¹ is a substituted or unsubstituted C6 to C30 aryl group, a substituted or unsubstituted C2 to C30 heteroaryl group, or a combination thereof, and ET is represented by Chemical Formula 1a, 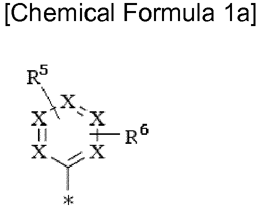 wherein in Chemical Formula 1a,
X is N, C or CR^{a},
at least one of X is N,
R⁵, R⁶ and R^{a} are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof, and * is a linking point, 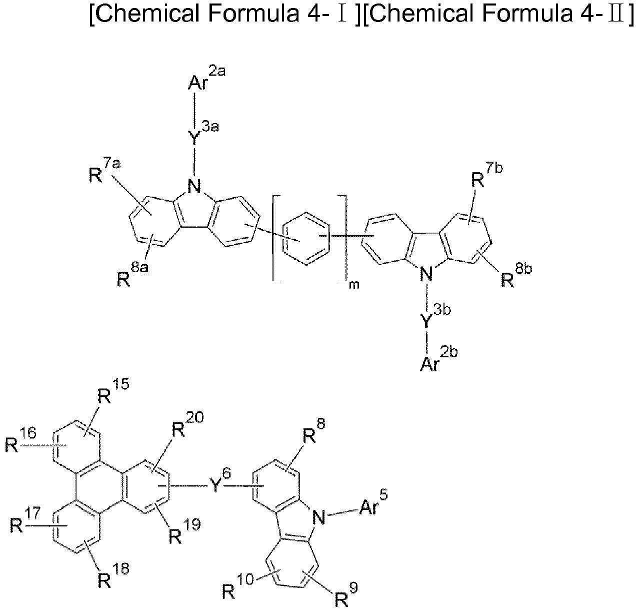
wherein in Chemical Formulae 4- I and 4-II, Y^{3a}, Y^{3b}, Y⁶ and Y⁷ are each independently a single bond, a substituted or unsubstituted C6 to C30 arylene group, a substituted or unsubstituted C2 to C30 heteroarylene group, or a combination thereof,
Ar^{2a}, Ar^{2b} and Ar⁵ are each independently a substituted or unsubstituted C6 to C30 aryl group, a substituted or unsubstituted C2 to C30 heteroaryl group, or a combination thereof,
R^{7a}, R^{8a}, R^{7b}, R^{8b}, R⁷ to R¹⁰, and R¹⁵ to R²⁶ are each independently hydrogen, deuterium, a substituted or unsubstituted C1 to C20 alkyl group, a substituted or unsubstituted C6 to C50 aryl group, a substituted or unsubstituted C2 to C50 heteroaryl group, or a combination thereof, and
m is one of integers of 0 to 4, 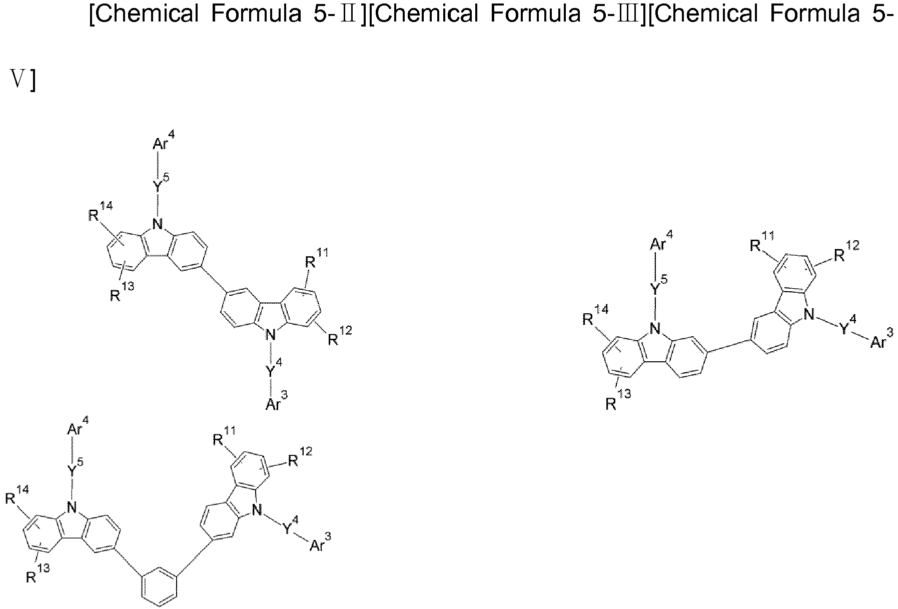
wherein, in Chemical Formulae 5-II, 5-III and 5-V,
R¹¹ to R¹⁴ are each independently hydrogen, deuterium, a substituted or unsubstituted C1 to C30 alkyl group, a substituted or unsubstituted C6 to C30 aryl group, a substituted or unsubstituted C2 to C30 heteroaryl group, or a combination thereof,
Y⁴ and Y⁵ are each independently a single bond, a substituted or unsubstituted C6 to C30 arylene group, a substituted or unsubstituted C2 to C30 heteroarylene group, or a combination thereof, and
Ar³ and Ar⁴ are each independently a substituted or unsubstituted phenyl group, a substituted or unsubstituted biphenyl group, a substituted or unsubstituted terphenyl group, a substituted or unsubstituted quarterphenyl group, a substituted or unsubstituted fluorenyl group, a substituted or unsubstituted dibenzofuranyl group, a substituted or unsubstituted dibenzothiophenyl group, a substituted or unsubstituted triphenylenyl group, or a combination thereof.

14. The organic optoelectric device of any one of claims 1 to 13, wherein the hole transport auxiliary layer contacts the hole transport layer and the emission layer.

15. A display device comprising the organic optoelectric device of any one of claims 1 to 14.

## Patentansprüche

1. Organische optoelektrische Vorrichtung, umfassend eine Anode (10) und eine Kathode (20), die einander gegenüberstehen, eine Emissionsschicht (32) zwischen der Anode (10) und der Kathode (20), eine Löchertransportschicht (31) zwischen der Anode (10) und der Emissionsschicht (32) und einer Löchertransport-Hilfsschicht (33) zwischen der Löchertransportschicht (31) und der Emissionsschicht (32), wobei die Emissionsschicht (32) wenigstens eine von einer ersten Verbindung, die sequenziell verknüpfte Einheiten enthält, die durch die chemischen Formeln 1 bis 3 dargestellt werden, und wenigstens eine von einer zweiten Verbindung, die durch die chemische Formel 4 dargestellt wird, umfasst, und die Löchertransport-Hilfsschicht (33) wenigstens eine von einer dritten Verbindung, die durch die chemische Formel 5 dargestellt wird, umfasst: 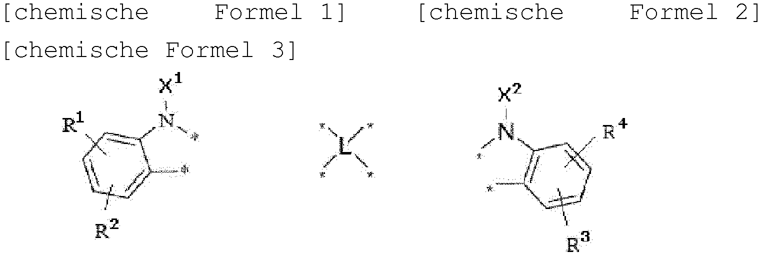 wobei in den chemischen Formeln 1 bis 3
X¹ *-Y¹-ET ist,
X² *-Y²-Ar¹ ist,
Y¹ und Y² jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind,
Ar¹ eine substituierte oder unsubstituierte C6- bis C30-Arylgruppe, eine substituierte oder unsubstituierte C2- bis C30-Heteroarylgruppe oder eine Kombination davon ist,
L eine substituierte oder unsubstituierte C2- oder C3-Alkenylengruppe oder eine substituierte oder unsubstituierte C6- bis C20-Arylengruppe ist,
R¹ bis R⁴ jeweils unabhängig Wasserstoff, Deuterium, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe oder eine Kombination davon sind,
ET durch die chemische Formel 1a dargestellt wird und
* ein Verknüpfungspunkt ist, 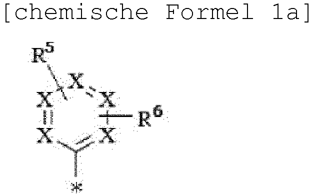
wobei in der chemischen Formel 1a
X N, C oder CR^{a} ist,
wenigstens eines der X N ist,
R⁵, R⁶ und R^{a} jeweils unabhängig Wasserstoff, Deuterium, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe oder eine Kombination davon sind und
* ein Verknüpfungspunkt ist, 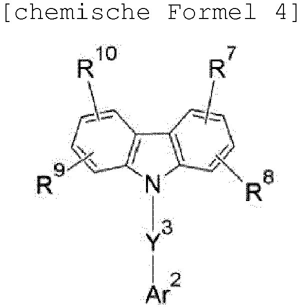
wobei in der chemischen Formel 4
Y³ eine Einfachbindung, eine substituierte oder unsubstituierte C6- bis C30-Arylengruppe, eine substituierte oder unsubstituierte C2- bis C30-Heteroarylengruppe oder eine Kombination davon ist,
Ar² eine substituierte oder unsubstituierte C6- bis C30-Arylgruppe, eine substituierte oder unsubstituierte C2- bis C30-Heteroarylgruppe oder eine Kombination davon ist,
R⁷ bis R¹⁰ jeweils unabhängig Wasserstoff, Deuterium, eine substituierte oder unsubstituierte C1- bis C20-Alkylgruppe, eine substituierte oder unsubstituierte C6- bis C50-Arylgruppe, eine substituierte oder unsubstituierte C2- bis C50-Heteroarylgruppe oder eine Kombination davon sind und
wenigstens eines von R⁷ bis R¹⁰ und Ar² eine substituierte oder unsubstituierte Triphenylengruppe oder eine substituierte oder unsubstituierte Carbazolylgruppe enthält, 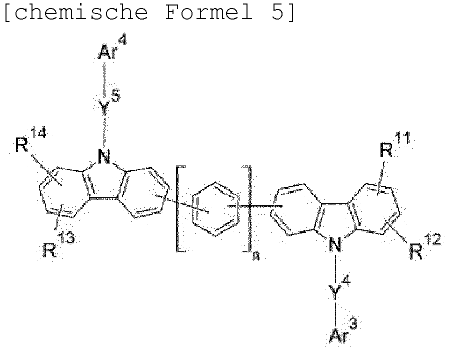
wobei in der chemischen Formel 5
R¹¹ bis R¹⁴ jeweils unabhängig Wasserstoff, Deuterium, eine substituierte oder unsubstituierte C1- bis C30-Alkylgruppe, eine substituierte oder unsubstituierte C6- bis C30-Arylgruppe, eine substituierte oder unsubstituierte C2- bis C30-Heteroarylgruppe oder eine Kombination davon sind,
Y⁴ und Y⁵ jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind,
Ar³ und Ar⁴ jeweils unabhängig Wasserstoff, Deuterium, eine substituierte oder unsubstituierte C1- bis C30-Alkylgruppe, eine substituierte oder unsubstituierte C3- bis C30-Cycloalkylgruppe, eine substituierte oder unsubstituierte C6- bis C30-Arylgruppe, eine substituierte oder unsubstituierte Carbazolylgruppe, eine substituierte oder unsubstituierte Dibenzofuranylgruppe, eine substituierte oder unsubstituierte Dibenzothiophenylgruppe, eine substituierte oder unsubstituierte C6- bis C30-Arylamingruppe, eine substituierte oder unsubstituierte C1- bis C30-Alkoxygruppe, eine substituierte oder unsubstituierte C3- bis C40-Silylgruppe, eine substituierte oder unsubstituierte C1- bis C30-Alkylthiogruppe, eine substituierte oder unsubstituierte C6- bis C30-Arylthiogruppe, ein Halogen, eine halogenhaltige Gruppe, eine Cyanogruppe, eine Hydroxygruppe, eine Aminogruppe, eine Nitrogruppe oder eine Kombination davon sind und
n eine ganze Zahl in dem Bereich von 0 bis 4 ist,
wobei "substituiert" bei den chemischen Formeln 1 bis 5 bedeutet, dass wenigstens ein Wasserstoff durch Deuterium, ein Halogen, eine Hydroxygruppe, eine Aminogruppe, eine substituierte oder unsubstituierte C1- bis C30-Amingruppe, eine Nitrogruppe, eine substituierte oder unsubstituierte C1- bis C40-Silylgruppe, eine C1-bis C30-Alkylgruppe, eine C3- bis C30-Cycloalkylgruppe, eine C2- bis C30-Heterocycloalkylgruppe, eine C6- bis C30-Arylgruppe, eine C2- bis C30-Heteroarylgruppe, eine C1- bis C20-Alkoxygruppe, eine Fluorgruppe, eine C1- bis C10-Trifluoralkylgruppe oder eine Cyanogruppe ersetzt ist.

2. Organische optoelektrische Vorrichtung gemäß Anspruch 1, wobei X¹ der chemischen Formel 1 einer der in Gruppe 2 aufgelisteten Substituenten ist: 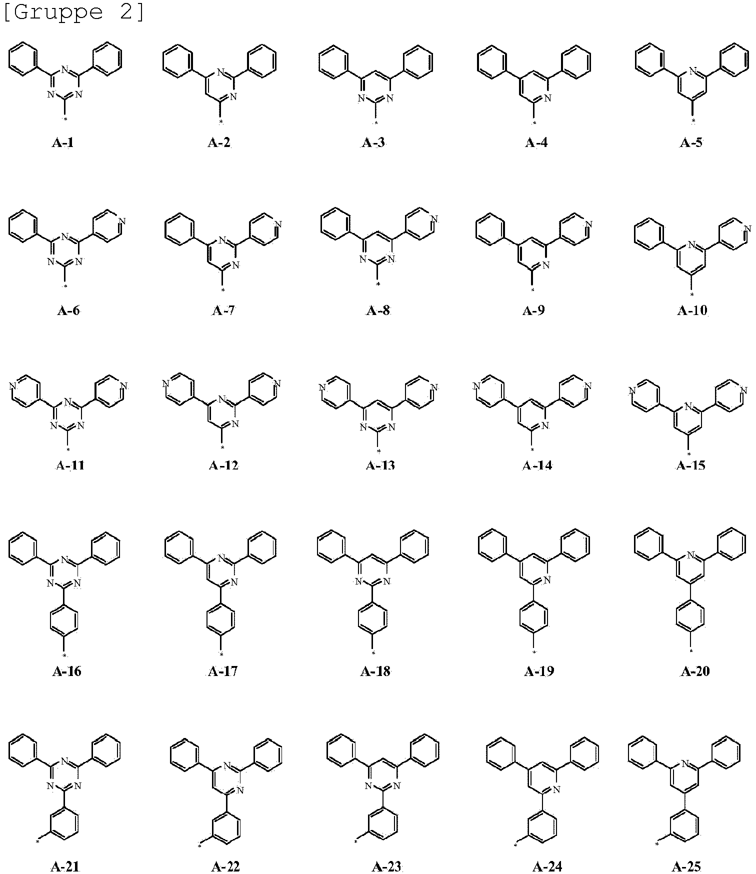 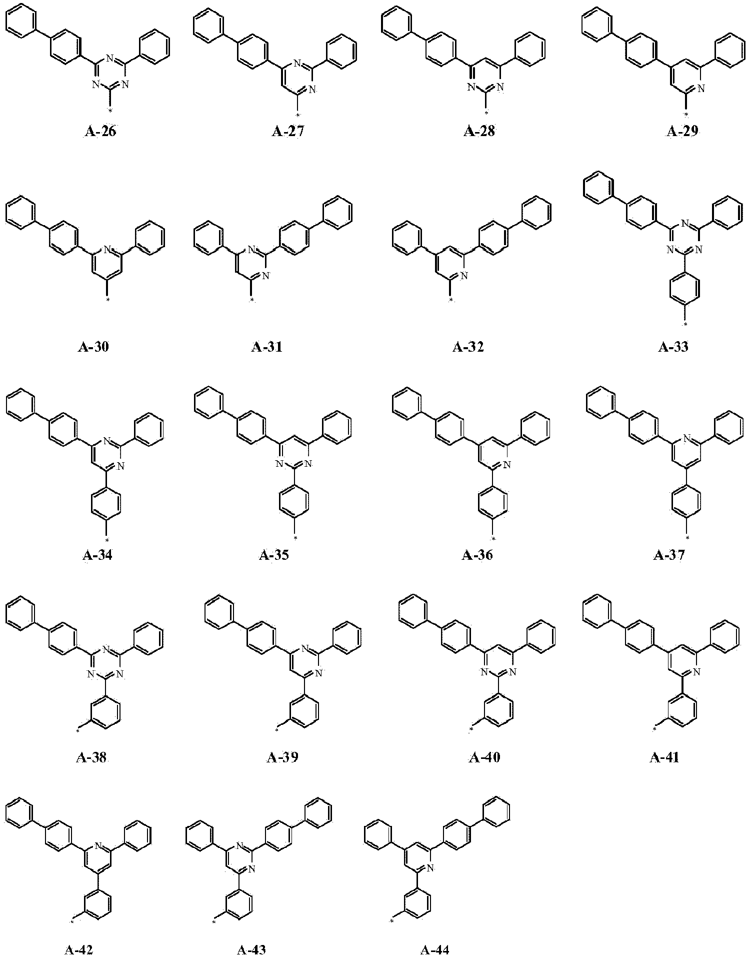 wobei in Gruppe 2
* ein Verknüpfungspunkt ist.

3. Organische optoelektrische Vorrichtung gemäß Anspruch 1 oder 2, wobei die durch die chemische Formel 2 dargestellte Einheit durch eine der chemischen Formeln 2-1 bis 2-3 dargestellt wird: 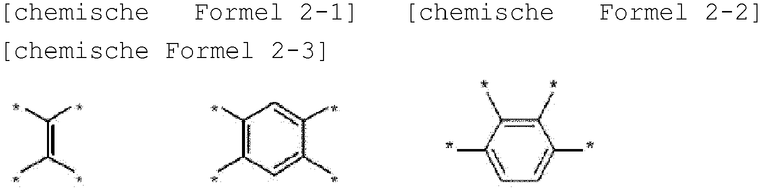 wobei in den chemischen Formeln 2-1 bis 2-3
* ein Verknüpfungspunkt ist.

4. Organische optoelektrische Vorrichtung gemäß einem der Ansprüche 1 bis 3, wobei Ar¹ eine substituierte oder unsubstituierte Phenylgruppe, eine substituierte oder unsubstituierte Biphenylgruppe, eine substituierte oder unsubstituierte Terphenylgruppe, eine substituierte oder unsubstituierte Naphthylgruppe, eine substituierte oder unsubstituierte Anthracenylgruppe, eine substituierte oder unsubstituierte Carbazolylgruppe, eine substituierte oder unsubstituierte Benzofuranylgruppe, eine substituierte oder unsubstituierte Benzothiophenylgruppe, eine substituierte oder unsubstituierte Fluorenylgruppe, eine substituierte oder unsubstituierte Dibenzothiophenylgruppe, eine substituierte oder unsubstituierte Dibenzofuranylgruppe oder eine Kombination davon ist.

5. Organische optoelektrische Vorrichtung gemäß einem der Ansprüche 1 bis 4, wobei X² der chemischen Formel 3 einer der in Gruppe 3 aufgelisteten Substituenten ist: 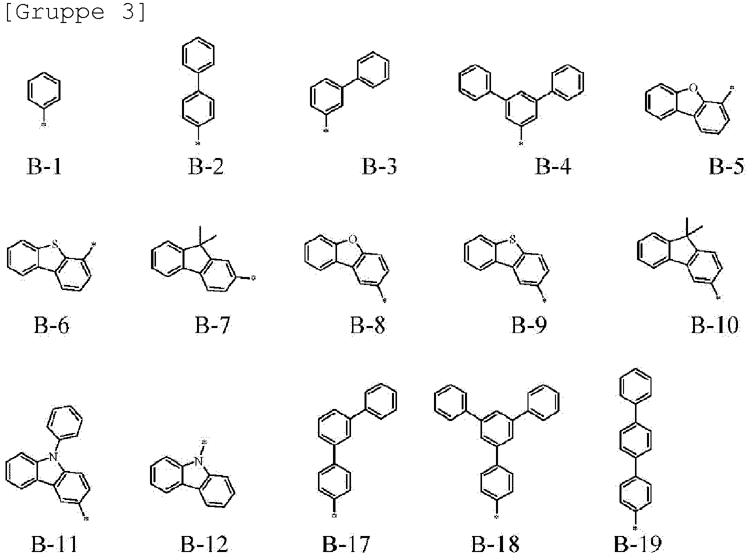 wobei in Gruppe 3 * ein Verknüpfungspunkt ist.

6. Organische optoelektrische Vorrichtung gemäß einem der Ansprüche 1 bis 5, wobei die erste Verbindung einer der in Gruppe 4 aufgelisteten Substituenten ist: 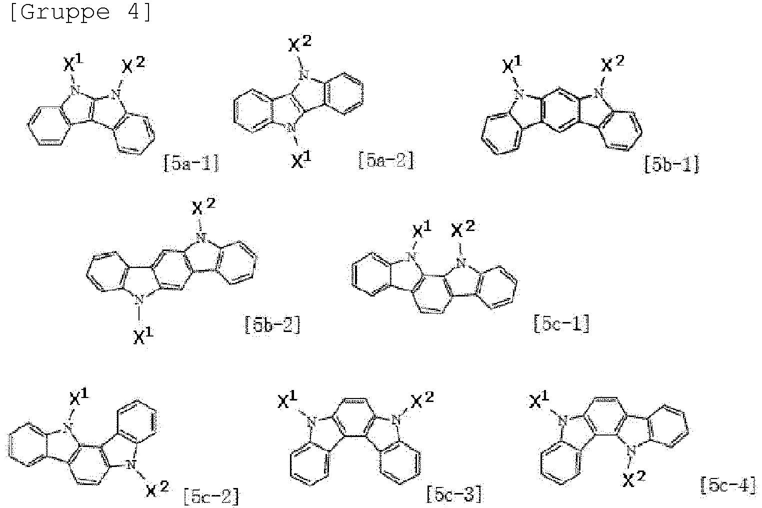 wobei in Gruppe 4
X¹ *-Y¹-ET ist,
X² *-Y²-Ar¹ ist,
Y¹ und Y² jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind,
Ar¹ eine substituierte oder unsubstituierte C6- bis C30-Arylgruppe, eine substituierte oder unsubstituierte C2- bis C30-Heteroarylgruppe oder eine Kombination davon ist,
ET durch die chemische Formel 1a dargestellt wird und
* ein Verknüpfungspunkt ist, 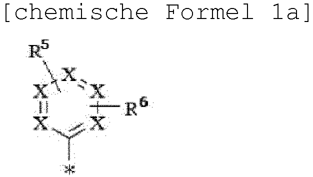
wobei in der chemischen Formel 1a
X N, C oder CR^{a} ist,
wenigstens eines der X N ist,
R⁵, R⁶ und R^{a} jeweils unabhängig Wasserstoff, Deuterium, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe oder eine Kombination davon sind und
* ein Verknüpfungspunkt ist.

7. Organische optoelektrische Vorrichtung gemäß einem der Ansprüche 1 bis 6, wobei
in Gruppe 4 X¹ *-Y¹-ET ist, X² *-Y²-Ar¹ ist,
Y¹ und Y² jeweils unabhängig eine Einfachbindung, eine substituierte oder unsubstituierte C6- bis C30-Arylengruppe oder eine Kombination davon sind,
Ar¹ eine substituierte oder unsubstituierte Phenylgruppe, eine substituierte oder unsubstituierte Biphenylgruppe, eine substituierte oder unsubstituierte Terphenylgruppe, eine substituierte oder unsubstituierte Quaterphenylgruppe, eine substituierte oder unsubstituierte Naphthalenylgruppe, eine substituierte oder unsubstituierte Dibenzofuranylgruppe, eine substituierte oder unsubstituierte Dibenzothiophenylgruppe, eine substituierte oder unsubstituierte Fluorenylgruppe oder eine substituierte oder unsubstituierte Carbazolylgruppe ist,
ET durch die chemische Formel 1a dargestellt wird, 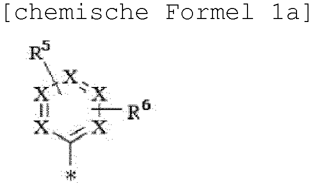 wobei in der chemischen Formel 1a
X N, C oder CR^{a} ist,
wenigstens eines der X N ist,
R⁵, R⁶ und R^{a} jeweils unabhängig Wasserstoff, Deuterium, eine substituierte oder unsubstituierte C1- bis C20-Alkylgruppe, eine substituierte oder unsubstituierte C6- bis C30-Arylgruppe oder eine Kombination davon sind und
* ein Verknüpfungspunkt ist.

8. Organische optoelektrische Vorrichtung gemäß einem der Ansprüche 1 bis 7, wobei die zweite Verbindung durch wenigstens eine der chemischen Formeln 4-1 bis 4-III dargestellt wird: 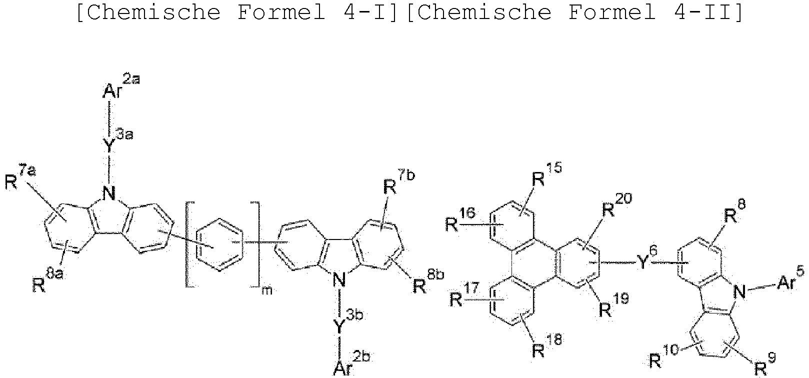 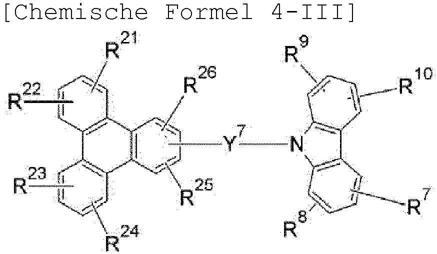 wobei in den chemischen Formeln 4-I bis 4-III
Y^{3a}, Y^{3b}, Y⁶ und Y⁷ jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind,
Ar^{2a}, Ar^{2b} und Ar⁵ jeweils unabhängig eine substituierte oder unsubstituierte C6- bis C30-Arylgruppe, eine substituierte oder unsubstituierte C2- bis C30-Heteroarylgruppe oder eine Kombination davon sind,
R^{7a}, R^{8a}, R^{7b}, R^{8b}, R⁷ bis R¹⁰ und R¹⁵ bis R²⁶ jeweils unabhängig Wasserstoff, Deuterium, eine substituierte oder unsubstituierte C1- bis C20-Alkylgruppe, eine substituierte oder unsubstituierte C6- bis C50-Arylgruppe, eine substituierte oder unsubstituierte C2- bis C50-Heteroarylgruppe oder eine Kombination davon sind und
m eine ganze Zahl von 0 bis 4 ist.

9. Organische optoelektrische Vorrichtung gemäß einem der Ansprüche 1 bis 8, wobei die chemische Formel 4-1 eine der in Gruppe 6 aufgelisteten Strukturen ist und die *-Y^{3a}-Ar^{2a} und *-Y^{3b}-Ar^{2b} eine der in Gruppe 3 aufgelisteten Substituenten sind: 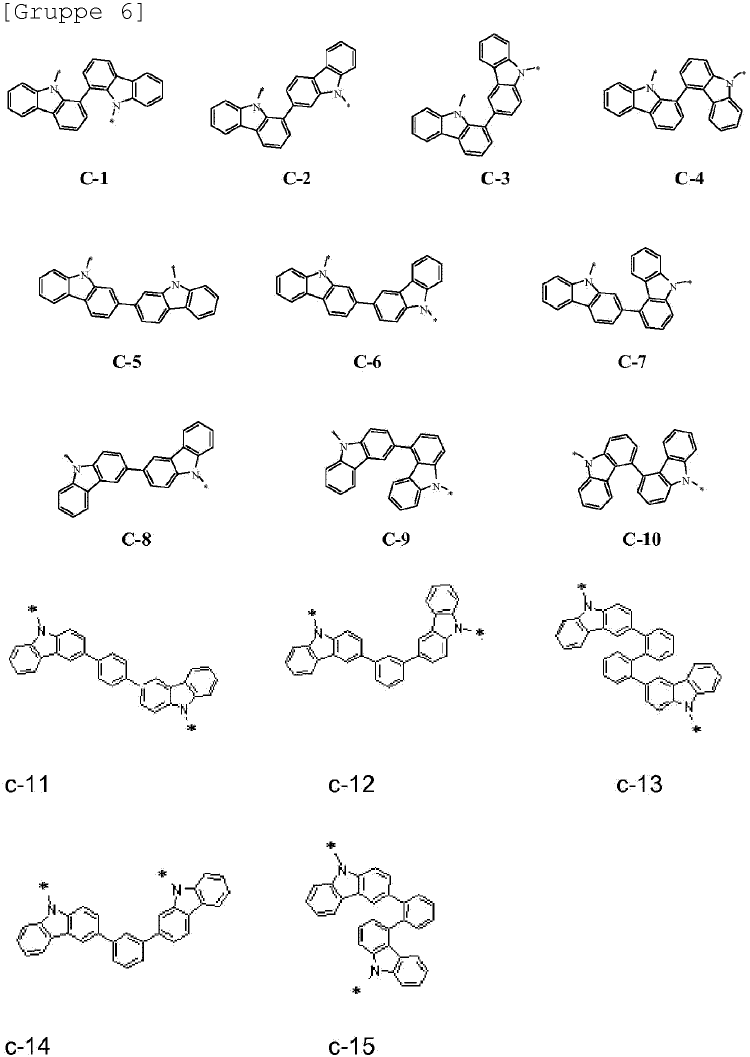 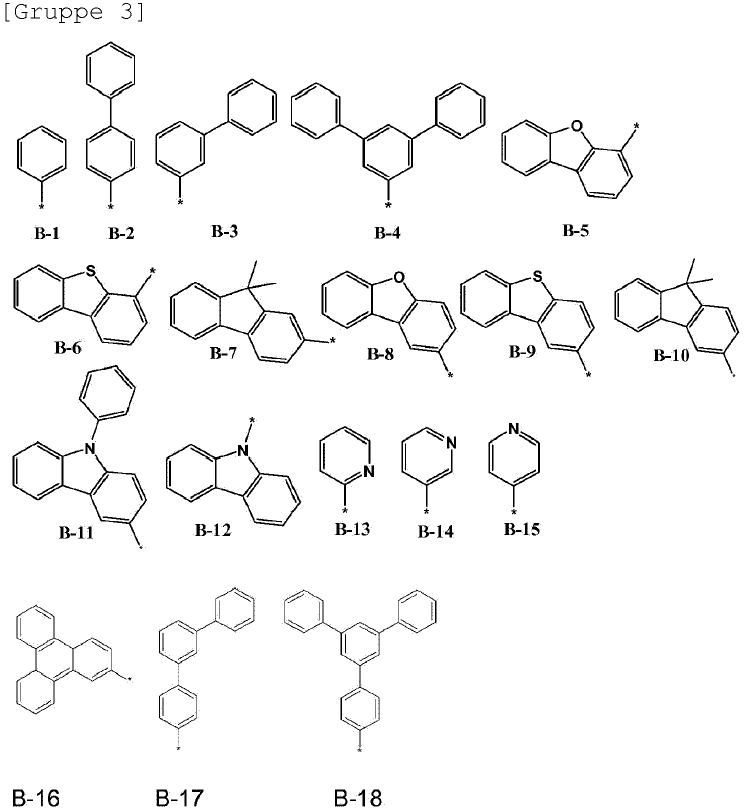 wobei in Gruppe 3 und Gruppe 6 * ein Verknüpfungspunkt ist.

10. Organische optoelektrische Vorrichtung gemäß einem der Ansprüche 1 bis 9, wobei Ar² in der chemischen Formel 4 eine substituierte oder unsubstituierte Phenylgruppe, eine substituierte oder unsubstituierte Biphenylgruppe, eine substituierte oder unsubstituierte Terphenylgruppe, eine substituierte oder unsubstituierte Naphthylgruppe, eine substituierte oder unsubstituierte Anthracenylgruppe, eine substituierte oder unsubstituierte Carbazolylgruppe, eine substituierte oder unsubstituierte Benzofuranylgruppe, eine substituierte oder unsubstituierte Benzothiophenylgruppe, eine substituierte oder unsubstituierte Fluorenylgruppe, eine substituierte oder unsubstituierte Dibenzofuranylgruppe, eine substituierte oder unsubstituierte Dibenzothiophenylgruppe, eine substituierte oder unsubstituierte Pyridinylgruppe, eine substituierte oder unsubstituierte Pyrimidinylgruppe oder eine Kombination davon ist.

11. Organische optoelektrische Vorrichtung gemäß einem der Ansprüche 1 bis 10, wobei die dritte Verbindung durch wenigstens eine der chemischen Formeln 5-1 bis 5-VII dargestellt wird: 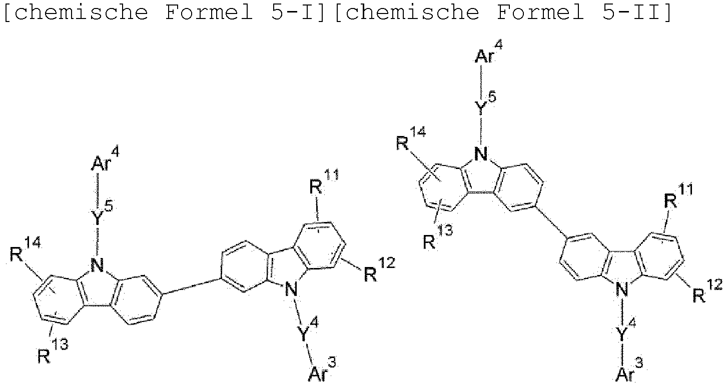 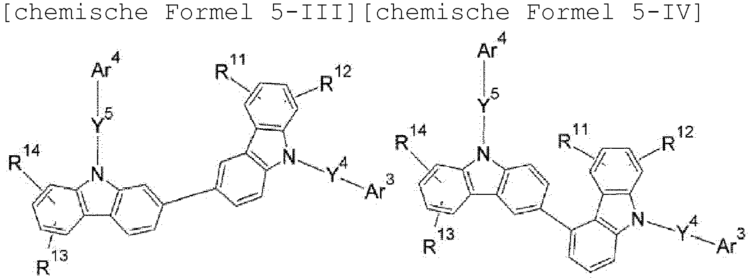 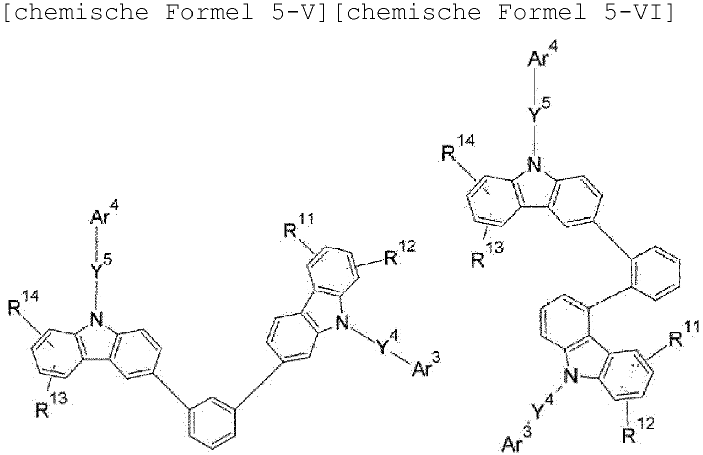 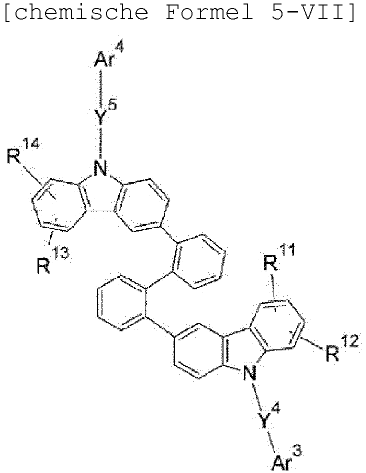 wobei in der chemischen Formel 5-1 bis zu der chemischen Formel 5-VII
R¹¹ bis R¹⁴ jeweils unabhängig Wasserstoff, Deuterium, eine substituierte oder unsubstituierte C1- bis C30-Alkylgruppe, eine substituierte oder unsubstituierte C6- bis C30-Arylgruppe, eine substituierte oder unsubstituierte C2- bis C30-Heteroarylgruppe oder eine Kombination davon sind, Y⁴ und Y⁵ jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind,
Ar³ und Ar⁴ jeweils unabhängig eine substituierte oder unsubstituierte Phenylgruppe, eine substituierte oder unsubstituierte Biphenylgruppe, eine substituierte oder unsubstituierte Terphenylgruppe, eine substituierte oder unsubstituierte Quarterphenylgruppe, eine substituierte oder unsubstituierte Fluorenylgruppe, eine substituierte oder unsubstituierte Dibenzofuranylgruppe, eine substituierte oder unsubstituierte Dibenzothiophenylgruppe, eine substituierte oder unsubstituierte Triphenylenylgruppe oder eine Kombination davon sind,
wobei "substituiert" bei den chemischen Formeln 5-I bis 5-VII bedeutet, dass wenigstens ein Wasserstoff durch Deuterium, ein Halogen, eine Hydroxygruppe, eine Aminogruppe, eine C1- bis C30-Amingruppe, eine Nitrogruppe, eine C1- bis C40-Silylgruppe, eine C1- bis C30-Alkylgruppe, eine C1- bis C10-Alkylsilylgruppe, eine C3- bis C30-Cycloalkylgruppe, eine C2- bis C30-Heterocycloalkylgruppe, eine C6- bis C30-Arylgruppe, eine C2- bis C30-Heteroarylgruppe, eine C1- bis C20-Alkoxygruppe, eine Fluorgruppe, eine C1- bis C10-Trifluoralkylgruppe oder eine Cyanogruppe ersetzt ist.

12. Organische optoelektrische Vorrichtung gemäß einem der Ansprüche 1 bis 11, wobei die Ar³ und Ar⁴ jeweils unabhängig ausgewählt sind aus substituierten oder unsubstituierten Gruppen, die in Gruppe 8 aufgelistet sind: 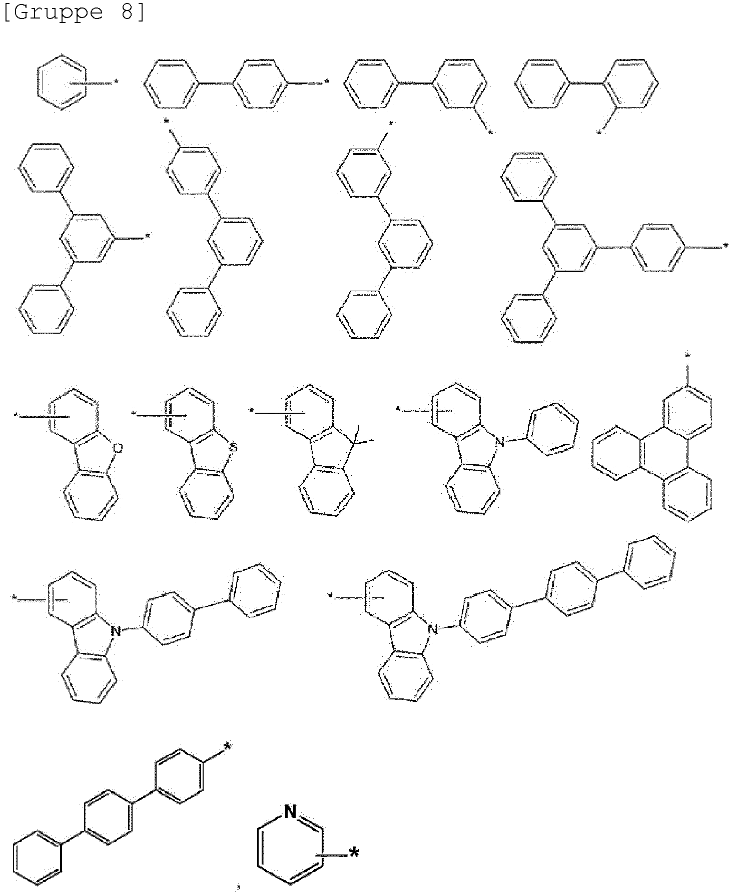 wobei in Gruppe 8 * ein Verknüpfungspunkt ist.

13. Organische optoelektrische Vorrichtung gemäß einem der Ansprüche 1 bis 12, wobei die Emissionsschicht wenigstens eine der in Gruppe 4 aufgelisteten ersten Verbindungen und
wenigstens eine der durch die chemischen Formeln 4-1 und 4-II dargestellten zweiten Verbindungen umfasst und
die Löchertransport-Hilfsschicht wenigstens eine der durch die chemischen Formeln 5-II, 5-III und 5-V dargestellten dritten Verbindungen umfasst: 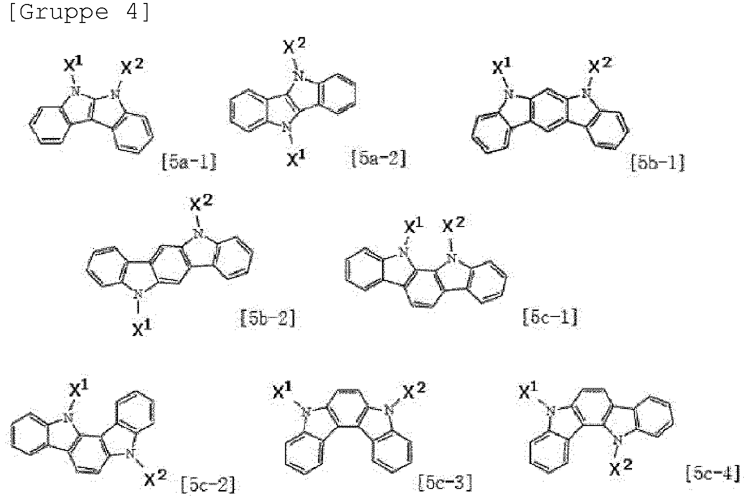 wobei in Gruppe 4 X¹ *-Y¹-ET ist, X² *-Y²-Ar¹ ist, wobei Y¹ und Y² jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind, Ar¹ eine substituierte oder unsubstituierte C6- bis C30-Arylgruppe, eine substituierte oder unsubstituierte C2- bis C30-Heteroarylgruppe oder eine Kombination davon ist und ET durch die chemische Formel 1a dargestellt wird, 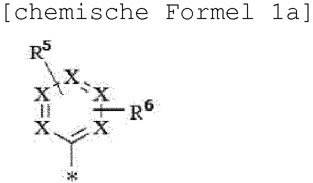 wobei in der chemischen Formel 1a
X N, C oder CR^{a} ist,
wenigstens eines der X N ist,
R⁵, R⁶ und R^{a} jeweils unabhängig Wasserstoff, Deuterium, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe oder eine Kombination davon sind und * ein Verknüpfungspunkt ist, 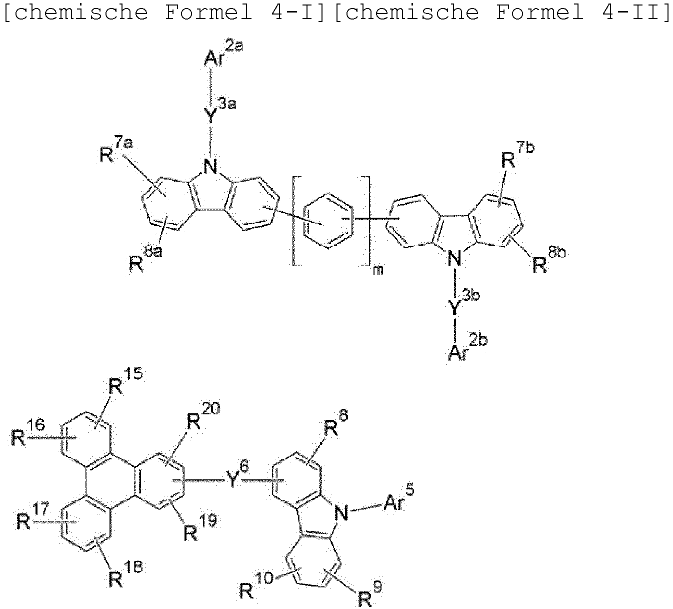
wobei in den chemischen Formeln 4-1 und 4-II Y^{3a}, Y^{3b}, Y⁶ und Y⁷ jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind,
Ar^{2a}, Ar^{2b} und Ar⁵ jeweils unabhängig eine substituierte oder unsubstituierte C6- bis C30-Arylgruppe, eine substituierte oder unsubstituierte C2- bis C30-Heteroarylgruppe oder eine Kombination davon sind,
R^{7a}, R^{8a}, R^{7b}, R^{8b}, R⁷ bis R¹⁰ und R¹⁵ bis R²⁶ jeweils unabhängig Wasserstoff, Deuterium, eine substituierte oder unsubstituierte C1- bis C20-Alkylgruppe, eine substituierte oder unsubstituierte C6- bis C50-Arylgruppe, eine substituierte oder unsubstituierte C2- bis C50-Heteroarylgruppe oder eine Kombination davon sind und
m eine ganze Zahl von 0 bis 4 ist, 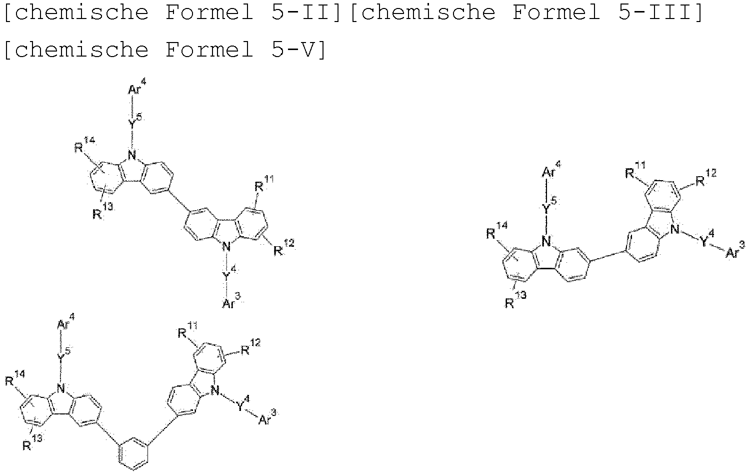
wobei in den chemischen Formeln 5-II, 5-III und 5-V
R¹¹ bis R¹⁴ jeweils unabhängig Wasserstoff, Deuterium, eine substituierte oder unsubstituierte C1- bis C30-Alkylgruppe, eine substituierte oder unsubstituierte C6- bis C30-Arylgruppe, eine substituierte oder unsubstituierte C2- bis C30-Heteroarylgruppe oder eine Kombination davon sind und
Y⁴ und Y⁵ jeweils unabhängig eine Einfachbindung, eine substituierte oder unsubstituierte C6- bis C30-Arylengruppe, eine substituierte oder unsubstituierte C2- bis C30-Heteroarylengruppe oder eine Kombination davon sind,
Ar³ und Ar⁴ jeweils unabhängig eine substituierte oder unsubstituierte Phenylgruppe, eine substituierte oder unsubstituierte Biphenylgruppe, eine substituierte oder unsubstituierte Terphenylgruppe, eine substituierte oder unsubstituierte Quarterphenylgruppe, eine substituierte oder unsubstituierte Fluorenylgruppe, eine substituierte oder unsubstituierte Dibenzofuranylgruppe, eine substituierte oder unsubstituierte Dibenzothiophenylgruppe, eine substituierte oder unsubstituierte Triphenylenylgruppe oder eine Kombination davon sind.

14. Organische optoelektrische Vorrichtung gemäß einem der Ansprüche 1 bis 13, wobei die Löchertransport-Hilfsschicht in Kontakt mit der Löchertransportschicht und der Emissionsschicht steht.

15. Anzeigevorrichtung, umfassend die organische optoelektrische Vorrichtung gemäß einem der Ansprüche 1 bis 14.

## Revendications

1. Dispositif optoélectrique organique comprenant
une anode (10) et une cathode (20) se faisant face,
une couche d'émission (32) entre l'anode (10) et la cathode (20),
une couche de transport de trous (31) entre l'anode (10) et la couche d'émission (32), et
une couche auxiliaire de transport de trous (33) entre la couche de transport de trous (31) et la couche d'émission (32),
la couche d'émission (32) comprenant au moins un d'un premier composé comportant des groupements représentés par les formules chimiques 1 à 3 liés en séquence et au moins un d'un deuxième composé représenté par la formule chimique 4, et
la couche auxiliaire de transport de trous (33) comprenant au moins un d'un troisième composé représenté par la formule chimique 5 : 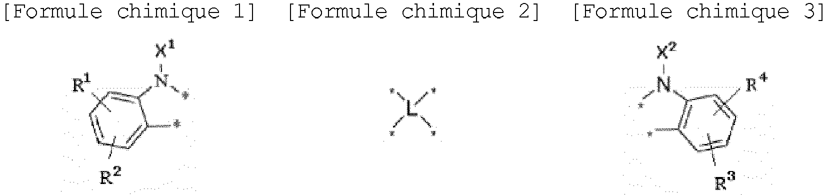 dans lequel, dans les formules chimiques 1 à 3,
X¹ représente *-Y¹-ET,
X² représente *-Y²-Ar¹,
Y¹ et Y² représentent chacun indépendamment une simple liaison, un groupe arylène en C6 à C30 substitué ou non substitué, un groupe hétéroarylène en C2 à C30 substitué ou non substitué, ou une combinaison de ceux-ci,
Ar¹ représente un groupe aryle en C6 à C30 substitué ou non substitué, un groupe hétéroaryle en C2 à C30 substitué ou non substitué, ou une combinaison de ceux-ci,
L représente un groupe alcénylène en C2 ou C3 substitué ou non substitué ou un groupe arylène en C6 à C20 substitué ou non substitué,
R¹ à R⁴ représentent chacun indépendamment l'hydrogène, le deutérium, un groupe alkyle en C1 à C20 substitué ou non substitué, un groupe aryle en C6 à C30 substitué ou non substitué, un groupe hétéroaryle en C2 à C30 substitué ou non substitué, ou une combinaison de ceux-ci,
ET est représenté par la formule chimique 1a, et
* représente un point de liaison, 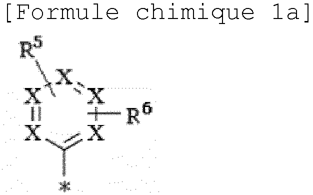
dans lequel, dans la formule chimique 1a,
X représente N, C ou CR^{a},
au moins un des X représente N,
R⁵, R⁶ et R^{a} représentent chacun indépendamment l'hydrogène, le deutérium, un groupe alkyle en C1 à C20 substitué ou non substitué, un groupe aryle en C6 à C30 substitué ou non substitué, un groupe hétéroaryle en C2 à C30 substitué ou non substitué, ou une combinaison de ceux-ci, et
* représente un point de liaison, 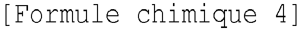 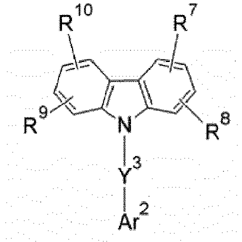
dans lequel, dans la formule chimique 4,
Y³ représente une simple liaison, un groupe arylène en C6 à C30 substitué ou non substitué, un groupe hétéroarylène en C2 à C30 substitué ou non substitué, ou une combinaison de ceux-ci,
Ar² représente un groupe aryle en C6 à C30 substitué ou non substitué, un groupe hétéroaryle en C2 à C30 substitué ou non substitué, ou une combinaison de ceux-ci,
R⁷ à R¹⁰ représentent chacun indépendamment l'hydrogène, le deutérium, un groupe alkyle en C1 à C20 substitué ou non substitué, un groupe aryle en C6 à C50 substitué ou non substitué, un groupe hétéroaryle en C2 à C50 substitué ou non substitué, ou une combinaison de ceux-ci, et
au moins un de R⁷ à R¹⁰ et Ar² comporte un groupe triphénylène substitué ou non substitué ou un groupe carbazolyle substitué ou non substitué, 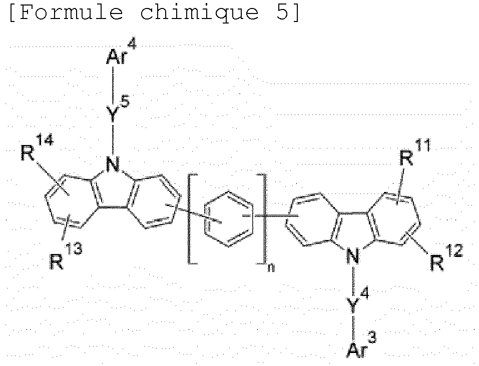
dans lequel, dans la formule chimique 5,
R¹¹ à R¹⁴ représentent chacun indépendamment l'hydrogène, le deutérium, un groupe alkyle en C1 à C30 substitué ou non substitué, un groupe aryle en C6 à C30 substitué ou non substitué, un groupe hétéroaryle en C2 à C30 substitué ou non substitué, ou une combinaison de ceux-ci,
Y⁴ et Y⁵ représentent chacun indépendamment une simple liaison, un groupe arylène en C6 à C30 substitué ou non substitué, un groupe hétéroarylène en C2 à C30 substitué ou non substitué, ou une combinaison de ceux-ci,
Ar³ et Ar⁴ représentent chacun indépendamment l'hydrogène, le deutérium, un groupe alkyle en C1 à C30 substitué ou non substitué, un groupe cycloalkyle en C3 à C30 substitué ou non substitué, un groupe aryle en C6 à C30 substitué ou non substitué, un groupe carbazolyle substitué ou non substitué, un groupe dibenzofuranyle substitué ou non substitué, un groupe dibenzothiophényle substitué ou non substitué, un groupe arylamine en C6 à C30 substitué ou non substitué, un groupe alcoxy en C1 à C30 substitué ou
non substitué, un groupe silyle en C3 à C40 substitué ou non substitué, un groupe alkylthiol en C1 à C30 substitué ou non substitué, un groupe arylthiol en C6 à C30 substitué ou non substitué, un halogène, un groupe contenant un halogène, un groupe cyano, un groupe hydroxyle, un groupe amino, un groupe nitro, ou une combinaison de ceux-ci, et
n représente un entier allant de 0 à 4,
dans lequel le « substitué » des formules chimiques 1 à 5 renvoie au fait qu'au moins un hydrogène est remplacé par le deutérium, un halogène, un groupe hydroxyle, un groupe amino, un groupe amine en C1 à C30 substitué ou non substitué, un groupe nitro, un groupe silyle en C1 à C40 substitué ou non substitué, un groupe alkyle en C1 à C30, un groupe cycloalkyle en C3 à C30, un groupe hétérocycloalkyle en C2 à C30, un groupe aryle en C6 à C30, un groupe hétéroaryle en C2 à C30, un groupe alcoxy en C1 à C20, un groupe fluoro, un groupe trifluoroalkyle en C1 à C10, ou un groupe cyano.

2. Dispositif optoélectrique organique de la revendication 1, dans lequel le X¹ de la formule chimique 1 est un des substituants répertoriés dans le groupe 2 : 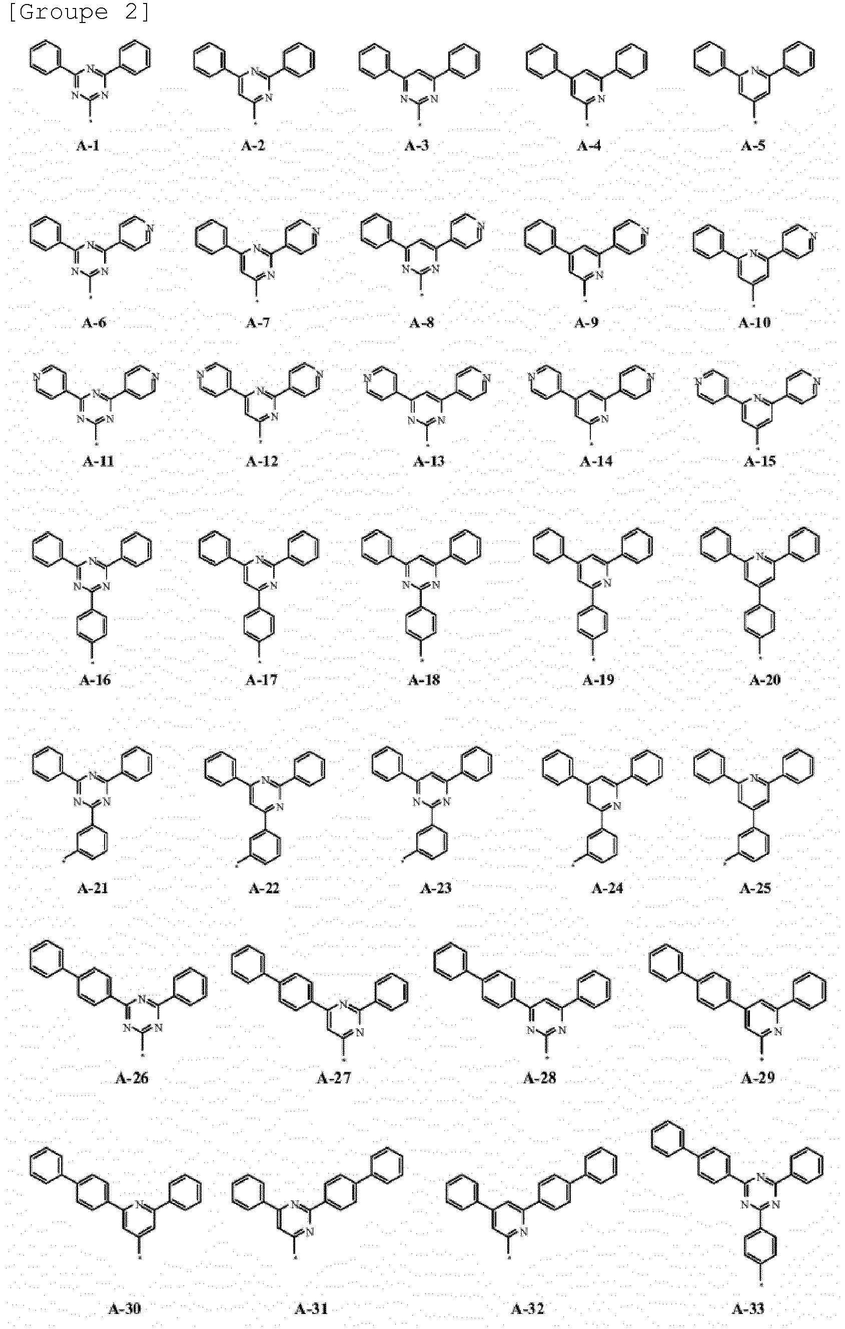 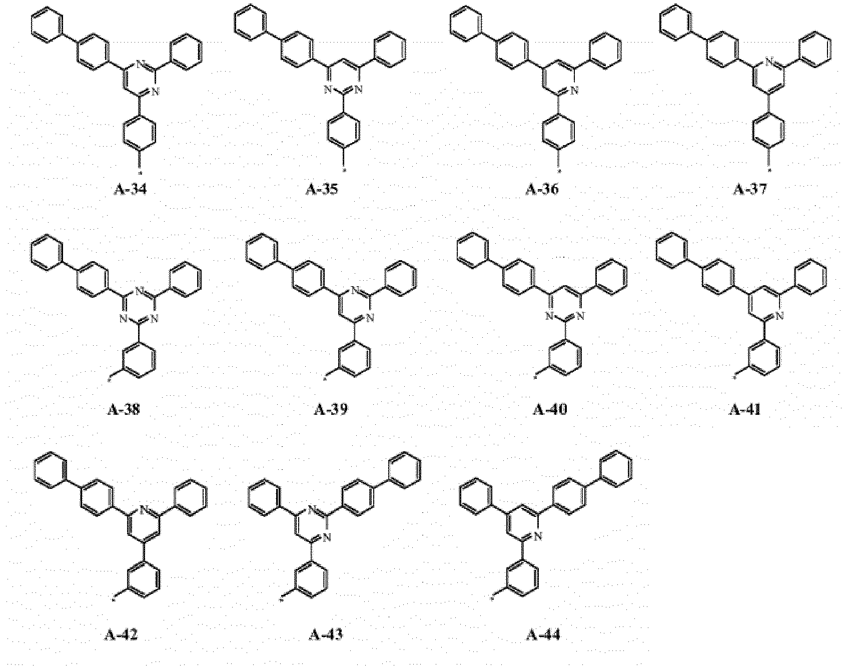 dans lequel, dans le groupe 2,
* représente un point de liaison.

3. Dispositif optoélectrique organique de la revendication 1 ou 2, dans lequel le groupement représenté par la formule chimique 2 est représenté par une des formules chimiques 2-1 à 2-3 : 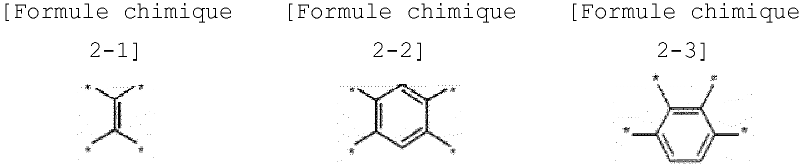 dans lequel, dans les formules chimiques 2-1 à 2-3,
* représente un point de liaison.

4. Dispositif optoélectrique organique de l'une quelconque des revendications 1 à 3, dans lequel Ar¹ représente un groupe phényle substitué ou non substitué, un groupe biphényle substitué ou non substitué, un groupe terphényle substitué ou non substitué, un groupe naphtyle substitué ou non substitué, un groupe anthracényle substitué ou non substitué, un groupe carbazolyle substitué ou non substitué, un groupe benzofuranyle substitué ou non substitué, un groupe benzothiophényle substitué ou non substitué, un groupe fluorényle substitué ou non substitué, un groupe dibenzothiophényle substitué ou non substitué, un groupe dibenzofuranyle substitué ou non substitué, ou une combinaison de ceux-ci.

5. Dispositif optoélectrique organique de l'une quelconque des revendications 1 à 4, dans lequel le X² de la formule chimique 3 est un des substituants répertoriés dans le groupe 3 : 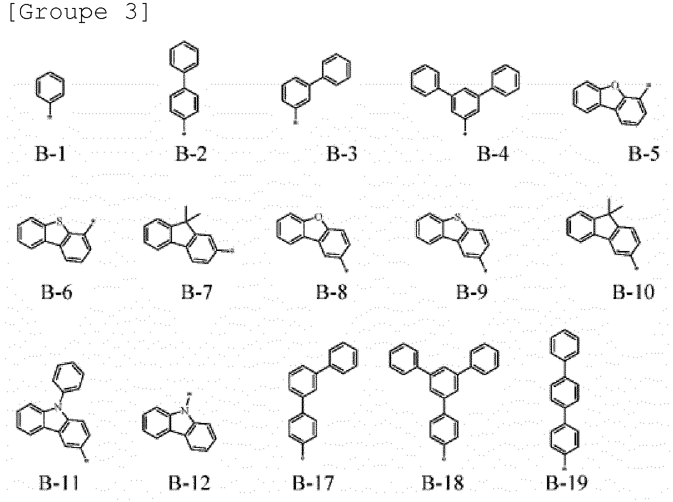 dans lequel, dans le groupe 3, * représente un point de liaison.

6. Dispositif optoélectrique organique de l'une quelconque des revendications 1 à 5, dans lequel le premier composé est un des substituants répertoriés dans le groupe 4 : 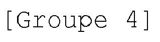 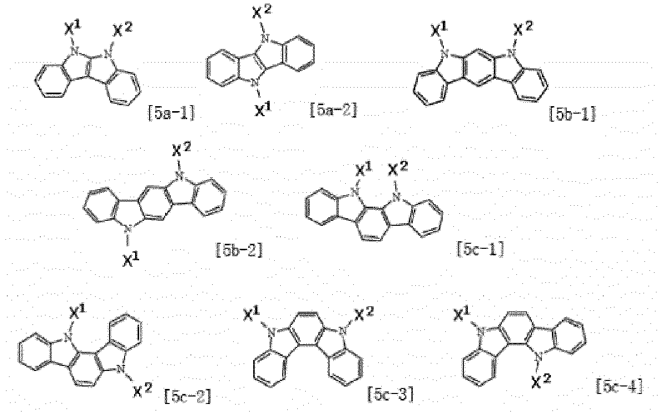 dans lequel, dans le groupe 4,
X¹ représente *-Y¹-ET,
X² représente *-Y²-Ar¹,
Y¹ et Y² représentent chacun indépendamment une simple liaison, un groupe arylène en C6 à C30 substitué ou non substitué, un groupe hétéroarylène en C2 à C30 substitué ou non substitué, ou une combinaison de ceux-ci,
Ar¹ représente un groupe aryle en C6 à C30 substitué ou non substitué, un groupe hétéroaryle en C2 à C30 substitué ou non substitué, ou une combinaison de ceux-ci,
ET est représenté par la formule chimique 1a, et
* représente un point de liaison, 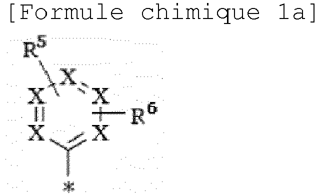
dans lequel, dans la formule chimique 1a,
X représente N, C ou CR^{a},
au moins un des X représente N,
R⁵, R⁶ et R^{a} représentent chacun indépendamment l'hydrogène, le deutérium, un groupe alkyle en C1 à C20 substitué ou non substitué, un groupe aryle en C6 à C30 substitué ou non substitué, un groupe hétéroaryle en C2 à C30 substitué ou non substitué, ou une combinaison de ceux-ci, et
* représente un point de liaison.

7. Dispositif optoélectrique organique de l'une quelconque des revendications 1 à 6, dans lequel, dans le groupe 4, X¹ représente *-Y¹-ET, X² représente *-Y²-Ar¹,
Y¹ et Y² représentent chacun indépendamment une simple liaison, un groupe arylène en C6 à C30 substitué ou non substitué, ou une combinaison de ceux-ci,
Ar¹ représente un groupe phényle substitué ou non substitué, un groupe biphényle substitué ou non substitué, un groupe terphényle substitué ou non substitué, un groupe quaterphényle substitué ou non substitué, un groupe naphtalényle substitué ou non substitué, un groupe dibenzofuranyle substitué ou non substitué, un groupe dibenzothiophényle substitué ou non substitué, un groupe fluorényle substitué ou non substitué, ou un groupe carbazolyle substitué ou non substitué,
ET est représenté par la formule chimique 1a, 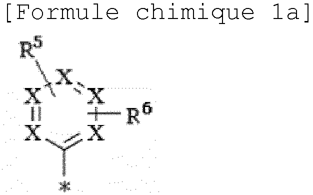 dans lequel, dans la formule chimique 1a,
X représente N, C ou CR^{a},
au moins un des X représente N,
R⁵, R⁶ et R^{a} représentent chacun indépendamment l'hydrogène, le deutérium, un groupe alkyle en C1 à C20 substitué ou non substitué, un groupe aryle en C6 à C30 substitué ou non substitué, ou une combinaison de ceux-ci, et
* représente un point de liaison.

8. Dispositif optoélectrique organique de l'une quelconque des revendications 1 à 7, dans lequel le deuxième composé est représenté par au moins une des formules chimiques 4-1 à 4-III : 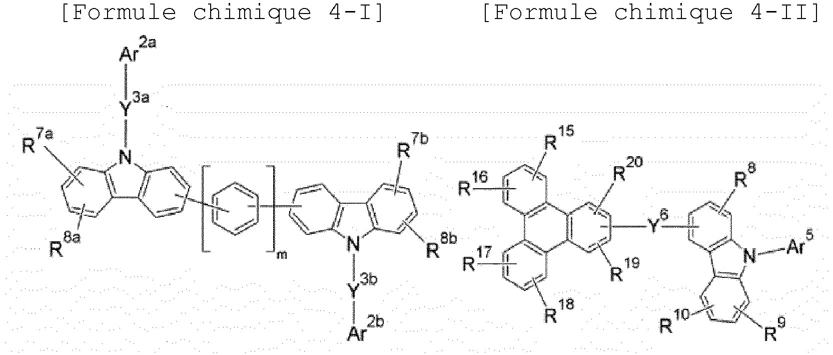 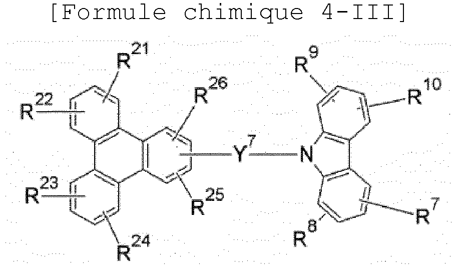
dans lequel, dans les formules chimiques 4-1 à 4-III, Y^{3a}, Y^{3b}, Y⁶ et Y⁷ représentent chacun indépendamment une simple liaison, un groupe arylène en C6 à C30 substitué ou non substitué, un groupe hétéroarylène en C2 à C30 substitué ou non substitué, ou une combinaison de ceux-ci,
Ar^{2a}, Ar^{2b} et Ar⁵ représentent chacun indépendamment un groupe aryle en C6 à C30 substitué ou non substitué, un groupe hétéroaryle en C2 à C30 substitué ou non substitué, ou une combinaison de ceux-ci, R^{7a}, R^{8a}, R^{7b}, R^{8b}, R⁷ à R¹⁰, et R¹⁵ à R²⁶ représentent chacun indépendamment l'hydrogène, le deutérium, un groupe alkyle en C1 à C20 substitué ou non substitué, un groupe aryle en C6 à C50 substitué ou non substitué, un groupe hétéroaryle en C2 à C50 substitué ou non substitué, ou une combinaison de ceux-ci, et
m représente un entier de 0 à 4.

9. Dispositif optoélectrique organique de l'une quelconque des revendications 1 à 8, dans lequel la formule chimique 4-1 est une des structures répertoriées dans le groupe 6, et *-Y^{3a}-Ar^{2a} et *-Y^{3b}-Ar^{2b} sont un des substituants répertoriés dans le groupe 3 : 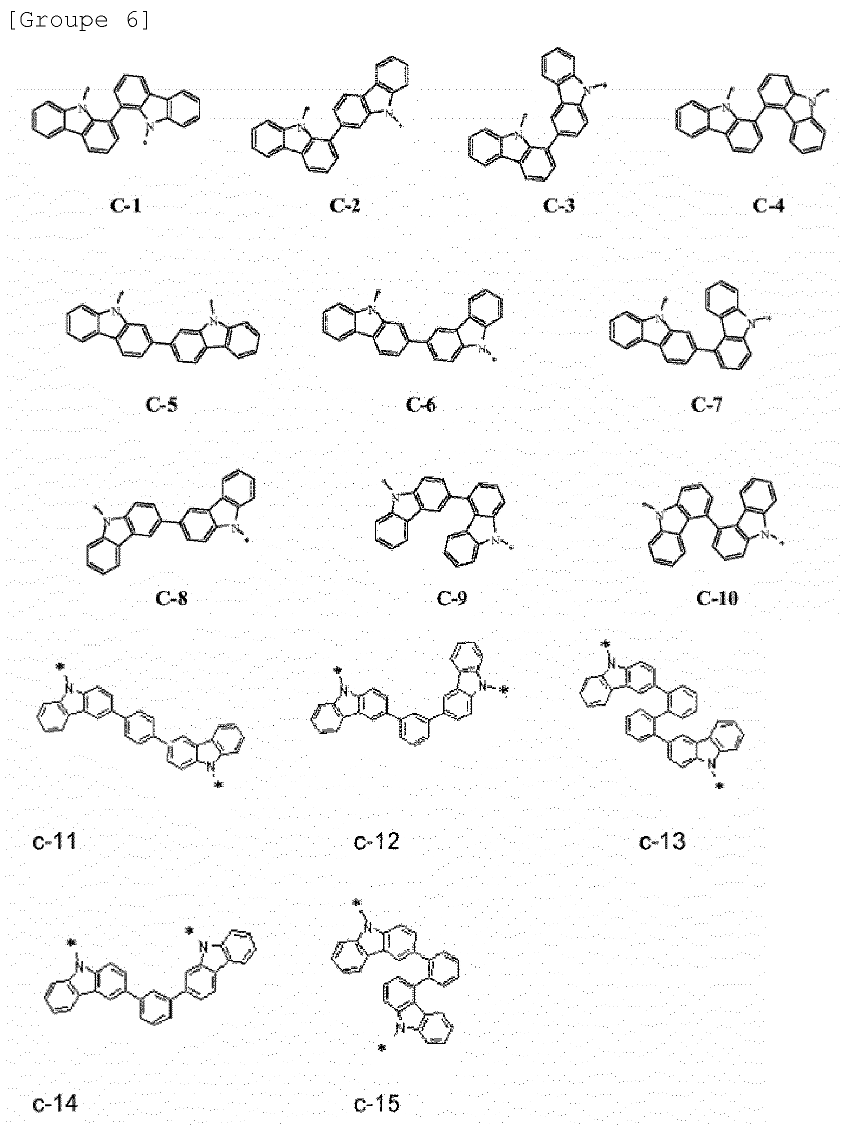 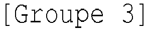 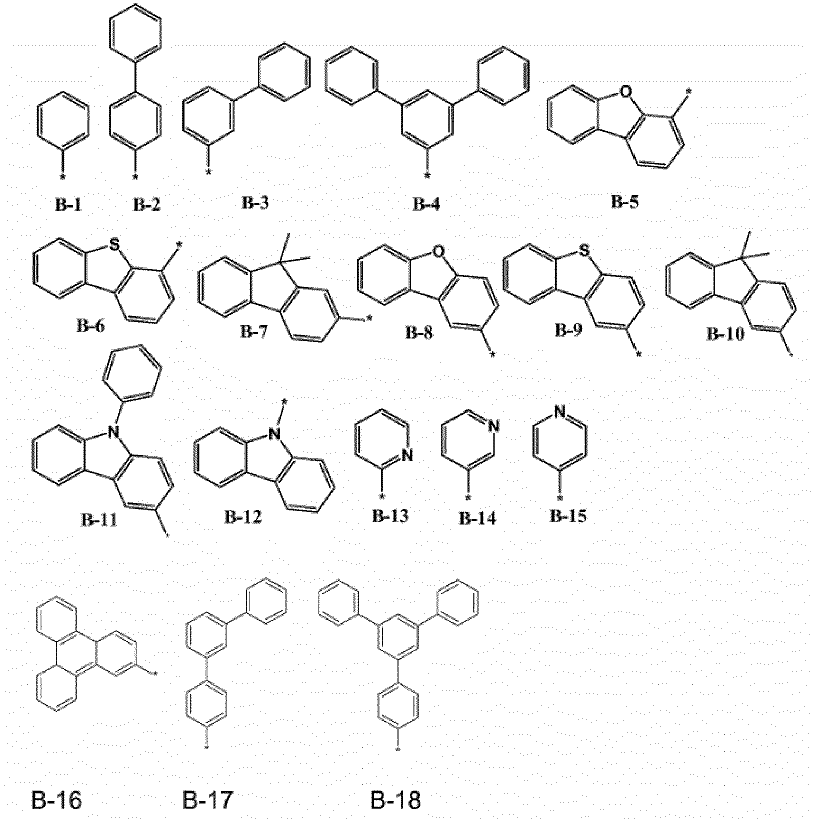 dans lequel, dans le groupe 3 et le groupe 6, * représente un point de liaison.

10. Dispositif optoélectrique organique de l'une quelconque des revendications 1 à 9, dans lequel l'Ar² de la formule chimique 4 représente un groupe phényle substitué ou non substitué, un groupe biphényle substitué ou non substitué, un groupe terphényle substitué ou non substitué, un groupe naphtyle substitué ou non substitué, un groupe anthracényle substitué ou non substitué, un groupe carbazolyle substitué ou non substitué, un groupe benzofuranyle substitué ou non substitué, un groupe benzothiophényle substitué ou non substitué, un groupe fluorényle substitué ou non substitué, un groupe dibenzofuranyle substitué ou non substitué, un groupe dibenzothiophényle substitué ou non substitué, un groupe pyridinyle substitué ou non substitué, un groupe pyrimidinyle substitué ou non substitué, ou une combinaison de ceux-ci.

11. Dispositif optoélectrique organique de l'une quelconque des revendications 1 à 10, dans lequel le troisième composé est représenté par au moins une des formules chimiques 5-1 à 5-VII : 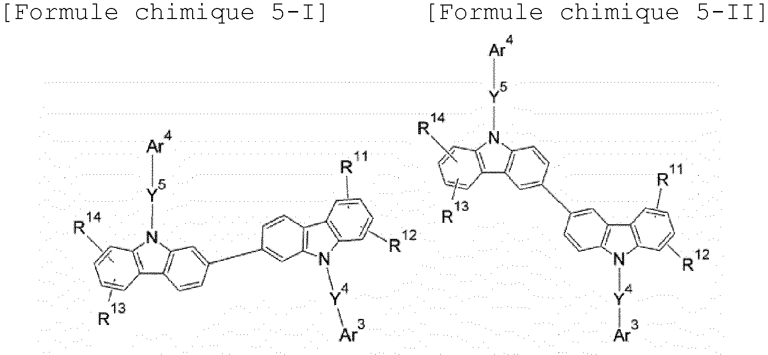 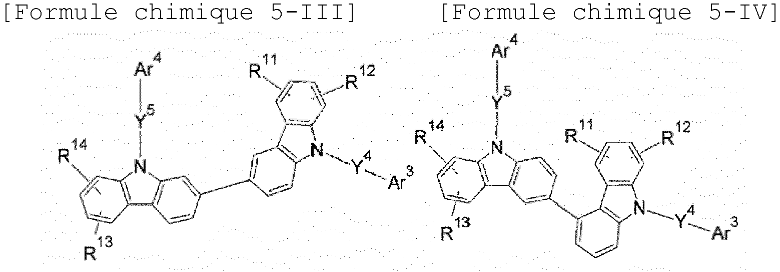 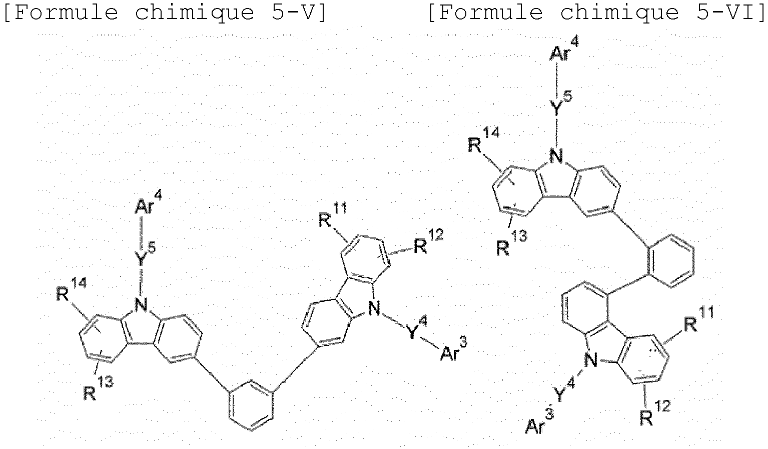 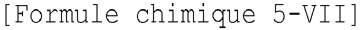 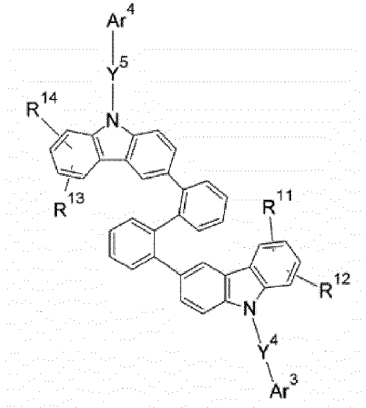 dans lequel, dans la formule chimique 5-1 à la formule chimique 5-VII,
R¹¹ à R¹⁴ représentent chacun indépendamment l'hydrogène, le deutérium, un groupe alkyle en C1 à C30 substitué ou non substitué, un groupe aryle en C6 à C30 substitué ou non substitué, un groupe hétéroaryle en C2 à C30 substitué ou non substitué, ou une combinaison de ceux-ci,
Y⁴ et Y⁵ représentent chacun indépendamment une simple liaison, un groupe arylène en C6 à C30 substitué ou non substitué, un groupe hétéroarylène en C2 à C30 substitué ou non substitué, ou une combinaison de ceux-ci,
Ar³ et Ar⁴ représentent chacun indépendamment un groupe phényle substitué ou non substitué, un groupe biphényle substitué ou non substitué, un groupe terphényle substitué ou non substitué, un groupe quaterphényle substitué ou non substitué, un groupe fluorényle substitué ou non substitué, un groupe dibenzofuranyle substitué ou non substitué, un groupe dibenzothiophényle substitué ou non substitué, un groupe triphénylényle substitué ou non substitué, ou une combinaison de ceux-ci, et
dans lequel le « substitué » des formules chimiques 5-1 à 5-VII renvoie au fait qu'au moins un hydrogène est remplacé par le deutérium, un halogène, un groupe hydroxyle, un groupe amino, un groupe amine en C1 à C30, un groupe nitro, un groupe silyle en C1 à C40, un groupe alkyle en C1 à C30, un groupe alkylsilyle en C1 à C10, un groupe cycloalkyle en C3 à C30, un groupe hétérocycloalkyle en C2 à C30, un groupe aryle en C6 à C30, un groupe hétéroaryle en C2 à C30, un groupe alcoxy en C1 à C20, un groupe fluoro, un groupe trifluoroalkyle en C1 à C10, ou un groupe cyano.

12. Dispositif optoélectrique organique de l'une quelconque des revendications 1 à 11, dans lequel Ar³ et Ar⁴ sont chacun indépendamment choisis parmi les groupes substitués ou non substitués répertoriés dans le groupe 8 : 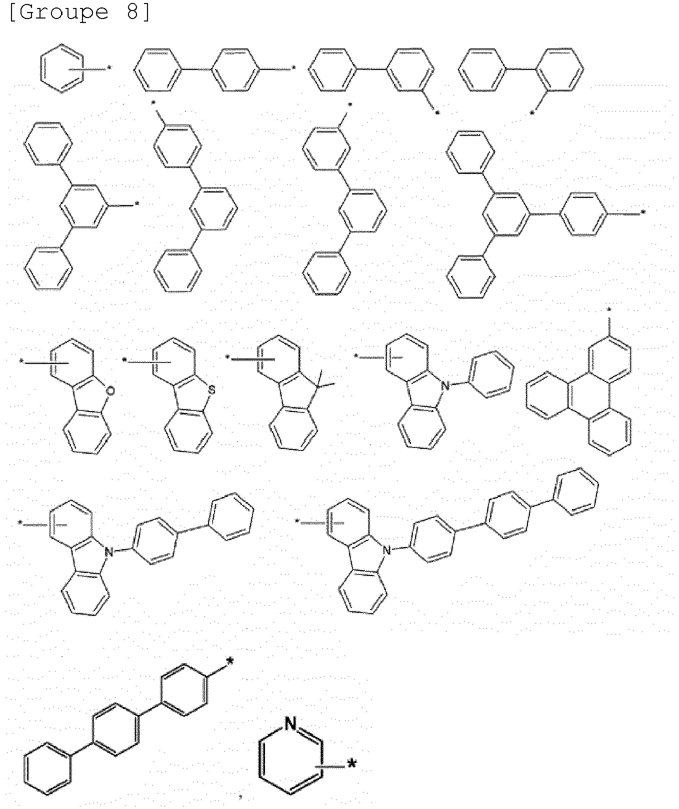 dans lequel, dans le groupe 8, * représente un point de liaison.

13. Dispositif optoélectrique organique de l'une quelconque des revendications 1 à 12, dans lequel la couche d'émission comprend au moins un des premiers composés répertoriés dans le groupe 4, et
au moins un des deuxièmes composés représentés par les formules chimiques 4-1 et 4-II, et
la couche auxiliaire de transport de trous comprend au moins un des troisièmes composés représentés par les formules chimiques 5-II, 5-III et 5-V : 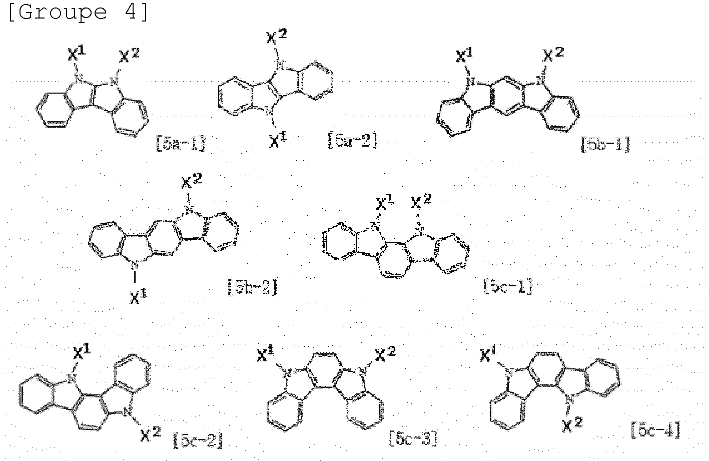 dans lequel, dans le groupe 4, X¹ représente *-Y¹-ET, X² représente *-Y²-Ar¹, Y¹ et Y² représentent chacun indépendamment une simple liaison, un groupe arylène en C6 à C30 substitué ou non substitué, un groupe hétéroarylène en C2 à C30 substitué ou non substitué, ou une combinaison de ceux-ci, Ar¹ représente un groupe aryle en C6 à C30 substitué ou non substitué, un groupe hétéroaryle en C2 à C30 substitué ou non substitué, ou une combinaison de ceux-ci, et ET est représenté par la formule chimique 1a, 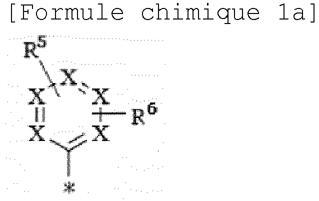 dans lequel, dans la formule chimique 1a,
X représente N, C ou CR^{a},
au moins un des X représente N, R⁵, R⁶ et R^{a} représentent chacun indépendamment l'hydrogène, le deutérium, un groupe alkyle en C1 à C20 substitué ou non substitué, un groupe aryle en C6 à C30 substitué ou non substitué, un groupe hétéroaryle en C2 à C30 substitué ou non substitué, ou une combinaison de
ceux-ci, et * représente un point de liaison, 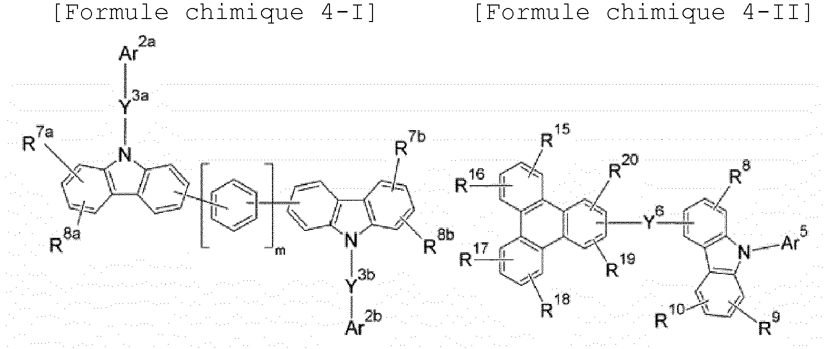
dans lequel, dans les formules chimiques 4-I et 4-II, Y^{3a}, Y^{3b}, Y⁶ et Y⁷ représentent chacun indépendamment une simple liaison, un groupe arylène en C6 à C30 substitué ou non substitué, un groupe hétéroarylène en C2 à C30 substitué ou non substitué, ou une combinaison de ceux-ci,
Ar^{2a}, Ar^{2b} et Ar⁵ représentent chacun indépendamment un groupe aryle en C6 à C30 substitué ou non substitué, un groupe hétéroaryle en C2 à C30 substitué ou non substitué, ou une combinaison de ceux-ci,
R^{7a}, R^{8a}, R^{7b}, R^{8b}, R⁷ à R¹⁰, et R¹⁵ à R²⁶ représentent chacun indépendamment l'hydrogène, le deutérium, un groupe alkyle en C1 à C20 substitué ou non substitué, un groupe aryle en C6 à C50 substitué ou non substitué, un groupe hétéroaryle en C2 à C50 substitué ou non substitué, ou une combinaison de ceux-ci, et
m représente un des entiers de 0 à 4, 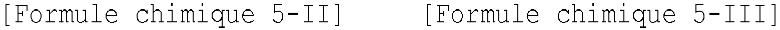 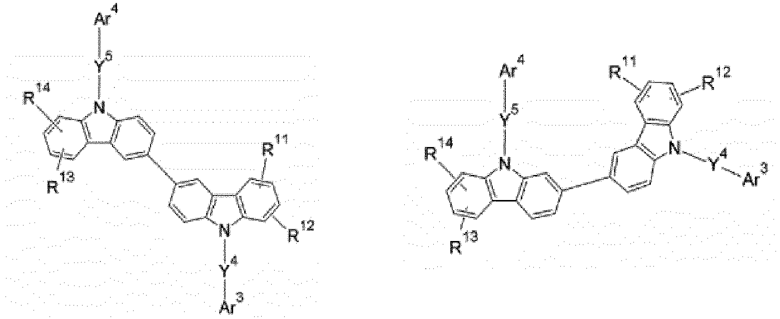 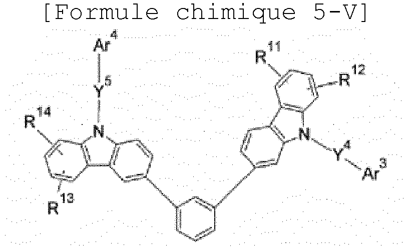
dans lequel, dans les formules chimiques 5-II, 5-III et 5-V,
R¹¹ à R¹⁴ représentent chacun indépendamment l'hydrogène, le deutérium, un groupe alkyle en C1 à C30 substitué ou non substitué, un groupe aryle en C6 à C30 substitué ou non substitué, un groupe hétéroaryle en C2 à C30 substitué ou non substitué, ou une combinaison de ceux-ci,
Y⁴ et Y⁵ représentent chacun indépendamment une simple liaison, un groupe arylène en C6 à C30 substitué ou non substitué, un groupe hétéroarylène en C2 à C30 substitué ou non substitué, ou une combinaison de ceux-ci,
Ar³ et Ar⁴ représentent chacun indépendamment un groupe phényle substitué ou non substitué, un groupe biphényle substitué ou non substitué, un groupe terphényle substitué ou non substitué, un groupe quaterphényle substitué ou non substitué, un groupe fluorényle substitué ou non substitué, un groupe dibenzofuranyle substitué ou non substitué, un groupe dibenzothiophényle substitué ou non substitué, un groupe triphénylényle substitué ou non substitué, ou une combinaison de ceux-ci.

14. Dispositif optoélectrique organique de l'une quelconque des revendications 1 à 13, dans lequel la couche auxiliaire de transport de trous est en contact avec la couche de transport de trous et la couche d'émission.

15. Dispositif d'affichage comprenant le dispositif optoélectrique organique de l'une quelconque des revendications 1 à 14.
